(19) Europäisches Patentamt
European Patent Office
Office européen des brevets

(11) **EP 2 054 884 B1**

(12) **EUROPÄISCHE PATENTSCHRIFT**

(45) Veröffentlichungstag und Bekanntmachung des Hinweises auf die Patenterteilung:
**05.10.2011 Patentblatt 2011/40**

(21) Anmeldenummer: **07819842.1**

(22) Anmeldetag: **16.11.2007**

(51) Int Cl.:
**G10L 19/14** *(2006.01)*

(86) Internationale Anmeldenummer:
**PCT/EP2007/009941**

(87) Internationale Veröffentlichungsnummer:
**WO 2008/058754 (22.05.2008 Gazette 2008/21)**

(54) **VORRICHTUNG ZUM KODIEREN UND DEKODIEREN**

DEVICE FOR ENCODING AND DECODING

DISPOSITIF DE CODAGE ET DE DÉCODAGE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **16.11.2006 DE 102006054080
12.04.2007 DE 102007017254**

(43) Veröffentlichungstag der Anmeldung:
**06.05.2009 Patentblatt 2009/19**

(73) Patentinhaber: **Fraunhofer-Gesellschaft zur Förderung der angewandten Forschung e.V.
80686 München (DE)**

(72) Erfinder:
• **WIK, Tilo
73730 Esslingen (DE)**
• **WENINGER, Dieter
91459 Markt Erlbach (DE)**
• **HERRE, Jürgen
91054 Buckenhof (DE)**

(74) Vertreter: **Schenk, Markus et al
Schoppe, Zimmermann, Stöckeler & Zinkler
Patentanwälte
Postfach 246
82043 Pullach bei München (DE)**

(56) Entgegenhaltungen:
**WO-A-03/026308 WO-A-2006/000842**

• **RAAD M ET AL: "Scalable audio coding employing sorted sinusoidal parameters" SIGNAL PROCESSING AND ITS APPICATIONS, SIXTH INTERNATIONAL, SYMPOSIUM ON. 2001 AUG. 16-16, 2001, PISCATAWAY, NJ, USA,IEEE, Bd. 1, 13. August 2001 (2001-08-13), Seiten 174-177, XP010557211 ISBN: 0-7803-6703-0**
• **RAAD ET AL: "From lossy to lossless audio coding using SPITH" PROCEEDINGS OF THE INTERNATIONAL CONFERENCE ON DIGITAL AUDIO EFFECTS, 26. September 2002 (2002-09-26), Seiten 245-250, XP002255007**

**Beschreibung**

Die vorliegende Erfindung bezieht sich auf eine Vorrichtung und ein Verfahren zum Kodieren und Dekodieren von Informationssignalen, wie sie beispielsweise in der Audio- und Videokodierung vorkommen können.

Bei der Kodierung und Dekodierung von Informationssignalen sind im Bereich der konventionellen Technik sogenannte verlustbehaftete Kodierverfahren bekannt. Beispielsweise existieren bereits transformationsbasierte Kodierverfahren, wie MPEG 1/2 Layer-3 (MPEG = Moving Picture Expert Group, MP3) oder Advanced Audio Coding (AAC). Diese arbeiten mit einer Zeit-Frequenztransformation und einem psychoakustischen Modell, welches wahrnehmbare Signalanteile von nichtwahrnehmbaren Signalanteilen unterscheiden kann. Die anschließende Quantisierung der Daten im Frequenzbereich wird mit diesen Modellen gesteuert. Steht allerdings für die kodierten Signale nur ein geringes Datenvolumen zur Verfügung, damit z.B. eine niedrige Gesamtbitrate eingehalten werden kann, ist eine gröbere Quantisierung das Resultat, d.h. durch die Quantisierung entstehen dann deutlich wahrnehmbare Kodierartefakte.

In der konventionellen Technik sind ferner die parametrischen Kodierverfahren bekannt, wie beispielsweise Philips Parametric Coding, HILN (HILN = Harmonic and Individual Lines and Noise ), etc., welche das ursprüngliche Signal dekoderseitig synthetisieren. Bei niedrigen Bitraten entsteht dadurch eine Verfälschung der originalen Klangcharakteristik., d.h. solche Kodierverfahren können dann wahrnehmbare Unterschiede zum Original aufweisen.

Im Bereich der verlustlosen Kodierung existieren prinzipiell zwei verschiedene Ansätze. Die erste Methode stützt sich darauf das Zeitsignal zu prädizieren. Der entstandene Prädiktorfehler wird dann anschließend entropiekodiert und kommt zur Speicherung bzw. Übertragung, z.B. bei SHORTEN (vgl. Tony Robinson: SHORTEN: Simple lossless and near lossless waveform compression. Technical report CUED/F-INFENG/TR.156, Cambridge University Engineering Department, December 1994) oder AudioPaK (vgl. Mat Hans, Ronald W. Schafer: Lossless Compression of Digital Audio, IEEE Signal Processing Magazine, July 2001).

Die zweite Methode benutzt als ersten Verarbeitungsschritt eine Zeit-Frequenztransformation mit anschließender verlustbehafteter Kodierung des entstandenen Spektrums. Zusätzlich kann dann noch der bei der Rücktransformation entstehende Fehler entropiekodiert werden, um eine verlustlose Kodierung des Signals zu gewährleisten, z.B. LTAC (LTAC = Lossless Transform Audio Compression, vgl. Tilman Liebchen, Marcus Purat, Peter Noll: Lossless Transform Coding of Audio Signals, 102nd AES Convention, 1997) und MPEG-4 SLS (SLS = Scalable Lossless Coding, vgl. Ralf Geiger, et al. :ISO/IEC MPEG-4 High-Definition Scalable Advanced Audio Coding, 120th AES Convention, May 2006).

Es existieren ferner zwei grundsätzliche Möglichkeiten zur Datenreduktion. Die erste Möglichkeit entspricht einer Redundanzreduktion. Hier wird eine ungleichmäßige Wahrscheinlichkeitsverteilung eines zugrundeliegenden Alphabets des Signals ausgenützt. Symbole, die eine höhere Auftrittswahrscheinlichkeit besitzen, werden z.B. mit weniger Bits dargestellt als Symbole mit einer kleineren Auftrittswahrscheinlichkeit. Oft wird dieses Prinzip auch als Entropiekodierung bezeichnet. Beim Enkodier-/Dekodierprozess gehen keine Daten verloren. Eine perfekte (verlustfreie) Rekonstruktion der Daten ist also wieder möglich. Die zweite Möglichkeit betrifft eine Irrelevanzreduktion. Bei dieser Art der Datenreduktion werden für den Benutzer nicht relevante Informationen gezielt entfernt. Als Grundlage werden hierfür oft Modelle natürlicher Wahrnehmungsbeschränkungen der menschlichen Sinne benutzt. Im Falle der Audiokodierung dient eine psychoakustische Betrachtung der Eingangssignale als Wahrnehmungsmodell, welche dann eine Quantisierung der Daten im Frequenzbereich steuert, vgl. z.B. E. Zwicker: Psychoakustik, Springer-Verlag, 1982. Da Daten gezielt aus dem Enkodier-/Dekodierprozess entfernt werden, ist eine perfekte Rekonstruktion der Daten nicht mehr möglich. Es handelt sich also um eine verlustbehaftete Datenreduktion.

Bei üblichen transformationsbasierten Audiokodierverfahren werden die Eingangsdaten aus dem Zeit- in den Frequenzbereich transformiert und dort mit Hilfe eines psychoakustischen Modells quantisiert. Idealerweise wird durch diese Quantisierung nur so viel Quantisierungsrauschen in das Signal eingefügt, dass dieses für den Hörer nicht wahrnehmbar ist, was jedoch für niedrige Bitraten nicht eingehalten werden kann - es entstehen deutlich hörbare Kodierartefakte. Weiterhin ist es bei niedrigen Zielbitraten oftmals nötig ein Downsampling mit vorhergehender Tiefpassfilterung vorzunehmen, somit ist dann eine Übertragung hoher Frequenzanteile des ursprünglichen Signals nicht mehr ohne weiteres möglich. Diese Verarbeitungsschritte beanspruchen eine erhebliche Rechenleistung und bringen eine Einschränkung der Signalqualität mit sich.

Die Aufgabe der vorliegenden Erfindung besteht somit darin, ein alternatives Konzept zur Kodierung und Dekodierung von Informationssignalen zu schaffen.

Diese Aufgabe wird gelöst durch eine Vorrichtung zum Kodieren gemäß einem der Ansprüche 1 oder 20, eine Vorrichtung zum Dekodieren gemäß einem der Ansprüche 11 oder 29 , ein Verfahren zum Kodieren gemäß einem der Ansprüche 9 oder 27, ein Verfahren zum Dekodieren gemäß einem der Ansprüche 18 oder 34 bzw. durch ein Computerprogramm gemäß einem der Ansprüche 10, 19, 28 oder 35.

Der vorliegenden Erfindung liegt die Erkenntnis zugrunde, dass ein Informationssignal aufwandsgünstiger kodiert werden kann, wenn zuvor eine Sortierung durchgeführt wird.

Dabei kann angenommen werden, dass ein Informationssignal oder auch ein Audiosignal eine Sequenz von Abtastwerten umfasst, wobei die Abtastwerte von einem Zeit oder Frequenzsignal stammen können, d.h. es kann sich dabei auch um ein abgetastetes Spektrum handeln. Der Begriff Abtastwert ist somit nicht einschränkend zu verstehen. In Ausführungsbeispielen der vorliegenden Erfindung kann deswegen ein grundlegender Verarbeitungsschritt darin bestehen, die Sortierung eines Eingangssignals nach dessen Amplitude durchzuführen, wobei dies auch nach einer evtl. durchgeführten Vorverarbeitung stattfinden kann. Als Vorverarbeitung könnten im Bereich der Audiosignale beispielsweise eine Zeit-/Frequenz-Transformation, eine Prädiktion oder auch eine Multikanalredundanzreduktion, z.B. bei Mehrkanalsignalen, erfolgen, allgemein auch Dekorrelationsverfahren. Vor diesen Verarbeitungsschritten kann zusätzlich noch eine evtl. variable Einteilung des Signals in definierte Zeitabschnitte, sogenannte Frames, stattfinden. Auch eine weitere Einteilung dieser Zeitabschnitte in Subframes, die dann einzeln sortiert werden, ist möglich. Ein Verfahren zur Kodierung von Audiosignalen mittels Parametersortierung ist z.B. beschrieben in Raad M. et al.: "Scalable audio coding employing sorted sinusoidal parameters", Sixth International Symposium on Signal Processing and its Applications, 13. August 2001, Bd. 1, Seiten 174-177.

In Ausführungsbeispielen der vorliegenden Erfindung existieren nach dem Sortierschritt zum einen die sortierten Daten und zum anderen eine Rücksortiervorschrift, die als Permutation der Indizes der ursprünglichen Eingangswerte vorliegt. Beide Datensätze werden dann möglichst effektiv kodiert. Ausführungsbeispiele bieten hierzu mehrere Möglichkeiten, wie beispielsweise eine Prädiktion mit anschließender Entropiekodierung des Restsignals, d.h. das Bestimmen von Prädiktionskoeffizienten für ein Prädiktionsfilter und Bestimmen des Restsignals, als eine Differenz zwischen einem Ausgangssignal des Prädiktionsfilters und des Eingangssignals.

In anderen Ausführungsbeispielen erfolgt eine Kurvenanpassung mit geeigneten Funktionsvorschriften und Funktionskoeffizienten mit anschließender Entropiekodierung des Restsignals. In anderen Ausführungsbeispielen kann eine verlustbehaftete Kodierung erfolgen und somit die Kodierung des Restsignals auch entfallen.

Ausführungsbeispiele können auch eine Permutationskodierung durchführen, beispielsweise durch Erstellung von Inversionstafeln und anschließende Entropiekodierung, wobei Details zu Inversionstafeln beispielsweise in Donald E. Knuth: The Art of Computer Programming, Volume 3: Sorting and Searching, Addison-Wesley, 1998, gefunden werden können.

In anderen Ausführungsbeispielen kann auch eine Prädiktion von Inversionstafeln und anschließende Entropiekodierung des Restsignals durch geführt werden, sowie eine Prädiktion der Permutation und anschließende Entropiekodierung des Restsignals. Ausführungsbeispiele können durch Weglassen des Restsignals auch eine verlustbehaftete Kodierung erreichen. Alternativ kann auch ein Erstellen von Nummerierungen für die Permutationen erfolgen, vgl. A. A. Babaev: Procedures of encoding and decoding of permutations, Kibernetika, No.6, 1984, pp. 77-82. Ferner können kombinatorische Auswahlverfahren mit anschließender Nummerierung in Ausführungsbeispielen zum Einsatz kommen.

Bevorzugte Ausführungsbeispiele der vorliegenden Erfindung werden nachfolgend Bezug nehmend auf die beiliegenden Zeichnungen näher erläutert. Es zeigen:

Fig. 1a     ein Ausführungsbeispiel einer Vorrichtung zum Kodieren;

Fig. 1b     ein Ausführungsbeispiel einer Vorrichtung zum Dekodieren;

Fig. 2a     ein Ausführungsbeispiel einer Vorrichtung zum Kodieren;

Fig. 2b     ein Ausführungsbeispiel einer Vorrichtung zum Dekodieren;

Fig. 3a     ein Ausführungsbeispiel einer Vorrichtung zum Kodieren;

Fig. 3b     ein Ausführungsbeispiel einer Vorrichtung zum Dekodieren;

Fig. 4a     ein Beispiel einer Vorrichtung zum Kodieren;

Fig. 4b     ein Beispiel einer Vorrichtung zum Dekodieren;

Fig. 5      a und b Beispiele eines Audiosignals, einer Permutation und einer Inversionstafel;

Fig. 6      ein Ausführungsbeispiel eines Kodierers;

Fig. 7      ein Ausführungsbeispiel eines Dekodierers;

Fig. 8      ein weiteres Ausführungsbeispiel eines Kodierers;

Fig. 9        ein weiteres Ausführungsbeispiel eines Dekodierers;

Fig. 10       ein Beispiel für ein Frequenzspektrum mit Approximation eines Audiosignals;

Fig. 11       ein Beispiel für ein sortiertes Frequenzspektrum und dessen Approximation eines Audiosignals;

Fig. 12       ein Beispiel eines sortierten differenzkodierten Signals und dessen Restsignals;

Fig. 13       Beispiel eines sortierten Zeitsignals;

Fig. 14       ein Beispiel sortierter Zeitwerte und einem entsprechenden Curve-Fitting; und

Fig. 15       eine Gegenüberstellung der Kodiereffizienz einer Differenzkodierung und Curve-Fitting.

Fig. 16       beispielhafte Verarbeitungsschritte der meisten verlustlosen Audiokompressionsalgorithmen;

Fig. 17       ein Ausführungsbeispiel einer Struktur einer Prädiktionskodierung;

Fig. 18       ein Ausführungsbeispiel einer Struktur einer Rekonstruktion bei einer Prädiktionskodierung;

Fig. 19       ein Ausführungsbeispiel von Warmup-Werten eines Prädiktionsfilters;

Fig. 20       ein Ausführungsbeispiel eines Vorhersagemodells;

Fig. 21       ein Blockdiagramm einer Struktur eines LTAC Encoders;

Fig. 22       ein Blockdiagramm eines MPEG-4 SLS Encoders;

Fig. 23       eine Stereoredundanzreduktion nach Dekorrelation einzelner Kanäle;

Fig. 24       eine Stereoredundanzreduktion vor Dekorrelation einzelner Kanäle;

Fig. 25       eine Illustration des Zusammenhangs von Prädiktorordnung und Gesamtbitverbrauch;

Fig. 26       eine Illustration des Zusammenhangs von Quantisierungparameters g und Gesamtbitverbrauch;

Fig. 27       eine Illustration eines Betragsfrequenzgangs eines Fixed Predictors in Abhängigkeit von dessen Ordnung p;

Fig. 28       eine Illustration des Zusammenhangs von Permutationslänge, Anzahl der Transpositionen und Kodierbarkeitsmaß;

Fig. 29       a bis h eine Darstellung von Inversionstafeln im 10. Block (Frame) eines rauschartigen Stückes;

Fig. 30       a bis h eine Darstellung von Inversionstafeln im 20. Block (Frame) eines tonalen Stückes;

Fig. 31       a und b eine Darstellung von aus einer Sortierung von Zeitwerten entstandenen Permutation eines rauschartigen Stückes im 10. Block und eines tonalen Stückes;

Fig. 32a      einen Teil eines Audiosignals, die entsprechende Permutation und Inversionstafel LS, und 32b die Permutation und die Inversionstafel LS aus dem linken Bild vergrößert;

Fig. 33a      einen Teil eines Audiosignals, die entsprechende Permutation und Inversionstafel LS, und Fig. 33b die Permutation und die Inversionstafel LS aus dem linken Bild vergrößert;

Fig. 34       eine Wahrscheinlichkeitsverteilung (oben) und eine Länge der Codewörter (unten) eines durch Prädiktion (Fixed Predictor) entstandenen Restsignals einer Inversionstafel LB;

Fig. 35a      eine Wahrscheinlichkeitsverteilung und Fig. 35b eine Länge von Codewörtern eines durch Differenzkodierung entstandenen Restsignals (unten) sortierter Zeitwerte;

Fig. 36    einen prozentualen Anteil einer Teilblockzerlegung mit einem geringsten Datenaufkommen einer vorwärts-adaptiven Rice Kodierung über ein Restsignal eines Fixed Predictors eines Stückes einschließlich Seiteninformation für Parameter, die Gesamtblocklänge ist 1024 Zeitwerte groß;

Fig. 37    einen prozentualen Anteil einer Teilblockzerlegung mit dem geringsten Datenaufkommen einer vorwärts-adaptiven Golomb Kodierung über das Restsignal eines Fixed Predictors eines Stückes einschließlich Seiteninformation für Parameter, die Gesamtblocklänge ist 1024 Zeitwerte groß;

Fig. 38    eine Illustration zur Arbeitsweise eines History Buffers;

Fig. 39    a und b eine Illustration zur Arbeitsweise einer Adaption verglichen mit einem optimalen Parameter für den Gesamtblock;

Fig. 40    ein Ausführungsbeispiel einer vorwärts-adaptiven arithmetische Kodierung unter Zuhilfenahme einer rückwärts-adaptiven Rice Kodierung;

Fig. 41    eine Darstellung des Einflusses der Blockgröße auf den Kompressionsfaktor F;

Fig. 42    eine Darstellung zur verlustlosen MS-Enkodierung;

Fig. 43    eine weitere Darstellung zur verlust losen MS-Enkodierung; und

Fig. 44    eine Illustration zur Auswahl einer besten Variante zur Stereoredundanzreduktion.

Bezüglich der nachfolgenden Beschreibung sollte beachtet werden, dass bei den unterschiedlichen Ausführungsbeispielen gleiche oder gleich wirkende Funktionselemente gleiche Bezugszeichen aufweisen und somit die Beschreibungen dieser Funktionselemente in den verschiedenen nachfolgend dargestellten Ausführungsbeispielen untereinander austauschbar sind. Es sei ferner noch einmal darauf hingewiesen, dass in den folgenden Ausführungsbeispielen stellvertretend für diskrete Werte eines Signals allgemein von Abtastwerten gesprochen wird. Der Begriff Abtastwert ist nicht einschränkend auszulegen, Abtastwerte können durch Abtasten eines Zeitsignals, eines Spektrums, eines allgemeinen Informationssignals usw. entstanden sein.

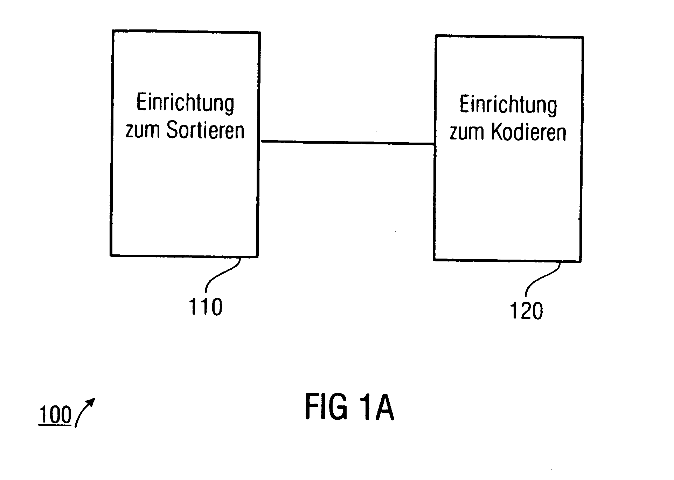

Fig. 1a zeigt eine Vorrichtung 100 zum Kodieren einer Sequenz von Abtastwerten eines Audiosignals, wobei jeder Abtastwert innerhalb der Sequenz eine Ursprungsposition aufweist. Die Vorrichtung 100 umfasst eine Einrichtung 110 zum Sortieren der Abtastwerte nach ihrer Größe (nach einer evtl. stattfindenden Vorverarbeitung, z.B. Zeit-/FrequenzTransformation, Prädiktion, usw.), um eine sortierte Sequenz von Abtastwerten zu erhalten, wobei jeder Abtastwert eine Sortierungsposition innerhalb der sortierten Sequenz aufweist. Ferner weist die Vorrichtung 100 eine Einrichtung 120 zum Kodieren der sortierten Abtastwerte und einer Information über eine Beziehung zwischen den Ursprungs- und Sortierungspositionen der Abtastwerte auf.

Die Vorrichtung 100 kann ferner eine Vorverarbeitungseinrichtung aufweisen, die ausgebildet ist, um eine Filterung, eine Zeit-/Frequenz-Transformation, eine Prädiktion oder eine Multikanalredundanzreduktion zur Erzeugung der Sequenz von Abtastwerten durchzuführen. In Ausführungsbeispielen kann die Einrichtung 120 zum Kodieren ausgebildet sein, um die Information über die Beziehung zwischen den Ursprungs- und Sortierungspositionen als Indexpermutation zu kodieren. Optional kann die Einrichtung 120 zum Kodieren die Information über die Beziehung zwischen den Ursprungs- und Sortierungspositionen als Inversionstafel kodieren. Die Einrichtung 120 zum Kodieren kann ferner ausgebildet sein, um die sortierten Abtastwerte oder die Information über die Beziehung zwischen den Ursprungs- und Sortierungspositionen mit einer Differenz- und anschließender Entropiekodierung oder nur einer Entropiekodierung zu kodieren.

In anderen Ausführungsbeispielen kann die Einrichtung 120 basierend auf den sortierten Abtastwerten, einer Permutation oder einer Inversionstafel Koeffizienten eines Prädiktionsfilters bestimmen und kodieren. Dabei kann ferner ein Restsignal, das einer Differenz zwischen den Abtastwerten und einem Ausgangssignal des Prädiktionsfilters entspricht, kodiert werden und eine verlustlose Kodierung ermöglichen. Das Restsignal kann dabei mit einer Entropiekodierung kodiert werden. In einem weiteren Ausführungsbeispiel kann die Vorrichtung 100 eine Einrichtung zum Einstellen von Funktionskoeffizienten einer Funktionsvorschrift zur Anpassung zumindest an einen Teilbereich der sortierten Sequenz aufweisen und die Einrichtung 120 zum Kodieren kann ausgebildet sein, um die Funktionskoeffizienten zu kodieren.

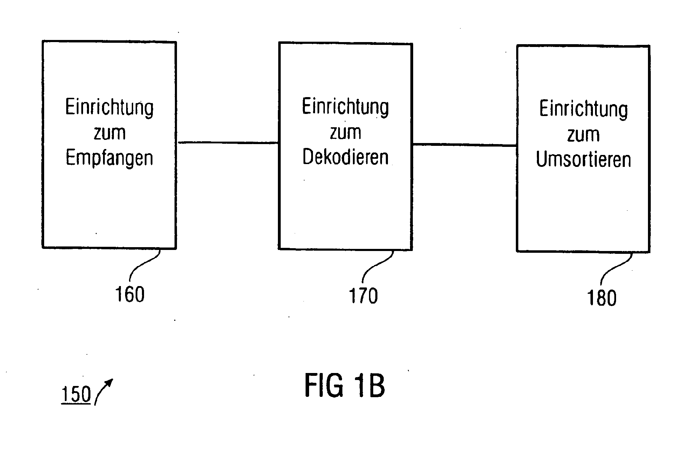

Fig. 1b zeigt ein Ausführungsbeispiel einer Vorrichtung 150 zum Dekodieren einer Sequenz von Abtastwerten eines Audiosignals, wobei jeder Abtastwert innerhalb der Sequenz eine Ursprungsposition aufweist. Die Vorrichtung 150 umfasst dabei eine Einrichtung 160 zum Empfangen einer Sequenz von kodierten Abtastwerten, wobei jeder kodierte Abtastwert innerhalb der Sequenz von kodierten Abtastwerten eine Sortierungsposition aufweist und die Einrichtung 160 ferner zum Empfangen einer Information über eine Beziehung zwischen den Ursprungs- und Sortierungspositionen der Abtastwerte ausgebildet ist. Die Vorrichtung 150 weist ferner eine Einrichtung 170 zum Dekodieren der Abtastwerte und der Information über die Beziehung zwischen den Ursprungs- und Sortierungspositionen auf und umfasst ferner eine Einrichtung 180 zum Umsortieren der Abtastwerte basierend auf der Information über die Beziehung zwischen den Ursprungs- und Sortierungspositionen, so dass jeder Abtastwert seine Ursprungsposition aufweist.

In Ausführungsbeispielen kann die Einrichtung 160 zum Empfangen ausgebildet sein, um die Information über die Beziehung zwischen den Ursprungs- und Sortierungspositionen als Indexpermutation zu empfangen. Ferner kann die Einrichtung 160 zum Empfangen ausgebildet sein, um die Information über die Beziehung zwischen den Ursprungs- und Sortierungspositionen als Inversionstafel zu empfangen. Die Einrichtung 170 zum Dekodieren kann in Ausführungsbeispielen ausgebildet sein, um die kodierten Abtastwerte oder die Information über die Beziehung zwischen den Ursprungs- und Sortierungspositionen mit einer Entropie- und anschließender Differenzdekodierung oder nur einer Entropiedekodierng zu dekodieren. Die Einrichtung 160 zum Empfangen kann optional kodierte Koeffizienten eines Prädiktionsfilters empfangen und die Einrichtung 170 zum Dekodieren kann ausgebildet sein, um die kodierten Koeffizienten zu dekodieren, wobei die Vorrichtung 150 ferner eine Einrichtung zum Prädizieren von Abtastwerten oder Beziehungen zwischen den Ursprungs- und Sortierungspositionen basierend auf den Koeffizienten aufweisen kann.

In weiteren Ausführungsbeispielen kann die Einrichtung 160 zum Empfangen ausgebildet sein, um ferner ein Restsignal, das einer Differenz zwischen den Abtastwerten und einem Ausgangssignal des Prädiktionsfilters entspricht, zu empfangen und die Einrichtung 170 zum Dekodieren kann ferner ausgebildet sein, um basierend auf dem Restsignal die Abtastwerte anzupassen. Die Einrichtung 170 kann dabei optional das Restsignal mit einer Entropiedekodierung dekodieren. Die Einrichtung 160 zum Empfangen könnte ferner Funktionskoeffizienten einer Funktionsvorschrift empfangen und die Vorrichtung 150 könnte ferner eine Einrichtung zum Anpassen einer Funktionsvorschrift an zumindest einen Teilbereich der sortierten Sequenz aufweisen und die Einrichtung 170 zum Dekodieren könnte ausgebildet sein, um die Funktionskoeffizienten zu dekodieren.

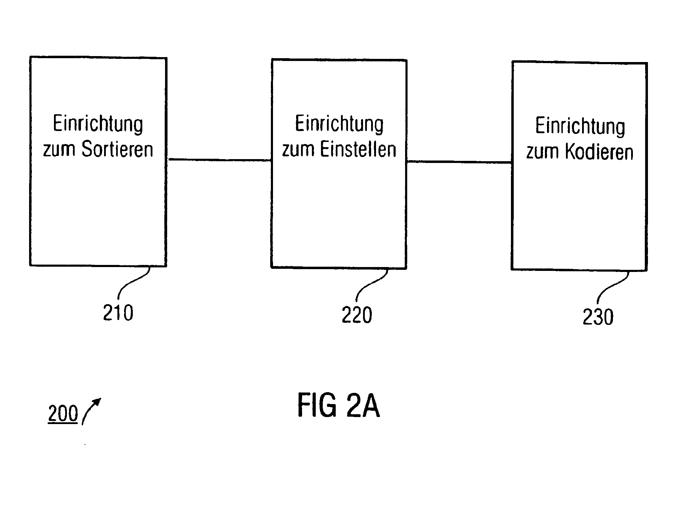

Fig. 2a zeigt ein Ausführungsbeispiel einer Vorrichtung 200 zum Kodieren einer Sequenz von Abtastwerten eines Informationssignals, wobei jeder Abtastwert innerhalb der Sequenz eine Ursprungsposition aufweist. Die Vorrichtung 200 umfasst eine Einrichtung 210 zum Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist. Die Vorrichtung 200 umfasst ferner eine Einrichtung 220 zum Einstellen von Funktionskoeffizienten einer Funktionsvorschrift zur Anpassung an zumindest einen Teilbereich der sortierten Sequenz und eine Einrichtung 230 zum Kodieren der Funktionskoeffizienten, der Abtastwerte außerhalb des Teilbereichs und einer Information über eine Beziehung zwischen den Ursprungs- und Sortierungspositionen der Abtastwerte.

Die Vorrichtung 200 kann ferner eine Vorverarbeitungseinrichtung aufweisen, die ausgebildet ist, um eine Filterung, eine Zeit-/Frequenz-Transformation, eine Prädiktion oder eine Multikanalredundanzreduktion zur Erzeugung der Sequenz von Abtastwerten durchzuführen. In Ausführungsbeispielen kann das Informationssignal ein Audiosignal umfassen. Die Einrichtung 230 zum Kodieren kann ausgebildet sein, um die Information über die Beziehung zwischen den Ursprungs- und Sortierungspositionen als Indexpermutation zu kodieren. Ferner kann die Einrichtung 230 zum Kodieren ausgebildet sein, um die Information über die Beziehung zwischen den Ursprungs- und Sortierungspositionen als Inversionstafel zu kodieren. Optional kann die Einrichtung 220 zum Kodieren auch ausgebildet sein, um die sortierten Abtastwerte, die Information über die Beziehung zwischen den Ursprungs- und Sortierungspositionen mit einer Differenz- und anschließender Entropiekodierung oder nur einer Entropiekodierung zu kodieren. Die Einrichtung 230 zum Kodieren könnte ferner ausgebildet sein, um basierend auf den Abtastwerten, einer Permutation oder einer Inversionstafel Koeffizienten eines Prädiktionsfilters zu bestimmen und zu kodieren.

In weiteren Ausführungsbeispielen kann die Einrichtung 230 zum Kodieren ferner ausgebildet sein, um ein Restsignal, das einer Differenz zwischen den Abtastwerten und einem Ausgangssignal eines Prädiktionsfilters entspricht, zu kodieren. Die Einrichtung 230 zum Kodieren kann wiederum angepasst sein, um das Restsignal mit einer Entropiekodierung zu kodieren.

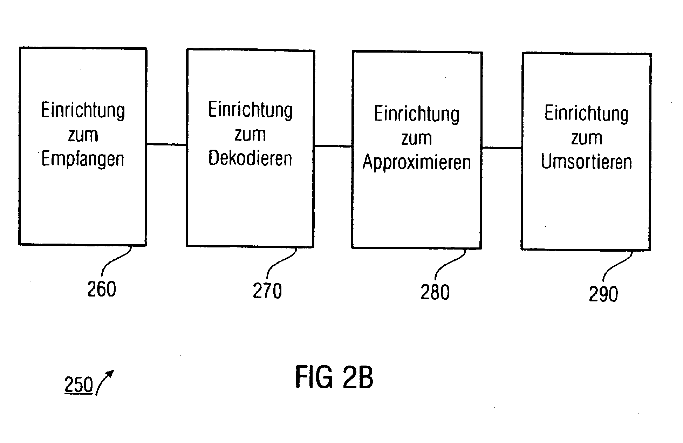

Fig. 2b zeigt ein Ausführungsbeispiel einer Vorrichtung 250 zum Dekodieren einer Sequenz von Abtastwerten eines Informationssignals, wobei jeder Abtastwert innerhalb der Sequenz eine Ursprungsposition aufweist. Die Vorrichtung 250 umfasst eine Einrichtung 260 zum Empfangen von kodierten Funktionskoeffizienten, sortierten Abtastwerten und einer Information über eine Beziehung zwischen einer Sortierungsposition und der Ursprungsposition von Abtastwerten. Die Vorrichtung 250 umfasst ferner eine Einrichtung 270 zum Dekodieren von Abtastwerten und eine Einrichtung 280 zum Approximieren von Abtastwerten basierend auf den Funktionskoeffizienten zumindest in einem Teilbereich der Sequenz. Die Vorrichtung 250 weist ferner eine Einrichtung 290 zum Umsortieren der Abtastwerte und des approximierten Teilbereiches auf, basierend auf der Information über die Beziehung zwischen den Ursprungs- und Sortierungspositionen, so dass jeder Abtastwert seine Ursprungsposition aufweist.

In Ausführungsbeispielen kann das Informationssignal ein Audiosignal umfassen. Die Einrichtung 260 zum Empfangen kann ausgebildet sein, um die Information über die Beziehung zwischen den Ursprungs- und Sortierungspositionen als Indexpermutation zu empfangen. Ferner kann die Einrichtung 260 zum Empfangen ausgebildet sein, um die Information über die Beziehung zwischen den Ursprungs- und Sortierungspositionen als Inversionstafel zu empfangen. Die Einrichtung 270 kann optional die sortierten Abtastwerte oder die Information über die Beziehung zwischen den Ursprungs- und Sortierungspositionen mit einer Entropie- und anschließender Differenzdekodierung oder nur einer Entropiedekodierung dekodieren. Die Einrichtung 260 zum Empfangen kann ferner angepasst sein, um kodierte Koeffizienten eines Prädiktionsfilters zu empfangen und die Einrichtung 270 zum Dekodieren kann ausgebildet sein, um die kodierten Koeffizienten zu dekodieren, wobei die Vorrichtung 250 ferner eine Einrichtung zum Prädizieren von Abtastwerten basierend auf den Koeffizienten aufweisen kann.

In weiteren Ausführungsbeispielen kann die Einrichtung 260 zum Empfangen ausgebildet sein, um ein Restsignal, das einer Differenz zwischen den Abtastwerten und einem Ausgangssignal des Prädiktionsfilters oder der Einrichtung 280 zum Approximieren entspricht, zu empfangen und die Einrichtung 270 zum Dekodieren kann ausgebildet sein, um basierend auf dem Restsignal die Abtastwerte anzupassen. Die Einrichtung 270 zum Dekodieren kann optional das Restsignal mit einer Entropiedekodierung dekodieren.

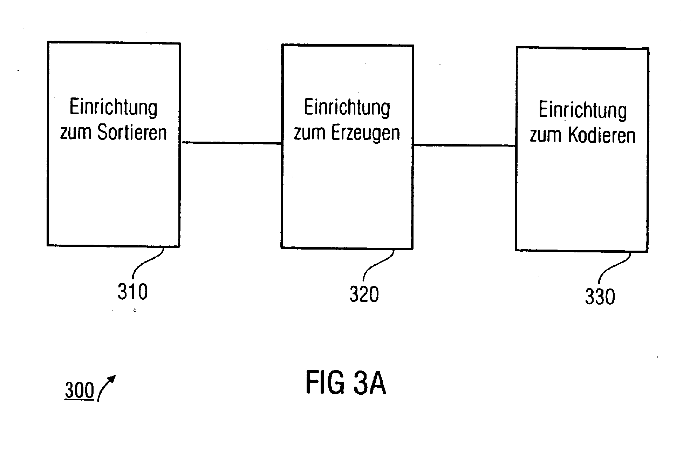

Fig. 3a zeigt eine Vorrichtung 300 zum Kodieren einer Sequenz von Abtastwerten eines Informationssignals, wobei jeder Abtastwert innerhalb der Sequenz eine Ursprungsposition aufweist. Die Vorrichtung 300 umfasst eine Einrichtung 310 zum Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist. Die Vorrichtung 300 umfasst ferner eine Einrichtung 320 zum Erzeugen einer Zahlenfolge abhängig von einer Beziehung zwischen den Ursprungs- und Sortierungspositionen der Abtastwerte und zum Bestimmen von Koeffizienten eines Prädiktionsfilters basierend auf der Zahlenfolge. Die Vorrichtung 300 weist ferner eine Einrichtung 330 zum Kodieren der sortierten Abtastwerte und der Koeffizienten auf.

Die Vorrichtung 300 kann ferner eine Vorverarbeitungseinrichtung aufweisen, die ausgebildet ist, um eine Filterung, eine Zeit-/Frequenz-Transformation, eine Prädiktion oder eine Multikanalredundanzreduktion zur Erzeugung der Sequenz von Abtastwerten durchzuführen. In Ausführungsbeispielen kann das Informationssignal ein Audiosignal aufweisen. Die Einrichtung 320 zum Erzeugen der Zahlenfolge kann ausgebildet sein, um eine Indexpermutation zu erzeugen. Optional kann die Einrichtung 320 zum Erzeugen der Zahlenfolge eine Inversionstafel erzeugen. Die Einrichtung 320 zum Erzeugen der Zahlenfolge kann angepasst sein, um ferner ein Restsignal zu erzeugen, das einer Differenz zwischen der Zahlenfolge und einer auf der Basis der Koeffizienten prädizierten Prädiktionsfolge entspricht. Die Einrichtung 330 zum Kodieren kann angepasst sein, um die sortierten Abtastwerte gemäß einer Differenz- und anschließender Entropiekodierung oder nur einer Entropiekodierung zu kodieren. Die Einrichtung 330 zum Kodieren kann ferner ausgebildet sein, um das Restsignal zu kodieren.

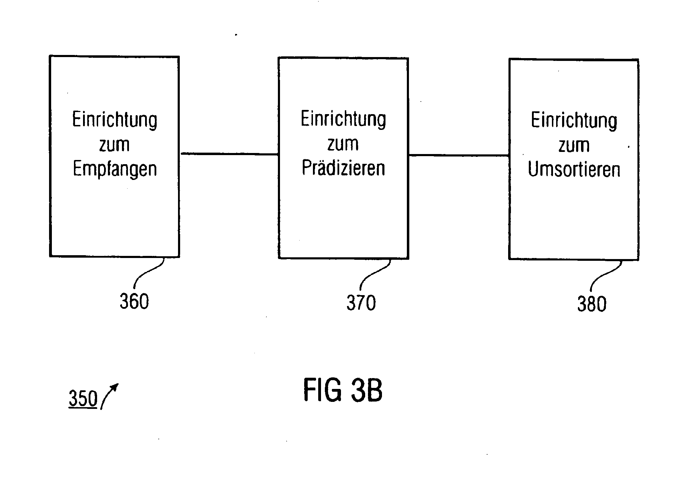

Fig. 3b zeigt ein Ausführungsbeispiel einer Vorrichtung 350 zum Dekodieren einer Sequenz von Abtastwerten eines Informationssignals, wobei jeder Abtastwert innerhalb der Sequenz eine Ursprungsposition aufweist. Die Vorrichtung 350 umfasst eine Einrichtung 360 zum Empfangen von Koeffizienten eines Prädiktionsfilters und einer Sequenz von Abtastwerten, wobei jeder Abtastwert eine Sortierungsposition aufweist. Die Vorrichtung umfasst ferner eine Einrichtung 370 zum Prädizieren einer Zahlenfolge basierend auf den Koeffizienten und eine Einrichtung 380 zum Umsortieren der Sequenz von Abtastwerten basierend auf der Zahlenfolge, so dass jeder Abtastwert seine Ursprungsposition aufweist.

In Ausführungsbeispielen kann das Informationssignal ein Audiosignal aufweisen. Ferner kann die Einrichtung 370 zum Prädizieren der Zahlenfolge eine Indexpermutation als Zahlenfolge prädizieren. Die Einrichtung 370 zum Prädizieren der Zahlenfolge könnte auch eine Inversionstafel als Zahlenfolge prädizieren. Die Einrichtung 360 zum Empfangen kann ferner ausgebildet sein, um ein kodiertes Restsignal zu empfangen und die Einrichtung 370 zum Prädizieren kann ausgebildet sein, um das Restsignal bei der Prädiktion der Zahlenfolge zu berücksichtigen. Die Vorrichtung 350 kann ferner eine Einrichtung zum Dekodieren aufweisen, die ausgebildet ist, um Abtastwerte nach einer Entropie- und anschließender Differenzdekodierung oder nur einer Entropiedekodierung zu dekodieren.

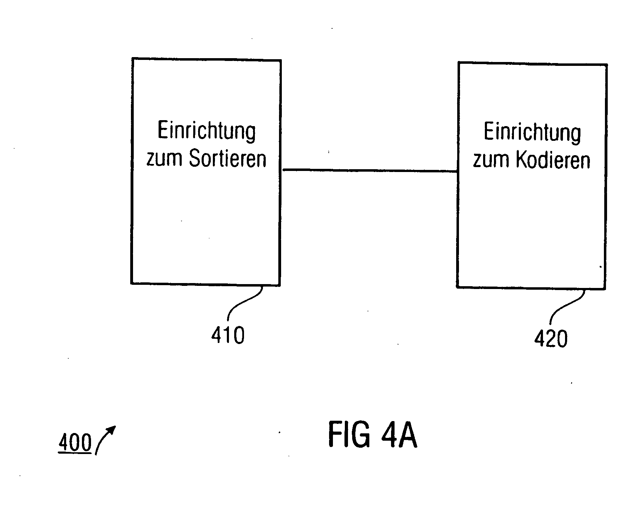

Fig. 4a zeigt ein Beispiel einer Vorrichtung 400 zum Kodieren einer Sequenz von Abtastwerten, wobei jeder Abtastwert innerhalb der Sequenz eine Ursprungsposition aufweist. Die Vorrichtung 400 umfasst eine Einrichtung 410 zum Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist. Die Vorrichtung 400 umfasst ferner eine Einrichtung 420 zum Kodieren der sortierten Abtastwerte und zum Kodieren einer Zahlenfolge mit einer Information über die Beziehung zwischen den Ursprungs- und Sortierungspositionen der Abtastwerte, wobei jedes Element innerhalb der Zahlenfolge einzigartig ist, und wobei die Einrichtung 420 zum Kodieren einem Element der Zahlenfolge eine Anzahl von Bits zuordnet, derart, dass die Anzahl von Bits, die einem ersten Element zugeordnet wird, größer ist als die Anzahl von Bits, die einem zweiten Element zugeordnet wird, wenn vor der Kodierung des ersten Elements weniger Elemente bereits kodiert waren, als vor der Kodierung des zweiten Elements.

Die Einrichtung 420 zum Kodieren kann dabei ausgebildet sein, um eine Zahlenfolge der Länge N zu kodieren und um eine Anzahl von X Elementen gleichzeitig zu kodieren, wobei der Anzahl von X Elementen G Bits zugeordnet werden gemäß, mit

$$G = \left\lceil \log_2 \left( \frac{N!}{(N-X)!} \right) \right\rceil \quad 0 < X \leq N \; ,$$

wobei die unten geöffneten Klammern anzeigen, dass der Wert in den Klammern auf die nächstgrößere ganze Zahl aufgerundet wird.

In einem anderen Beispiel kann die Einrichtung 420 zum Kodieren ausgebildet sein, um eine Zahlenfolge der Länge N zu kodieren, wobei X eine Anzahl bereits kodierter Elemente der Zahlenfolge ist, wobei der dem nächsten Element der Zahlenfolge G Bits zugeordnet werden gemäß,

$$G = \left\lceil \log_2 (N-X) \right\rceil$$

mit $0 \leq X < N$.

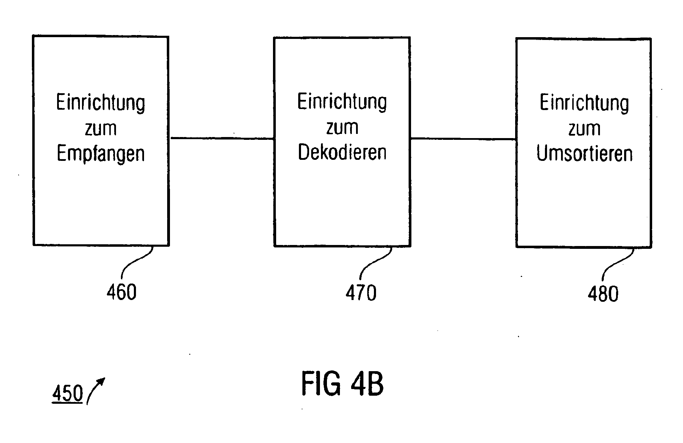

Fig. 4b zeigt ein Beispiel einer Vorrichtung 450 zum Dekodieren einer Sequenz von Abtastwerten, wobei jeder Abtastwert innerhalb der Sequenz eine Ursprungsposition aufweist. Die Vorrichtung 450 umfasst eine Einrichtung 460 zum Empfangen einer kodierten Zahlenfolge und einer Sequenz von Abtastwerten, wobei jeder Abtastwert eine Sortierungsposition aufweist. Die Vorrichtung 450 umfasst ferner eine Einrichtung 470 zum Dekodieren einer dekodierten Zahlenfolge mit einer Information über eine Beziehung zwischen den Ursprungs- und Sortierungspositionen basierend auf der kodierten Zahlenfolge, wobei jedes Element innerhalb der dekodierten Zahlenfolge einzigartig ist und die Einrichtung 470 zum Dekodieren einem Element der Zahlenfolge eine Anzahl von Bits zuordnet, derart, dass die Anzahl von Bits, die einem ersten Element zuggeordnet wird, größer ist als die Anzahl von Bits, die einem zweiten Element zugeordnet wird, wenn vor der Dekodierung des ersten Elements weniger Elemente bereits dekodiert waren, als vor der Kodierung des zweiten Elements. Die Vorrichtung 450 umfasst ferner eine Einrichtung 480 zum Umsortieren der Sequenz von Abtastwerten basierend auf der dekodierten Zahlenfolge, so dass jeder Abtastwert innerhalb der dekodierten Sequenz seine Ursprungsposition aufweist.

In Beispielen kann die Einrichtung 470 zum Dekodieren ausgebildet sein, um eine Zahlenfolge der Länge N zu dekodieren und um eine Anzahl von X Elementen gleichzeitig zu dekodieren, wobei der Anzahl von X Elementen G Bits zugeordnet werden gemäß,

$$G = \left\lceil \log_2 \left( \frac{N!}{(N-X)!} \right) \right\rceil$$

mit $0 < X \leq N$.

Die Einrichtung 470 zum Dekodieren kann ferner ausgebildet sein, um eine Zahlenfolge der Länge N zu dekodieren, wobei X eine Anzahl bereits kodierter Elemente der Zahlenfolge ist, wobei der dem nächsten Element der Zahlenfolge G Bits zugeordnet werden gemäß,

$$G = \left\lceil \log_2 (N-X) \right\rceil$$

mit $0 \leq X < N$.

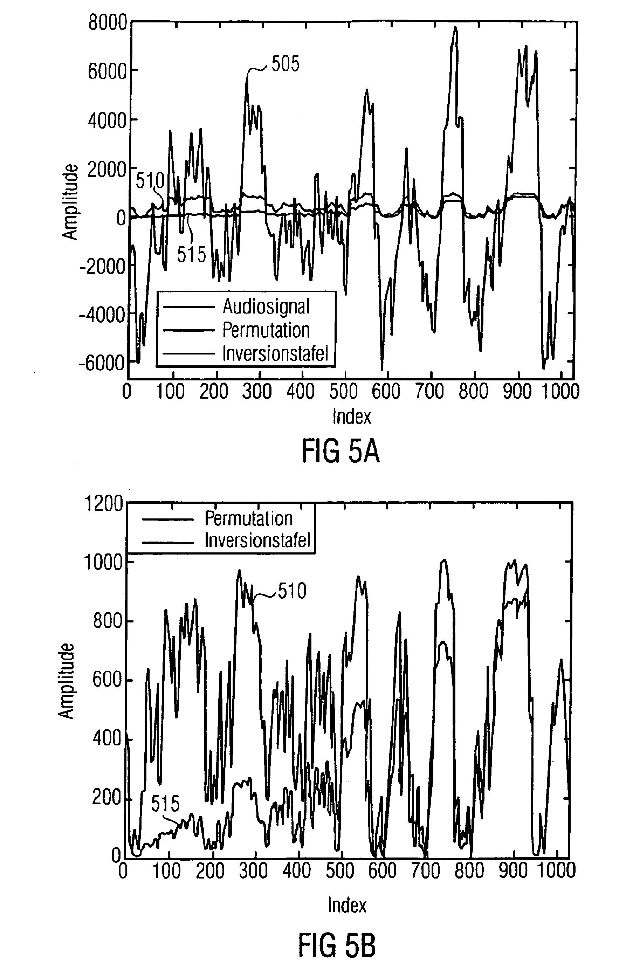

Die Fig. 5a zeigt Signalverläufe eines Audiosignals 505 (große Amplituden), einer Permutation 510 (mittlere Amplituden) und einer Inversionstafel 515 (kleine Amplituden). In der Fig. 5b sind die Permutation 510 und die Inversionstafel 515 aus Gründen einer besseren Übersicht noch einmal in einer anderen Skalierung dargestellt.

Aus den in Fig. 5a,b dargestellten Verläufen, lässt sich eine Korrelation zwischen dem Audiosignal 505, der Permutation 510 und der Inversionstafel 515 erkennen. Deutlich ist die Korrelationsübertragung des Eingangssignals auf die Permutation bzw. Inversionstafel zu erkennen. Gemäß Beispielen kann neben einer Kodierung der sortierten Abtastwerte eine Permutationskodierung durch Erstellen von Inversionstafeln erfolgen, die anschließend entropiekodiert werden. Aus Fig. 5a,b wird ersichtlich, dass aufgrund der Korrelationen auch eine Prädiktion der Permutation bzw. der Inversionstafeln möglich ist, wobei das jeweilige Restsignal im Falle einer verlustlosen Kodierung beispielsweise entropiekodiert werden kann.

Die Prädiktion ist möglich, da sich eine im Eingangssignal vorhandene Korrelation auf die entstehende Permutation bzw. Inversionstafel überträgt, vgl. Fig. 5a,b. Als Prädiktionsfilter können dabei bekannte FIR (FIR = Finite Impulse Response) und IIR (IIR = Infinite Impulse Response) Strukturen zum Einsatz kommen. Die Koeffizienten eines solchen Filters werden dann so gewählt, daß beispielsweise basierend auf einem Restsignal am Eingang des Filters, an seinem Ausgang das ursprüngliche Ausgangssignal anliegt bzw. ausgegeben werden kann. Die entsprechenden Koeffizienten des Filters und das Restsignal können dann in Beispielen kostengünstiger, d.h. mit weniger Bits oder Übertragungsrate übertragen werden, als das ursprüngliche Signal selbst. In einem Empfänger, bzw. einem Dekoder wird dann das ursprüngliche Signal, basierend auf den übertragenen Koeffizienten und gegebenenfalls einem Restsignal prädiziert oder rekonstruiert. Die Anzahl der. Koeffizienten bzw. die Ordnung des Prädiktionsfilters bestimmt dabei einerseits die zur Übertragung notwendigen Bits und andererseits die Genauigkeit, mit der das ursprüngliche Signal prädiziert oder rekonstruiert werden kann.

Bei den Inversionstafeln handelt es sich um eine äquivalente Darstellung der Permutation, die jedoch für eine Entropiekodierung besser geeignet sind. Für eine verlustbehaftete Kodierung ist es ebenso möglich die Rücksortierung nur unvollständig durchzuführen, um somit an Datenaufkommen einzusparen.

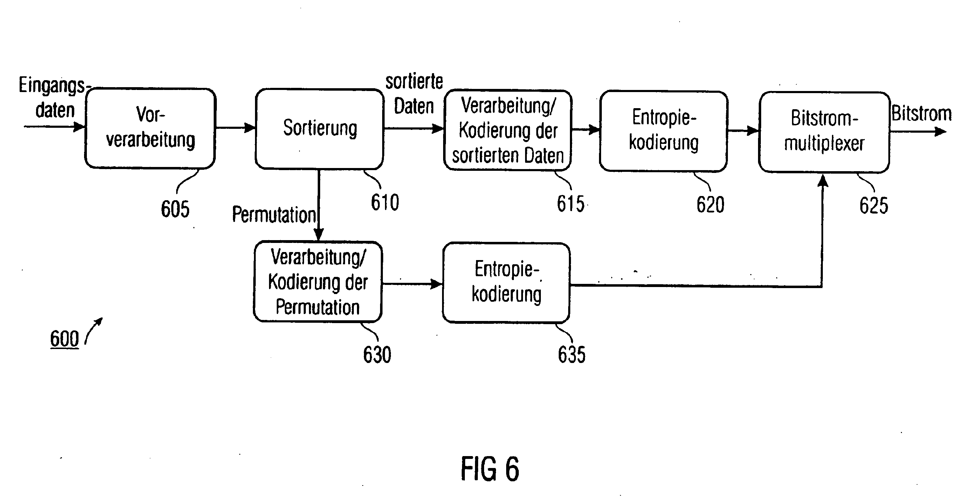

Die Fig. 6 zeigt ein Ausführungsbeispiel eines Kodierers 600. In dem Kodierer 600 kann eine Vorverarbeitung 605 der Eingangsdaten erfolgen (z.B. Zeit-/Frequenz-Transformation, Prädiktion, Stereoredundanzreduktion, Filterung zur Bandbegrenzung, usw.). Die vorverarbeiteten Daten werden dann sortiert 610, wobei sortierte Daten und eine Permutation entstehen. Die sortierten Daten können dann weiter verarbeitet oder kodiert werden 615, beispielsweise kann hier eine Differenzkodierung erfolgen. Die Daten können dann im Anschluss entropiekodiert werden 620 und einem Bitmultiplexer 625 zur Verfügung gestellt werden. Die Permutation kann ebenfalls zunächst verarbeitet oder kodiert werden 630, beispielsweise durch Bestimmen einer Inversionstafel mit evtl anschließender Prädiktion, woraufhin auch hier eine Entropiekodierung 635 erfolgen kann, bevor die entropiekodierte Permutation bzw. Inversionstafel dem Bitmultiplexer 625 zugeführt werde. Der Bitmultiplexer 625 multiplext dann die entropiekodierten Daten und die Permutation zu einem Bitstrom.

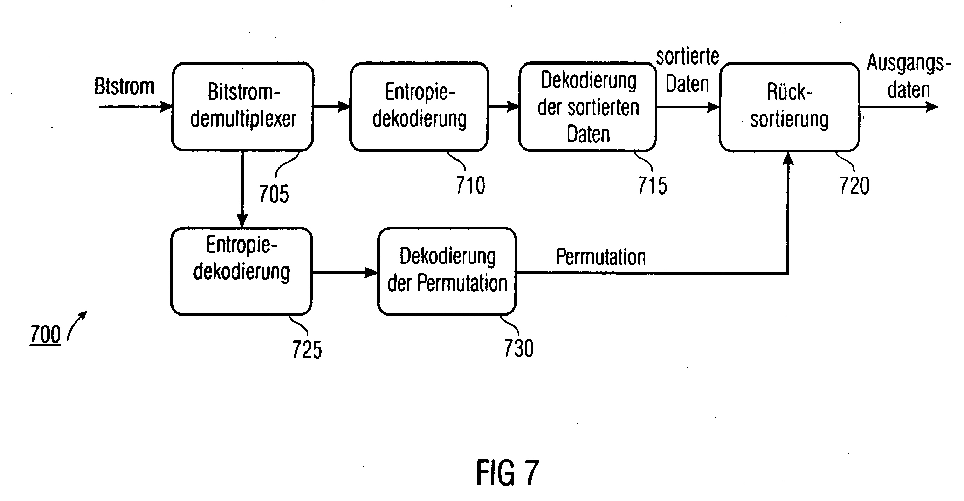

Die Fig. 7 zeigt ein Ausführungsbeispiel eines Dekodierers 700, der beispielsweise einen Bitstrom gemäß des Kodierers 600 erhält. Der Bitstrom wird dann zunächst in einem Bitstromdemultiplexer 705 gedemultiplext, woraufhin kodierte Daten einer Entropiedekodierung 710 zugeführt werden. Die entropiedekodierten Daten können dann in einer Dekodierung der sortierten Daten 715, z.B. in einer Differenzdekodierung, weiter dekodiert werden. Die dekodierten sortierten Daten werden dann einer Rücksortierung 720 zugeführt. Aus dem Bitstrommultiplexer 705 werden ferner die kodierten Permutationsdaten einer Entropiedekodierung 725 zugeführt, der eine weitere Dekodierung der Permutation 730 nachgeschaltet sein kann. Die dekodierte Permutation wird dann ebenfalls der Rücksortierung 720 zugeführt. Die Rücksortierung 720 kann dann basierend auf den dekodierten Permutationsdaten und den dekodierten sortierten Daten die Ausgangsdaten ausgeben.

Ausführungsbeispiele können ferner ein Kodiersystem besitzen, das 3 Betriebsmodi aufweist. Ein Modus 1 könnte hohe Kompressionsraten mit Hilfe einer psychoakustischen Betrachtung des Eingangssignals ermöglichen. Ein Modus 2 könnte mittlere Kompressionsraten ohne Psychoakustik und ein Modus 3 könnte niedrigere Kompressionsraten, jedoch mit verlustloser Kodierung ermöglichen, siehe auch Tilo Wik, Dieter Weninger: Verlustlose Audiokodierung mit sortierten Zeitwerten und Anbindung an filterbankbasierte Kodierverfahren, Oktober 2006.

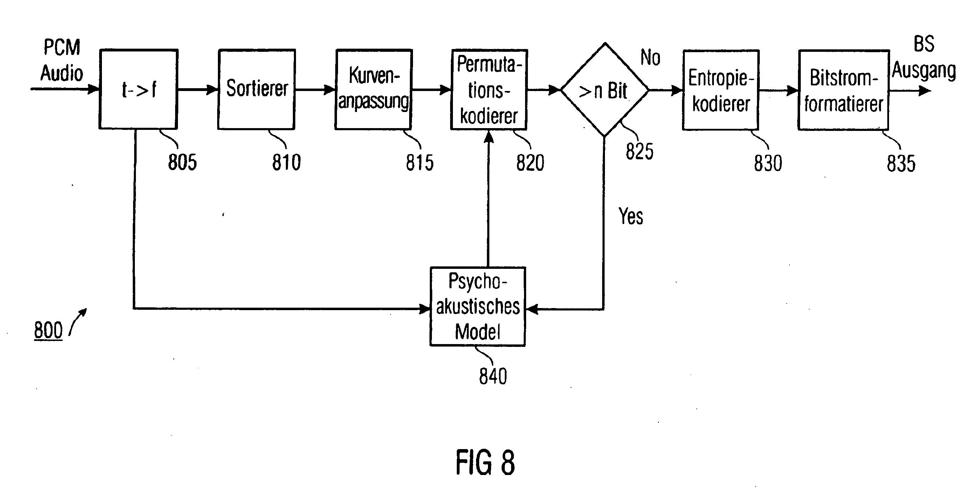

Allen Modi gemeinsam könnte der Verzicht auf die Verarbeitungsstufen der Quantisierung, des Resamplings und der Tiefpassfilterung sein. Es könnte somit in allen 3 Stufen die volle Bandbreite des Eingangssignals übertragen werden. Fig. 8 zeigt ein weiteres Ausführungsbeispiel eines Kodierers 800. Fig. 8 zeigt das Blockschaltbild eines Kodierers 800 bzw. eine Kodierverfahrens für die Modi 1 und 2. Das Eingangssignal wird mittels einer Zeit-Frequenztransformation 805, z.B. einer MDCT (MDCT = Modified Discrete Cosinus Transform) in den Frequenzbereich transformiert, vgl. J. Princen, A. Bradley: Analysis/ Synthesis Filter Bank Design Based on Time Domain Aliasing Cancellation, IEEE Trans. ASSP 1986.

Danach werden die Spektrallinien nach der Größe ihrer Amplituden sortiert 810 (Sorting). Da das entstehende sortierte Spektrum eine relativ einfache Kurvenform besitzt, kann es in Ausführungsbeispielen leicht durch eine Funktionsvorschrift mittels einer Kurvenanpassung approximiert werden 815 (Curve Fitting), siehe z.B. Draper, N.R and H. Smith, Applied Regression Analysis, 3rd Ed., John Wiley & Sons, New York, 1998. Um die durch die Umsortierung entstandene Permutation der Spektrallinienindizes auf Dekoderseite wieder in die ursprüngliche Reihenfolge zu bringen und somit das ursprüngliche Spektrum wiederherstellen zu können, kann nun eine Rücksortierungsvorschrift 820 gefunden und in den Bitstrom geschrieben werden, die ein möglichst kleines Datenaufkommen beinhaltet. Dieses kann für den Modus 1 beispielsweise durch eine Lauflängenkodierung 820 und für den Modus 2 durch einen speziellen Permutationskodierer 820 bewerkstelligt werden, der mit Hilfe einer Inversionstafel arbeiten kann.

Die Daten der Lauflängenkodierung bzw. des Permutationskodierers 820 werden dann zusätzlich durch ein Entropiekodierverfahren oder Entropiekodierer 830 kodiert und schließlich inklusive einiger Zusatzinformationen, z.B. den Koeffizienten der o.g. Funktionsvorschrift in den Bitstrom geschrieben, angedeutet durch den Bitstromformatierer 835. Möglichkeiten das entstehende Datenaufkommen zu kontrollieren (variable Bitraten) bestehen z.B. in der Variation der Qualität der Kurvenanpassung, durch wahlweise Hinzunahme einer psychoakustischen Betrachtung in einem psychoakustischen Mode11840 des Eingangssignals sowie durch verschiedene Kodierstrategien des Permutationskodierers 820 bzw. der Lauflängenkodierung 820. Dazu zeigt die Fig. 8 ferner einen Block 825 der die im Kodierprozess entstandene Bitrate überwacht und gegebenenfalls eine Rückmeldung an das psychoakustische Modell liefert, wenn die Datenrate noch zu hoch ist.

Das Blockschaltbild der Fig. 8 zeigt das ein psychoakustisches Modell 840 zur Bitratensteuerung, dieses kann beispielsweise nur für den Modus 1 aktiviert sein und im Modus 2 kann auf diese Steuerungsmöglichkeit zugunsten der Kodierqualität verzichtet werden. Im Betriebsmodus 1 wird eine höhere Kompressionsrate erreicht als in den beiden anderen Betriebsmodi. Hierzu werden mit Hilfe einer psychoakustischen Betrachtung 840 des Eingangssignals gezielt Linien des Frequenzspektrums zu Null gesetzt oder alternativ Elemente der Indexpermutation von der Rücksortierung ausgeschlossen, um bei der Übertragung der Rücksortierungsvorschrift 820 Daten einsparen zu können. Im Gegensatz dazu wird im Betriebsmodus 2 das Frequenzspektrum vollständig wiederhergestellt, es treten hier nur geringe Fehler durch kleine Ungenauigkeiten der Kurvenapproximation 815 auf. Weiterhin kann der Betriebsmodus 2 mit der Hinzunahme eines Restsignals zu einem verlustlosen Modus erweitert werden. Sowohl in Modus 1 als auch Modus 2 kann das gesamte Frequenzspektrum übertragen werden, d.h. die Datenreduktion im Modus 1 kann nur durch eine verkleinerte Rücksortiervorschrift 820 erzielt werden.

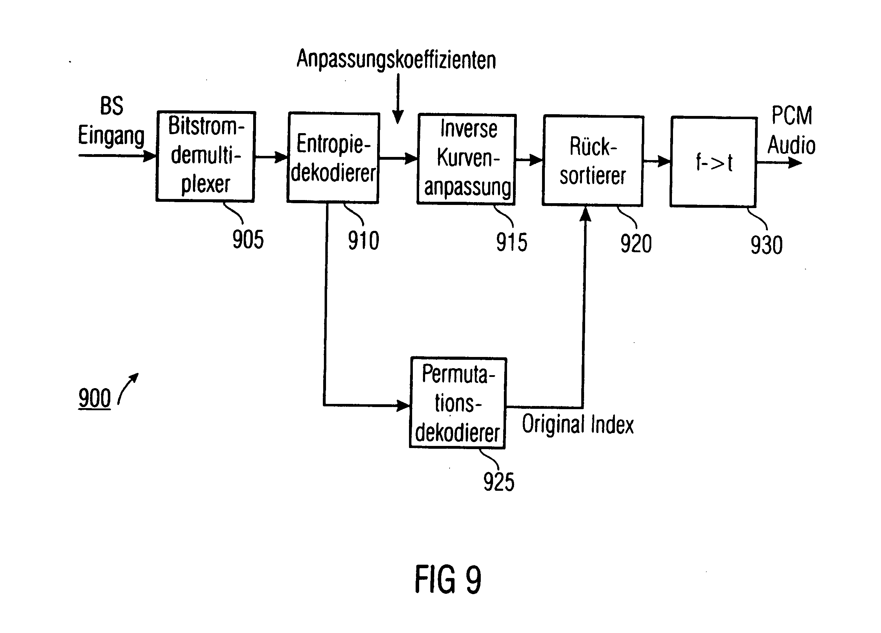

Die Fig. 9 zeigt ein weiteres Ausführungsbeispiel eines Dekodierers 900 bzw. eines Dekodierprozesses der Modi 1 und 2, der im Wesentlichen die Schritte der Kodierung bzw. des Kodierers 800 rückwärts durchläuft. Der Bitstrom wird zunächst durch einen Bitstromdemultiplexer 905 entpackt und in einem Entropiedekodierer 910 dekodiert. Aus den dekodierten Funktionskoeffizienten einer Funktionsvorschrift kann dann durch einen "Inverse Curve Fitting"-Block, d.h. eine inverse Kurvenanpassung 915 die Funktion bzw. Spektralfunktion wieder hergestellt werden und einem Rücksortierer 920 zugeführt werden. Der Rücksortierer 920 erhält ferner eine Permutation von einem Permutationdekodierer 925, der auf der Basis der entropiedekodierten Permutation die Permutation dekodiert. Der Rücksortierer 920 kann dann mit Hilfe der Permutation und der mit Hilfe der übertragenen Funktionskoeffizienten wieder aufgebauten Spektralfunktion ihre Spektrallinien in die ursprüngliche Reihenfolge bringen. Schließlich wird das rekonstruierte Spektrum durch eine Rücktransformation 930, z.B. inverse MDCT, in den Zeitbereich zurücktransformiert.

In anderen Ausführungsbeispielen kann auch auf die Zeit-/Frequenztransformation verzichtet werden und ein Informationssignal direkt im Zeitbereich sortiert, wie oben beschrieben, kodiert und übertragen werden.

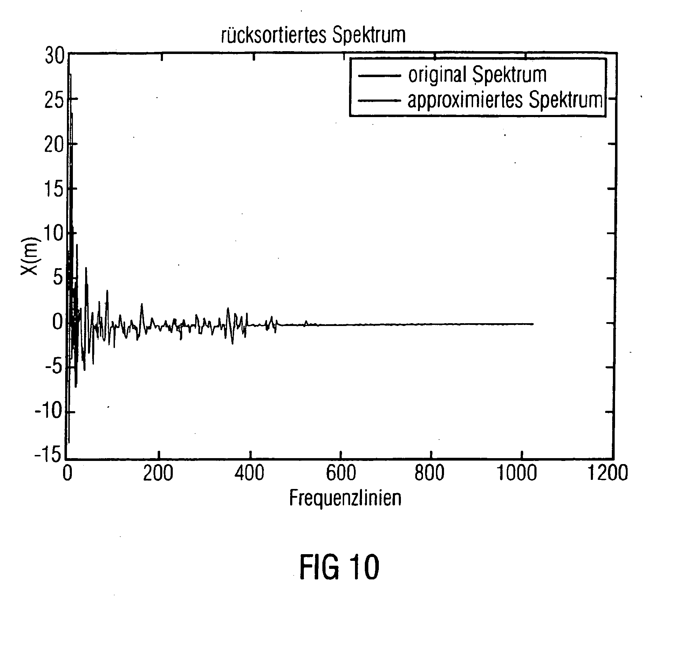

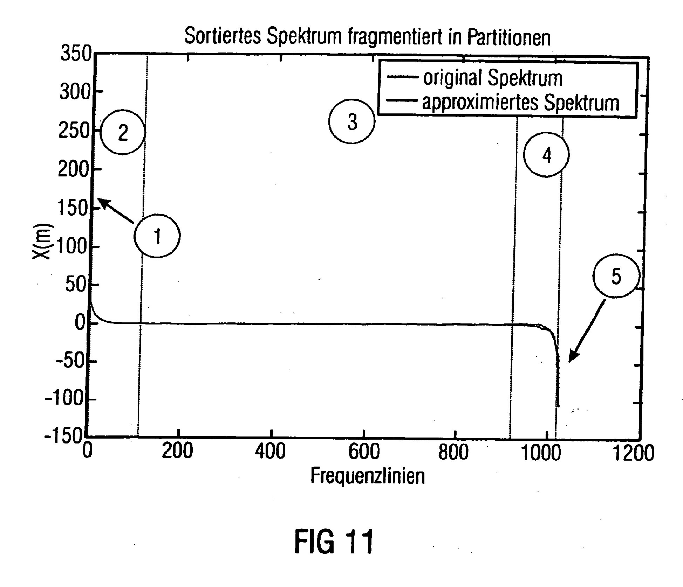

Die Fig. 10 zeigt ein Beispiel für ein Frequenzspektrum eines Audiosignals mit 1024 Frequehzlinien und dessen approximiertes Spektrum, wobei Original und Approximation nahezu identisch sind. Fig. 11 zeigt das dazugehörende sortierte Spektrum und dessen Approximation. Es ist klar ersichtlich, dass sich das sortierte Spektrum deutlich leichter und genauer durch eine Funktionsvorschrift approximieren lässt als das Originalspektrum. Um das Spektrum aus Fig. 11 zu approximieren, kann es in Ausführungsbeispielen in z.B. 5 Bereiche (Partitionen oder engl. Partitions) eingeteilt werden, die in der Fig. 11 dargestellt sind, wobei der Bereich 3 z.B. durch eine Gerade und die Bereiche 2 und 4 mit entsprechend geeigneten Funktionen (z.B. Polynome, Exponentialfunktionen, usw.) angenähert werden. Die Anzahl der Amplitudenwerte in den Bereichen 1 und 5 kann in Ausführungsbeispielen sehr klein gewählt werden, z.B. 3, da diese aber enorm wichtig für die Klangqualität sind, sollten sie entweder sehr genau approximiert oder direkt übertragen werden.

Für das gesamte Spektrum können gemäß Ausführungsbeispielen also letztendlich nur noch die Funktionstypen und deren Koeffizienten bzw. für die Bereiche 1 und 5 ggf. die Amplitudenwerte übertragen. Die gewählte Einteilung in 5 Bereiche dient hier nur als Beispiel, es ist natürlich jederzeit möglich andere Aufteilungen zu wählen, um z.B. die Qualität der Approximation zu verbessern. Fig. 10 zeigt zusätzlich noch das approximierte und wieder zurücksortierte Spektrum, wobei gut zu erkennen ist, dass das rekonstruierte Spektrum sehr nahe an das Originalspektrum zu liegen kommt.

In Ausführungsbeispielen entsteht durch die Umsortierung eine Zahlenfolge der Spektrallinienindizes, die eine Permutation der Indexmenge darstellt. In Ausführungsbeispielen kann die Zahlenfolge dieser umsortierten Indizes direkt übertragen werden, wobei dabei relativ große Datenmengen anfallen können, die, da sie völlig gleichverteilt sind, nicht durch eine Entropiekodierung reduzierbar sind. Um die gleichverteilte Zahlenfolge der Indizes der sortierten Spektrallinien, diese Zahlenfolge ist logischerweise unsortiert, auf eine ungleichverteilte Folge abzubilden, kann in Ausführungsbeispielen eine Inversionstafelbildung auf die Indizes angewendet werden, welche eine bijektive, also eindeutig umkehrbare Abbildung darstellt, und ein nicht gleichverteiltes Ergebnis liefert, vgl. z.B. Donald E. Knuth: The Art of Computer Programming, Volume 3: Sorting and Searching, Addison-Wesley, 1998.

Eine nicht gleichverteilte invertierte Zahlenfolge wird nun entropiekodiert und somit das zu übertragende Datenvolumen reduziert. Im Folgenden wird ein kleines Beispiel zur Funktionsweise der Inversionstafel erläutert. Gegeben sei eine Menge von Zahlenpaaren A = {(x$_1$, y$_1$),..., (x$_n$, y$_n$)} wobei die x$_i$ eine Indizierung der y$_i$ darstellen sollen, so dass die x$_i$ eine streng monoton steigende Folge bilden. Bei den y$_i$ könnte es sich z.B. um Amplitudenwerte eines Frequenzspektrums handeln, z.B. A = {(1,5), (2,3), (3,1), (4,2), (5,8), (6,2.3), (7,2), (8,4.5), (9,6)}.

Nun wird A anhand der Größe der y$_i$ sortiert, so dass die y$_i$ eine monoton fallende Folge bilden. Die x$_i$ werden dadurch zu einer unsortierten Zahlenfolge, also eine Permutation der ursprünglichen x$_i$.

A' = {(5,8), (9,6), (1,5), (8,4.5), (2,3), (6,2.3), (4,2), (7, 2), (3,1)}

x$_i$' = {5,9,1,8,2,6,4,7,3}

y$_i$' = {8,6,5,4.5,3,2.3,2,2,1}

Inversionstafelbildung von x$_i$:

| X$_i$' | 5 | 9 | 1 | 8 | 2 | 6 | 4 | 7 | 3 | (gleichverteilt) |
|---|---|---|---|---|---|---|---|---|---|---|
| x$_i$'$^{-1}$ | 2 | 3 | 6 | 4 | 0 | 2 | 2 | 1 | 0 | (nicht gleichverteilt) |

Die Umkehrung der Inversiontafel ergibt wieder die ursprüngliche Zahlenfolge:

| | | | | | | | | | |
|---|---|---|---|---|---|---|---|---|---|
| x$_9$'$^{-1}$ = 0 | 9 | | | | | | | | |
| X$_8$'$^{-1}$ = 1 | 9 | 8 | | | | | | | |
| x$_7$'$^{-1}$ = 2 | 9 | 8 | 7 | | | | | | |
| x$_6$'$^{-1}$ = | 9 | 8 | 6 | 7 | | | | | |
| x$_5$'$^{-1}$ = 0 | 5 | 9 | 8 | 6 | 7 | | | | |
| x$_4$'$^{-1}$ = 4 | 5 | 9 | 8 | 6 | 4 | 7 | | | |
| x$_3$'$^{-1}$ = 6 | 5 | 9 | 8 | 6 | 4 | 7 | 3 | | |
| x$_2$'$^{-1}$ = 3 | 5 | 9 | 8 | 2 | 6 | 4 | 7 | 3 | |
| X$_1$'$^{-1}$ = 2 | 5 | 9 | 1 | 8 | 2 | 6 | 4 | 7 | 3=x$_i$' |

Prinzipiell sind noch weitere Möglichkeiten der Inversionstafelbildung möglich, siehe z.B.

Donald E. Knuth: The Art of Computer Programming, Volume 3: Sorting and Searching, Addison-Wesley, 1998;

D. H. Lehmer: Teaching Combinatorial Tricks to a Computer, Proc. Of Symposium Appl. Math., Combinatorial Analysis, Vol. 10, Amercian Mathematical Society, Providence, R.I., 1960, 179-193;

D. H. Lehmer, The Machine Tools of Combinatorics, Applied Combinatorial Mathematics, John Wiley and Sons, Inc. N.Y., 1964; und

Ziya Arnavut: Permutations Techniques in Lossless Compression, Dissertation, 1995.

Weiterhin wäre in anderen Ausführungsbeispielen nach der Bildung der Inversionstafel eine Differenzkodierung, wie sie z.B. in Ziya Arnavut: Permutations Techniques in Lossless Compression, Dissertation, 1995, beschrieben ist oder andere Nachbearbeitungen (z.B. Prädiktion), die die Entropie verkleinern, denkbar.

Ausführungsbeispiele der vorliegenden Erfindung arbeiten nach einem völlig anderen Prinzip als bereits bestehende Systeme. Durch die Vermeidung der Rechenschritte der Quantisierung, des Resamplings und der Tiefpassfilterung sowie durch den wahlweisen Verzicht einer psychoakustischen Betrachtung können Ausführungsbeispiele an Berechnungskomplexität einsparen. Die Qualität der Kodierung hängt für den Modus 2 ausschließlich von der Güte der Approximation der Funktionsvorschrift an das sortierte Frequenzspektrum ab, während für den Modus 1 die Qualität hauptsächlich durch das verwendete psychoakustische Modell bestimmt wird.

Die Bitrate aller Modi ist zum allergrößten Teil von der Komplexität der zu übertragenden Rücksortiervorschrift abhängig. Die Bitratenskalierbarkeit ist in einem weiten Bereich gegeben, von hoher Kompression bis hin zu verlustfreier Kodierung bei höheren Datenraten ist jede Abstufung möglich. Aufgrund des Funktionsprinzips kann auch bei relativ niedrigen Bitraten die volle Frequenzbandbreite des Signals übertragen werden. Die geringen Anforderungen an die Rechenleistung und den Speicherplatz ermöglichen eine Anwendung und Implementierung von Ausführungsbeispielen nicht nur auf herkömmlichen PCs, sondern auch auf portablen Endgeräten.

Weiterhin wäre z.B. ein Einsatz im Bereich des MPEG-4 Scalable, MPEG Surround, vgl. J. Breebaart, J. Herre, C. Faller et al.; MPEG Spatial Audio Coding/MPEG Surround: Overview and Current Status; 119th AES Convention, Oct 2005,

Binaural Cue Coding, vgl. C. Faller, F. Baumgarte; Binaural Cue Coding Applied to Stereo and Multi-Channel Audio Compression; 112th AES Convention, May 2002,

oder im Low-Delay-Bereich, hier evtl. auch in Verbindung mit einer Anwendung im Zeitbereich möglich.

Da das Funktionsprinzip von Ausführungsbeispielen keine restriktiven Anforderungen an das zu kodierende Signal stellt, können auch Anwendungen insbesondere des verlustfreien Modus außerhalb der Audiokodierung, wie beispielsweise in der Videokodierung oder anderen Bereichen vorkommen.

Da die entstehenden Bitraten erheblich von der Komplexität der zu übertragenden Rücksortierungsvorschrift abhängen, sind noch weitere Ausführungsbeispiele denkbar. Eine Verbesserung ist möglich, wenn beispielsweise ein Schlüssel übertragen wird, mit dem sich auf Dekoderseite die entstandene Permutation eindeutig identifizieren lässt. Schon vorhandene Arbeiten auf dem Gebiet der "Restricted Permutations" lassen sich hierzu als Grundlage benutzen, vgl. V. Vatter; Finitely Labeled Generating Trees and Restricted Permutations; Journal of Symbolic Computation, 41 (2006), 559-572.

Ausführungsbeispiele können zusätzlich die Übertragung eines Fehler- oder Restsignals vorsehen, hiermit könnte die Qualität der Modi 1 und 2 gesteigert, der Modus 2 sogar zu einem verlustlosen Mode erweitert werden. Weiterhin könnte ein übertragenes Fehlersignal eine intelligente Zurückordnung für die im Modus 1 von der Rücksortierung ausgeschlossenen Frequenzlinien ermöglichen, und so die Qualität dieses Modus weiter verbessern.

Ausführungsbeispiele können für den Modus 1 auch eine Synthetisierung von Frequenzlinien vorsehen, der ähnlich wie SBR (SBR = Spectral Band Replication) arbeitet, nur hier nicht ausschließlich für den oberen Frequenzbereich zuständig ist, sondern gelöschte Zwischenfrequenzbereiche rekonstruiert. Auch eine speziell auf die bei der Approximation entstehenden Fehler abgestimmte psychoakustische Betrachtung könnte in weiteren Ausführungsbeispielen die Qualität steigern und die Bitrate senken. Da das Prinzip der Umsortierung und anschließenden Kurvenapproximation nicht auf Signale aus dem Frequenzbereich angewiesen ist, können andere Ausführungsbeispiele auch im Zeitbereich auch für den Modus 2 eingesetzt sein. Da die Modi 2 und 3 auf den Einsatz einer psychoakustischen Betrachtung verzichten, können Ausführungsbeispiele auch außerhalb der Audiokodierung eingesetzt werden.

Ausführungsbeispiele können ferner eine auf die Besonderheiten dieses Verfahrens angepasste optimierte Verarbeitung von Stereosignalen liefern und können somit den Bitverbrauch und den Rechenaufwand gegenüber einer zweifachen Monokodierung noch einmal reduzieren.

Ausführungsbeispiele machen sich ein Sorting Model zu Nutze. Bei einem nach dem Sorting Model arbeitenden Kodierverfahren findet eine Sortierung der zu kodierenden Daten statt. Dadurch wird zum einen eine künstliche Korrelation der Daten herbeigeführt, wodurch sich die Daten leichter kodieren lassen. Zum anderen entsteht aber durch die Sortierung eine Permutation der ursprünglichen Positionen der Zeitwerte. Damit ein Decoder ein ursprüngliches Informations- oder Audiosignal wieder rekonstruieren kann, ist es somit nötig, neben den kodierten Zeitwerten eine Rücksortiervorschrift (Permutation) zu kodieren und zu übertragen. Dadurch wird das ursprüngliche Problem, lediglich eine Kodierung der Zeitwerte durchzuführen, nun in zwei Teilprobleme zerlegt, d.h. in eine Kodierung der sortierten Zeitwerte und eine Kodierung der Rücksortiervorschrift. Fig. 11 illustriert das Schema einer sogenannten "Sorted-Lossless"-Kodierung. Beispielsweise wird ein Audiosignal durch Sortierung auf ein Signal mit stärkerer Korrelation abgebildet. Anschließend werden die sortierten Zeitwerte und eine Rücksortiervorschrift kodiert.

Aus dem anhand der Fig. 11 beschriebenen Prinzip leitet sich auch der Name SOLO (SOLO = Sorted Lossless) für das neuartige verlustlose Kodierverfahren oder Audiokodierverfahren ab. Jedes der beiden Teilprobleme hat ganz spezielle Eigenschaften. Für die Kodierung der sortierten Zeitwerte bietet sich in Ausführungsbeispielen z.B. eine Differenzkodierung an. Die Kodierung der Permutation kann z.B. in der äquivalenten Inversionstafeldarstellung erfolgen. Im folgenden wird detailliert auf die beiden Teilprobleme eingegangen. Zusätzlich zu dem Sorting Model können in SOLO aber auch traditionelle Dekorrelationsverfahren, beispielsweise die des Predictive Modeling verwendet werden.

Im Falle des Sorting Model kommt im Vergleich zu herkömmlichen Kodierverfahren ein zusätzlicher Verarbeitungsschritt, die Verarbeitung der Permutation, hinzu. Somit ergeben sich in Ausführungsbeispielen beispielsweise vier grundlegende Verarbeitungsschritte:

1. Blockeinteilung (Frameing)
2. Dekorrelation der unsortierten/sortierten Zeitwerte
3. Verarbeitung der Permutation
4. Entropiekodierung der Daten aus 2. und 3.

Bei der Differenzkodierung wird, wie der Name sagt, nicht der eigentliche Wert, sondern die Differenz aufeinanderfolgender Werte kodiert. Sind die Differenzen kleiner als die ursprünglichen Werte kann eine höhere Kompression erreicht werden.

Sei $i \in N$ ($N$ = Menge der natürlichen Zahlen) mit $1 \leq i \leq n < \infty$ und $x_i \in Z$ ($Z$ = Menge der ganzen zahlen), dann kann die Differenzkodierung definiert werden als:

$$\delta(x) = \begin{cases} x_i & \text{falls } i = 1 \\ x_{i-1} - x_i & \text{sonst} \end{cases}$$

Die Differenzkodierung ist invertierbar. Sei $i \in N$ (N = Menge der natürlichen Zahlen) mit $1 \leq i \leq n < \infty$ und $x_i \in Z$ (Z = Menge der ganzen zahlen), dann kann die inverse Differenzkodierung definiert werden als:

$$\delta^{-1}(x) = \begin{cases} x_i & \text{falls } i = 1 \\ x_{i-1} - \delta(x_i) & \text{sonst} \end{cases}$$

Da es sich bei der Differenzkodierung um eine einfache Art der Prädiktion handelt, wird auch hier ein Warmup (ein Zeitwert bei $i$ = 1) von der Entropiekodierung ausgeschlossen. δ hat die Eigenschaft, daß bei absteigend sortierten Zeitwerten das Restsignal komplett in der Menge der positiven natürlichen Zahlen liegt. Dadurch lässt sich eine nachfolgende Entropiekodierung einfacher gestalten. Eine Differenzkodierung arbeitet dann optimal, wenn die zu kodierenden Werte sehr nahe beieinander liegen, also stark korreliert sind. Durch die Sortierung der Zeitwerte werden die Zeitwerte in eine starke Korrelation gebracht.

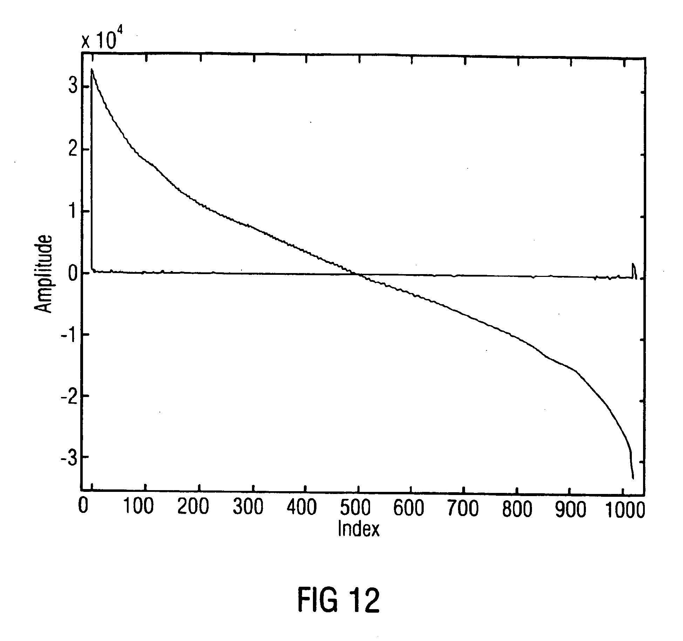

Fig. 12 zeigt einen beispielhaften Verlauf eines differenzkodierten sortierten Signals und dessen Restsignal, d.h. Fig. 12 zeigt die Auswirkung einer Differenzkodierung angewandt auf sortierte Zeitwerte. Deutlich ist der übereinstimmende Wert von sortiertem und dekorreliertem Zeitsignal bei Index 1 (Warmup oder Aufwärmphase) zu erkennen. Weiterhin ist der wesentlich kleinere Dynamikumfang des Restsignals der Differenzkodierung gegenüber den sortierten Zeitwerten auffallend. Detaillierte Angaben zu Fig. 12 sind der nachfolgenden Tabelle zu entnehmen. Die Differenzkodierung stellt also ein einfaches und effizientes Verfahren dar, um sortierte Zeitwerte zu kodieren.

|  | max. Wert (ohne Warmup) | min. Wert | Warmup |
|---|---|---|---|
| Sortierte Zeitwerte | 32425 | -32768 | 32767 |
| Restsignal δ | 2630 | 0 | 32767 |

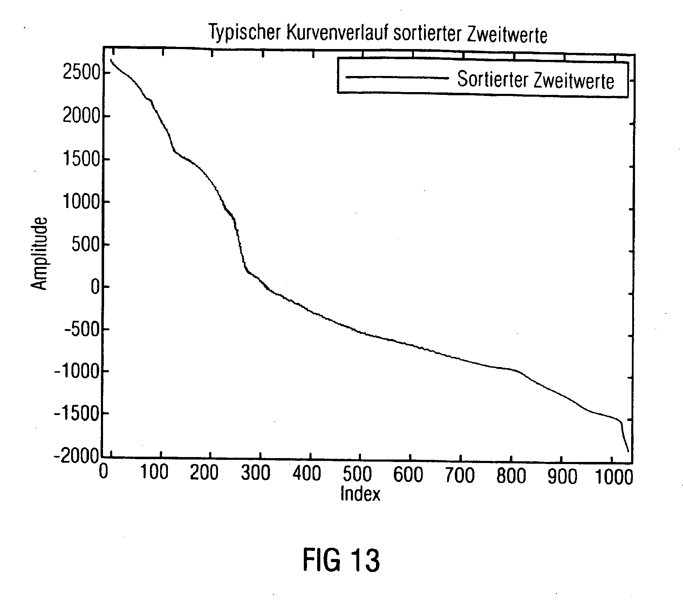

Kurvenanpassung (CF = Curve Fitting) ist eine Technik mit der in Ausführungsbeispielen versucht wird eine gegebene mathematische Modellfunktion bestmöglich an Datenpunkte, hier die sortierten Zeitwerte, anzupassen. Die Effektivität der Kurvenanpassung wird ganz wesentlich dadurch bestimmt, welche Form die zu beschreibenden Kurven haben. Sicher ist, dass es sich je nach Art der Sortierung, um monoton fallende bzw. monoton steigende Kurvenformen handelt. Die Fig. 12 und 13 zeigen zwei repräsentative Kurvenformen sortierter Zeitwerte. Beachtenswert ist die ungleichmäßige Kurvenform in Fig. 13. Solche Kurvenverläufe, welche ca. in 40% (Bezogen auf eine Auswahl von verschiedenen Audiosignalen) der Fälle auftreten, lassen sich meist nicht besonders gut durch ein Curve Fitting beschreiben.

Um Kurvenverläufe wie in den Fig. 12 und 13 gezeigt zu approximieren, wird die folgende Funktion gewählt. Diese Funktion erwies sich in Experimenten als gut dafür geeignet die hier vorliegenden Kurvenformen zu beschreiben.

$$f_{cf1}(x) = c_1 \cdot e^{-\lambda_1 x} + c_2 \cdot e^{-\lambda_2 x}$$

Die Koeffizienten $c_1, c_2, \lambda_1, \lambda_2$ sind Elemente der Menge der reellen Zahlen und können z.B. mit dem Nelder-Mead Simplex Algorithmus bestimmt werden, vgl. NELDER, J. A.; MEAD, R. A.: A Simplex Method for Function Minimization. Computer Journal, Vol. 7, p. 308-313, 1965.

Bei diesem Algorithmus handelt es sich um eine Methode zur Optimierung nichtlinearer Funktionen von mehreren Parametern. Ähnlich dem Regula-falsi-Verfahrens mit Schrittweitensteuerung wird die Tendenz der Werte Richtung Optimum angenähert. Der Nelder-Mead Simplex Algorithmus konvergiert in etwa linear und ist relativ einfach und robust. Die Funktion $f_{cf1}$ hat den Vorteil, dass sie sich sehr flexibel an eine ganze Reihe von Kurvenverläufen anpassen kann. Nachteilig ist allerdings, dass verhältnismäßig viel Seiteninformation (vier Koeffizienten) benötigt wird. Zudem fällt auf, dass Teile der sortierten Kurven, z.B. der mittlere Abschnitt von Fig. 12, gut durch ein Polynom ersten Grades (Gerade) beschrieben werden könnten und nur zwei reelle Koeffizienten a, b benötigt würden. Deshalb soll alternativ eine zweite Funktion zur Anwendung kommen:

$$f_{cf2}(x) = ax + b \quad .$$

Eine Kurvenanpassung über die gesamte Anzahl der sortierten Zeitwerte eines Blocks ist sicher zu ungenau. Deshalb würde es sich anbieten den Block in mehrere kleinere Partitionen aufzuteilen. Zerlegt man aber den Block in zu viele Partitionen die durch die Funktionen $f_{cf1}$ und $f_{cf2}$ beschrieben werden, benötigt man sehr viele Funktionskoeffizienten. Darum wird in einem Ausführungsbeispiel bei einer festen Gesamtblocklänge von 1024 Zeitwerten eine Unterteilung in 4 Partitionen zu je 256 Zeitwerten vorgenommen. Um pro Partition entscheiden zu können ob sich $f_{cf1}$ oder $f_{cf2}$ besser für eine Kurvenanpassung eignet, benötigt man ein adäquates Entscheidungskriterium. Das Entscheidungskriterium sollte zum einen einfach zu ermitteln sein, und zum anderen aussagekräfig sein. Um dies zu gewährleisten wird zunächst das Restsignal der jeweiligen Funktion gebildet und eine Abschätzung des Bitbedarfs vorgenommen. Da Funktion $f_{cf1}$ doppelt so viele Koeffizienten wie $f_{cf2}$ benötigt, werden zusätzlich 32 Bit für $f_{cf1}$ veranschlagt.

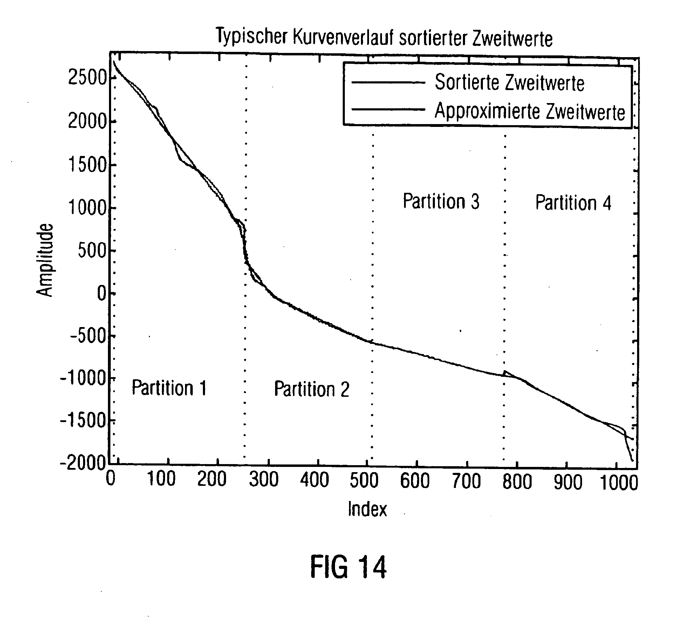

In Fig. 14 ist die Wirkungsweise von Curve-Fitting dargestellt. In diesem Frame wird die erste und vierte Partition durch *fcf2* und die zweite und dritte Partition durch *fcf1* beschrieben.

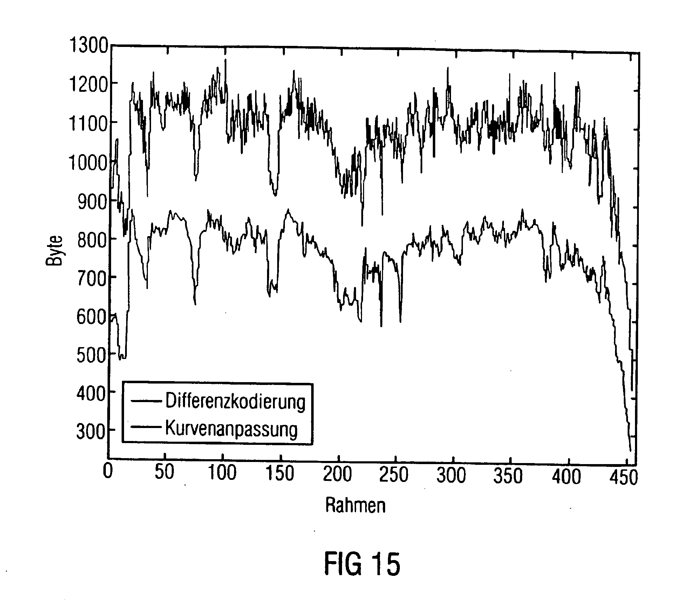

Abschließend soll ein direkter Vergleich zwischen der Differenzkodierung und einer Dekorrelation durch Kurvenanpassung erfolgen. Dazu werden die jeweiligen Kosten in Bytes pro Frame angegeben. Um einen direkten Vergleich beider Kodierverfahren zu gewährleisten, wird in beiden Fällen eine vorwärtsadaptive Rice Kodierung mit nur einem Parameter verwendet. In allen Blöcken schneidet die Differenzkodierung besser ab als das hier angegebene Kurvenanpassung bzw. Curve-Fitting, eine Gegenüberstellung ist in Fig. 15 dargestellt.

Im Nachfolgenden werden Details von Ausführungsbeispielen der vorliegenden Erfindung näher erläutert. Die folgende Tabelle listet das im Folgenden verwendete Audiomaterial auf, auf das an entsprechenden Stellen Bezug genommen wird.

| Nr. | Dateiname | Abtastrate | Bit | Kanäle | Anmerkung | Quelle | Stil |
|---|---|---|---|---|---|---|---|
| 1 | adia m.wav | 44100 Hz | 16 | 1 | | k.A. | Pop |
| 2 | white m.wav | 44100 Hz | 16 | 1 | OdBFS | s.e. | weißes Rauscher |
| 3 | es01 m.wav | 44100 Hz | 16 | 1 | Suzanne Vega | k.A. | Pop |
| 4 | es02 m.wav | 44100 Hz | 16 | 1 | geschnitten | SQAM | German Male |
| 5 | es03 m.wav | 44100 Hz | 16 | 1 | geschnitten | SQAM | English Female |
| 6 | si01 m.wav | 44100 Hz | 16 | 1 | geschnitten | SQAM | Harpsichord |
| 7 | si02 m.wav | 44100 Hz | 16 | 1 | geschnitten | SQAM | Castagnets |
| 8 | si03 m.wav | 44100 Hz | 16 | 1 | | k.A. | Pitch Pipe |
| 9 | sm01 m.wav | 44100 Hz | 16 | 1 | | k.A. | Bagpipe |
| 10 | sm02 m.wav | 44100 Hz | 16 | 1 | | k.A. | Glockenspiel |
| 11 | sm03 m.wav | 44100 Hz | 16 | 1 | | k.A. | Dulzimer |
| 12 | sc01 m.wav | 44100 Hz | 16 | 1 | geschnitten | SQAM | Trompetenkonze |
| 13 | sc02 m.wav | 44100 Hz | 16 | 1 | Richard Wagner | k.A. | Meistersinger |
| 14 | sc03 m.wav | 44100 Hz | 16 | 1 | | k.A. | Pop |
| 15 | sine 1kHz 0dB.wav | 44100 Hz | 16 | 1 | 0dBFS | s.e. | 1kHz Sinus |
| 16 | adia LeqR. wav | 44100 Hz | 16 | 2 | L=R | s.e. | Pop |
| 17 | adia.wav | 44100 Hz | 16 | 2 | | k.A. | Pop |
| 18 | es01.wav | 44100 Hz | 16 | 2 | Suzanne Vega | k.A. | Pop |
| 19 | es02.wav | 44100 Hz | 16 | 2 | geschnitten | SQAM | German Male |
| 20 | es03. wav | 44100 Hz | 16 | 2 | geschnitten | SQAM | English Female |

(fortgesetzt)

| Nr. | Dateiname | Abtastrate | Bit | Kanäle | Anmerkung | Quelle | Stil |
|-----|-----------|-----------|-----|--------|-----------|--------|------|
| 21 | si01.wav | 44100 Hz | 16 | 2 | geschnitten | SQAM | Harpsichord |
| 22 | si02.wav | 44100 Hz | 16 | 2 | geschnitten | SQAM | Castagnets |
| 23 | si03.wav | 44100 Hz | 16 | 2 | | k.A. | Pitch Pipe |
| 24 | sm01.wav | 44100 Hz | 16 | 2 | | k.A. | Bagpipe |
| 25 | sm02.wav | 44100 Hz | 16 | 2 | geschnitten | SQAM | Glockenspiel |
| 26 | sm03.wav | 44100 Hz | 16 | 2 | | k.A. | Dulzimer |
| 27 | sc01.wav | 44100 Hz | 16 | 2 | geschnitten | SQAM | Trompetenkonze |
| 28 | sc02.wav | 44100 Hz | 16 | 2 | Richard Wagner | k.A. | Meistersinger |
| 29 | sc03.wav | 44100 Hz | 16 | 2 | | k.A. | Pop |

Man kann die verlustlose Kodierung grob in zwei Bereiche unterteilen. Es gibt universelle Verfahren, die mit Daten unterschiedlichster Art arbeiten können, und es gibt spezialisierte Verfahren, die darauf optimiert sind ganz spezielle Daten wie z.B. Audiosignale zu komprimieren.

Bereits seit vielen Jahren existieren universelle Verfahren wie GZIP oder ZIP zur Kompression von digitalen Daten. GZIP verwendet zur Komprimierung den Deflate-Algorithmus, der eine Kombination aus LZ77 (siehe Ziv, Jacob; Lempel, Abraham: A Universal Algorithm for Sequential Data Compression. IEEE Transactions on Information Theory, Vol. IT-23, No. 3, May 1977) und Huffman Kodierung (siehe Huffman, David A.: A Method for the Construction of Minimum-Redundancy Codes. Proceedings of the I.R.E, September, 1952) ist. Auch das ZIP Dateiformat verwendet einen ähnlichen Algorithmus zur Kompression. Ein weiteres universelles Verfahren ist BZIP2. Vor der eigentlichen Kodierung der Daten findet hier eine Präkodierung mit der Burrows-Wheeler-Transformation (BWT) (siehe Burrows, M.; Wheeler, D.: A block sorting lossless data compression algorithm. Technical Report 124, Digital Equipment Corporation, 1994) statt.

BZIP2 verwendet auch eine Huffman Kodierung. Diese Programme lassen sich auf beliebige Daten wie z.B. Text, Programmcode, Audiosignale, etc. anwenden. Aufgrund ihrer Arbeitsweise erreichen diese Verfahren allerdings bei Text eine wesentlich bessere Kompression als bei Audiosignalen. Ein direkter Vergleich von GZIP und dem auf Audiosignale spezialisierten Kompressionsverfahren SHORTEN (siehe Robinson, Tony: SHORTEN: Simple lossless and near lossless waveform compression. Technical report CUED/FINFENG/TR.156, Cambridge University Engineering Department, December 1994) bestätigt dies, siehe folgende Tabelle. Es wurden die jeweiligen Standardeinstellungen für den Test verwendet.

| Stück Nr. | Dateigröße (Bytes) | GZIP | | SHORTEN | |
|-----------|---------------------|----------------|-------|----------------|-------|
| | | Dateigröße . | F | Dateigröße . | F |
| 13 | 2246022 | 1962100 | 1.145 | 1102557 | 2.037 |
| 14 | 2037842 | 1724447 | 1.182 | 1304845 | 1.562 |
| 17 | 1912876 | 1753719 | 1.091 | 1117413 | 1.712 |

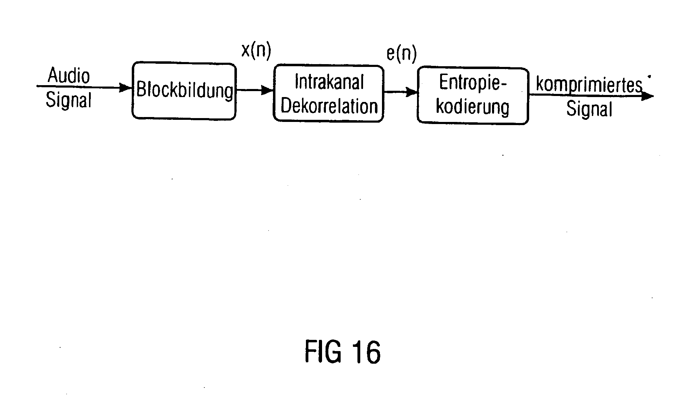

Um also für Audiosignale einen guten Kompressionsfaktor zu erhalten, müssen die speziellen Eigenschaften von Audiosignalen bei der Kompression berücksichtigt werden. Die meisten verlustlosen Audiokodierverfahren haben das in Fig. 16 gezeigte Blockschaltbild gemeinsam.

Fig. 16 zeigt beispielhaft Verarbeitungsschritte der meisten verlustlosen Audiokompressionsalgorithmen. Die Darstellung in der Fig. 16 zeigt ein Blockdiagramm, wobei das Audiosignal zunächst einer Blockbildung oder einem engl. "Framing"-Block zugeführt wird, der das Audiosignal in Signalblöcke unterteilt. Nachfolgend dekorreliert ein Intrakanal-Dekorrelationsblock oder engl. "Intrachannel Decorrelation"-Block einzelne das Signal, beispielsweise durch eine Differenzkodierung. In einem Entropiekodierungsblock oder engl. "Entropy Coding"-Block wird das Signal schließlich entropiekodiert, vgl. auch Hans, Mat; Schafer, Ronald W.: Lossless Compression of Digital Audio. IEEE Signal Processing Magazine, July 2001.

Zunächst werden die zu verarbeitenden Daten in Signalabschnitte (Frames) $x(n) \in Z$ (Z entspricht der Menge der ganzen Zahlen) einer bestimmten Größe zerlegt. Dann folgt ein Dekorrelationsschritt, in dem versucht wird so gut wie möglich die Redundanz aus dem Signal zu entfernen. Letztlich wird das aus dem Dekorrelationsschritt entstandene Signal $e(n) \in Z$ entropiekodiert. Bisher gibt es zwei prinzipielle Vorgehensweisen für den Dekorrelationsschritt. Die meisten verlustlosen Audiokodierverfahren verwenden eine Art lineare Prädiktion, um die Redundanz aus dem Signal zu entfernen (Predictive Modeling). Andere verlustlose Audiokoderverfahren basieren auf einem verlustbehafteten Audiokodierverfahren, bei dem neben den verlustbehafteten Daten zusätzlich das Rest- oder Fehlersignal (auch Residualsignal) zum Originalsignal kodiert wird (Lossy Coding Model). Anschließend sollen die unterschiedlichen Herangehensweisen genauer betrachtet werden.

Die Lineare Prädiktion (Linear Predictive Coding - LPC) ist vor allem in der digitalen Sprachsignalverarbeitung weit verbreitet. Ihre Bedeutung liegt nicht nur in der hohen Effizienz, sondern auch in der relativ geringen Berechnungskomplexität. Die Grundidee der Prädiktion besteht darin einen Wert $x(n)$ aus vorangegangenen Werten $x(n-1)$, $x(n-2)$, ... , $x(n-p)$ vorherzusagen. Werden p vorhergehende Werte zur Prädiktion verwendet, spricht man von einem Prädiktor p-ter Ordnung. Die in der verlustlosen Audiokodierung verwendeten Prädiktionskodierverfahren haben üblicherweise die in Fig. 12 gezeigte grundlegende Struktur. $\hat{A}(z)$ und $\hat{B}(z)$ stehen dabei für z-Transformationspolynome (siehe Mitra, Sanjit K.: Digital Signal Processing. New York: McGraw-Hill, 2001, S. 155-176) mit quantisierten Koeffizienten $\hat{a}_k$ und $\hat{b}_k$. Q steht für Quantisierung zur selben Wortlänge wie $x(n)$. Die z-Transformation ist das zeitdiskrete Analogon zur Laplace-Transformation zeitkontinuierlicher Signale.

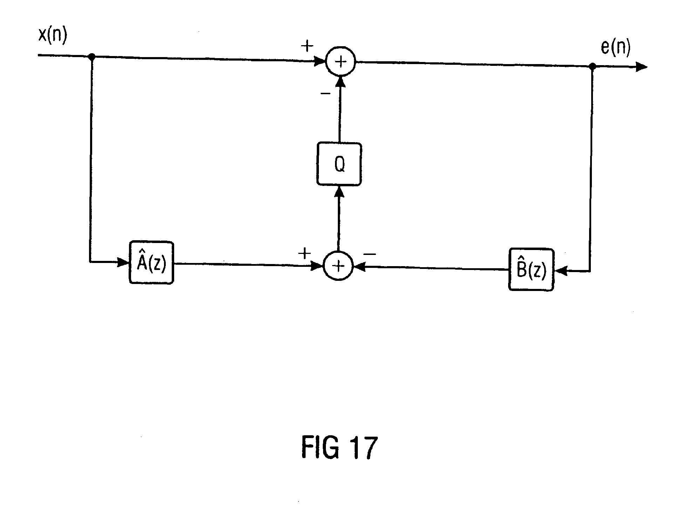

Fig. 17 zeigt ein Ausführungsbeispiel einer Struktur einer Prädiktionskodierung. Prinzipiell zeigt Fig. 17 eine IIR-Filter-Struktur mit einem Mitkopplungszweig mit Filterkoeffizienten $\hat{A}(z)$, einem Gegenkopplungszweig mit Filterkoeffizienten $\hat{B}(z)$, und einer Quantisierung Q.

Hinter Fig. 17 verbirgt sich die Gleichung

$$e(n) = x(n) - Q\left[\underbrace{\sum_{k=1}^{p} \hat{a}_k x(n-k)}_{\textit{feedforward Term}} - \underbrace{\sum_{k=1}^{q} \hat{b}_k e(n-k)}_{\textit{feedback Term}}\right]$$

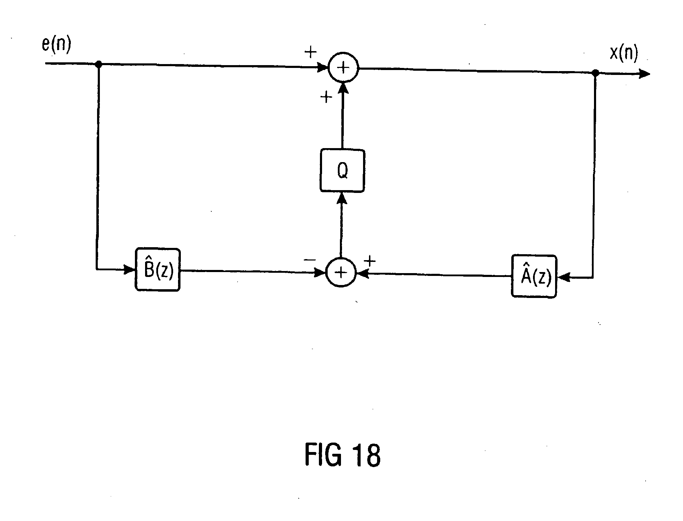

Falls das Prädiktionskodierverfahren optimal arbeitet, wird ein großer Teil der Redundanz aus $x(n)$ entfernt und durch die Koeffizienten von $\hat{A}(z)$ und $\hat{B}(z)$ repräsentiert. Das entstehende Restsignal $e(n)$ ist dann unkorreliert und von der Amplitude deutlich kleiner als das Originalsignal $x(n)$. Dadurch wird ein Kodiergewinn erreicht. Falls $\hat{B}(z) = 0$, also der feedback Term gleich 0 ist, spricht man von einem FIR-Prädiktor. Andernfalls, also $\hat{B}(z) \neq 0$, spricht man von einem IIR-Prädiktor. IIR-Prädiktoren sollen hier nicht näher betrachtet werden. IIR-Prädiktoren sind deutlich komplexer, können aber in einigen Fällen einen besseren Kodiergewinn als FIR-Pädiktoren erzielen (siehe Craven, P.; Law, M.; Stuart J.: Lossless Compression using IIR prediction filters. Munich : 102nd AES Conv., 1997). Um aus dem Restsignal $e(n)$ und den Prädiktorkoeffizienten das ursprüngliche Signal wieder rekonstruieren zu können, geht man wie in Fig. 18 vor.

Fig. 18 zeigt ein Ausführungsbeispiel einer Struktur einer Rekonstruktion bei einer Prädiktionskodierung. Fig. 18 zeigt eine Ausführung als IIR-Filter-Struktur mit einem Mitkopplungszweig mit Filterkoeffizienten $\hat{B}(z)$, einem Gegenkopplungszweig mit Filterkoeffizienten $\hat{A}(z)$, und einer Quantisierung Q.

Hinter Fig. 18 verbirgt sich die Gleichung

$$x(n) = e(n) + Q\left[\sum_{k=1}^{p} \hat{a}_k x(n-k) - \sum_{k=1}^{q} \hat{b}_k e(n-k)\right]$$

Die Prädiktorkoeffizienten werden für jeden zu verarbeitenden Signalabschnitt jedesmal neu bestimmt und übertragen. Dabei kann die adaptive Bestimmung der Koeffizienten ak eines Prädiktors p-ter Ordnung entweder mit der Kovarianzmethode oder mit der Autokorrelationsmethode, welche die Autokorrelationsfunktion benutzt, erfolgen. Mit der Autokorrelationsmethode erhält man die Koeffizienten über die Lösung eines linearen Gleichungssystems folgender Form:

$$\begin{pmatrix} r_{xx}(1) \\ r_{xx}(2) \\ r_{xx}(3) \\ \vdots \\ r_{xx}(p) \end{pmatrix} = \begin{pmatrix} r_{xx}(0) & r_{xx}(1) & r_{xx}(2) & \cdots & r_{xx}(p-1) \\ r_{xx}(1) & r_{xx}(2) & r_{xx}(1) & \cdots & r_{xx}(p-2) \\ r_{xx}(2) & r_{xx}(3) & r_{xx}(0) & \cdots & r_{xx}(p-3) \\ \vdots & \vdots & \vdots & \cdots & \vdots \\ r_{xx}(p-1) & r_{xx}(p-2) & r_{xx}(p-3) & \cdots & r_{xx}(0) \end{pmatrix} \begin{pmatrix} a_1 \\ a_2 \\ a_3 \\ \vdots \\ a_p \end{pmatrix}.$$

Wobei $r_{xx}(k) = E(s(n)s(n+k))$ gilt (siehe Sayood, Khalid: Introduction to Data Compression. San Francisco : Morgan Kaufmann, Third Edition, 2006, S. 333). Alternativ kann man dies in Matrixschreibweise durch

$$r = \mathbf{R}a$$

darstellen. Weil R invertierbar ist, erhält man die Koeffizienten durch

$$a = \mathbf{R}^{-1}r$$

Wie man genau auf das lineare Gleichungssystem zur Bestimmung der optimalen Prädiktorkoeffizienten kommt, ist detailliert in Jayant, N. S., Noll, P.: Digital Coding of Waveforms - Principles and Applications to Speech and Video. Prentice Hall, Englewood Cliffs, New Jersey, 1984, S. 267-269, Sayood, Khalid: Introduction to Data Compression. San Francisco : Morgan Kaufmann, Third Edition, 2006, S. 332-334 und Rabiner, L. R.; Schafer, R. W.: Digital Processing of Speech Signals. New Jersey : Prentice-Hall, 1978, S. 396-404, beschrieben. Die Gleichung läßt sich aufgrund der Matrixeigenschaften von **R** sehr effektiv mit dem Levinson-Durbin Algorithmus (siehe Yu, R.; Lin, X.; Ko, C.C.: A Multi-Stage Levinson-Durbin Algorithm. IEEE Proc., Vol. 1, pp. 218-221, November 2002, S. 218-221, lösen.

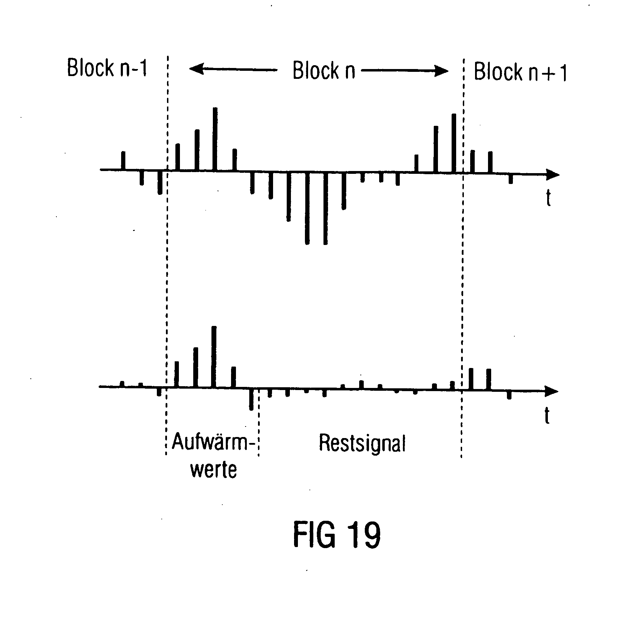

Für eine Prädiktion nimmt man eine Einteilung der Zeitwerte in Blöcke der Größe N vor. Angenommen man möchte einen Prädiktor 2-ter Ordnung benutzen, um die Zeitwerte aus dem aktuellen Block n zu prädizieren, dann ergibt sich das Problem wie mit den ersten beiden Werten aus Block n zu verfahren ist. Man kann entweder die letzten beiden Werte aus dem vorhergehenden Block n-1 dazu verwenden diese zu prädizieren, oder die ersten beiden Werte von Block n nicht prädizieren und diese in ihrer ursprünglichen Form belassen. Wird auf Werte aus einem vorhergehenden Block n-1 zurückgegriffen, dann ist Block n nur dekodierbar wenn Block n-1 erfolgreich dekodiert wurde. Dies würde aber zu Blockabhängigkeiten führen und dem Grundsatz wiedersprechen jeden Block (Frame) als eine für sich alleinstehende dekodierbare Einheit zu behandeln. Werden die ersten p Werte in ihrer ursprünglichen Form belassen, werden sie als engl. Warmup oder Aufwärmwerte (siehe Fig. 19) des Prädiktors bezeichnet. Weil das Warmup üblicherweise andere Größenverhältnisse und statistische Eigenschaften als das Restsignal hat, wird es meist nicht entropiekodiert.

Fig. 19 zeigt ein Ausführungsbeispiel von Warmup-Werten eines Prädiktionsfilters. Im oberen Bereich der Fig. 19 sind unveränderte Eingangssignale dargestellt, im unteren Bereich sind Aufwärmwerte und ein Restsignal dargestellt.

Eine andere Möglichkeit eine Prädiktion zu realisieren besteht darin, die Koeffizienten nicht für jeden Signalabschnitt neu zu bestimmen, sondern immer feste Prädiktorkoeffizienten zu verwenden. Werden immer die gleichen Koeffizienten verwendet, spricht man auch von einem Fixed Predictor.

Beispielhaft soll nun AudioPaK (siehe Hans, Mat; Schafer, Ronald W.: Lossless Compression of Digital Audio. IEEE Signal Processing Magazine, July 2001, S. 28-31), ein Vertreter des Predictive Modeling, etwas näher betrachtet werden. Zuerst wird bei AudioPaK das Audiosignal in unabhängige für sich dekodierbare Abschnitte zerlegt. Üblicherweise werden Vielfache von 192 Abtastwerten (192, 576, 1152, 2304, 4608) verwendet. Zur Dekorrelation wird ein FIR-Prädiktor mit festen ganzzahligen Koeffizienten verwendet (Fixed Predictor). Dieser FIR-Prädiktor wurde erstmals in SHORTEN (siehe Robinson, Tony: SHORTEN: Simple lossless and nearlossless waveform compression. Technical report CUED/FINFENG/ TR.156, Cambridge University Engineering Department, December 1994, S. 3-4) verwendet. Intern besitzt der Fixed Predictor vier verschiedene Vorhersagemodelle.

$$\hat{x}_0(n) \;\; = \;\; 0$$

$$\hat{x}_1(n) = x(n-1)$$

$$\hat{x}_2(n) = 2x(n-1)-x(n-2)$$

$$\hat{x}_3(n) = 3x(n-1)-3x(n-2)+x(n-3)$$

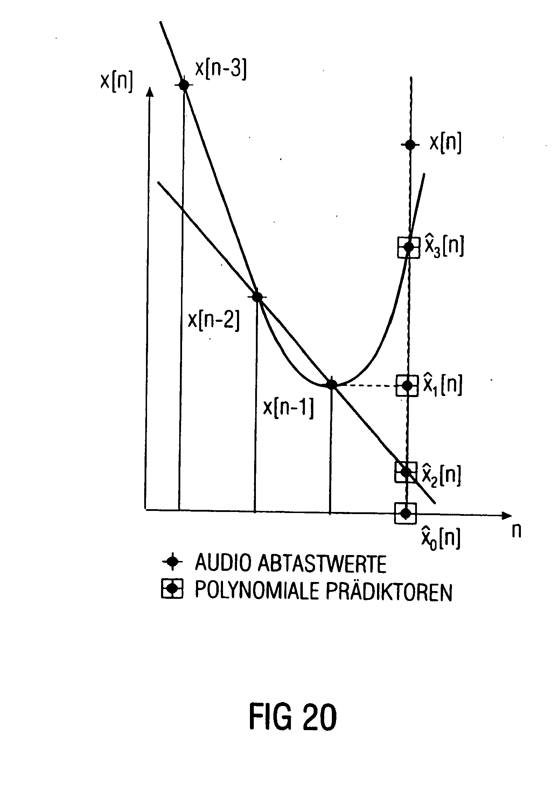

Prinzipiell handelt es sich in der Gleichung um polynomielle Approximations- bzw. Vorhersagemethoden. Durch ein Polynom vom Grad p-1 können die vorhergehenden p Abtastwerte x(n-1), x(n-2), ..., x(n-p) beschrieben werden. Wertet man nun dieses Polynom an der Stelle n aus, so erhält man den vorhergesagten Wert $\hat{x}(n)$. Grafisch kann man sich dies wie in Fig. 20 gezeigt veranschaulichen. Fig. 20 zeigt ein Ausführungsbeispiel eines Vorhersagemodells, in einem polynomialen Prädiktor.

Die durch die Prädiktion entstehenden Restsignale $e_p(n)=x(n)-\hat{x}p(n)$ lassen sich wie in folgender Gleichung relativ einfach rekursiv berechnen.

$$e_0(n) = x(n)$$

$$e_1(n) = e_0(n)-e_0(n-1)$$

$$e_2(n) = e_1(n)-e_1(n-1)$$

$$e_3(n) = e_2(n)-e_2(n-1)$$

Letztlich wird das beste Vorhersagemodell dadurch bestimmt, dass die Summe der Beträge der Restsignalwerte am kleinsten werden. AudioPaK verwendet eine Rice Kodierung. Da die Werte des Restsignals $e_i(n) \in Z$, die Rice Kodierung aber mit Werten aus $N_0$ arbeitet, wird zunächst eine Abbildung der Restwerte $e_i(n)$ nach $N_0$ vorgenommen.

$$M(e_i(n)) = \begin{cases} 2e_i(n) & falls\ e_i(n) \geq 0 \\ 2|e_i(n)|-1 & sonst \end{cases}$$

Der Rice-Parameter k wird pro Block (Frame) bestimmt, und nimmt Werte 0, 1, ..., (b-1) an. Wobei b die Anzahl der Bits pro Audioabtastwert darstellt. k wird über folgende Gleichung ermittelt

$$k = \left| \log_2 \left( E \left( |e_i(n)| \right) \right) \right|$$

Eine einfache Abschätzung von k ohne jegliche Gleitkommaoperationen kann beispielsweise folgendermaßen geschehen: *for (k=0, N=framesize; N<AbsError; k++, N\*=2) {NULL; }*

Wobei *framesize* die Anzahl der Abtastwerte pro Frame und *AbsError* die Summe der Absolutwerte des Restsignals darstellt. Weitere Vertreter des Predictive Modeling sind SHORTEN (siehe Robinson, Tony: SHORTEN: Simple lossless and nearlossless waveform compression. Technical report CUED/FINFENG/TR.156, Cambridge University Engineering Department,December 1994), FLAC (siehe Coalson, Josh: FLAC - Free Lossless Audio Codec; http://flac.sourceforge.net), MPEG-4 Audio Lossless Coding (MPEG-4 ALS) (siehe Liebchen, Tilman; Reznik, Yuriy; Moriya, Takehiro; Yang, Dai Tracy: MPEG-4 Audio Lossless Coding. Berlin, Germany : 116th AES Convention, May 2004) und Monkey's Audio (siehe Ashland, Matthew T.: Monkey's Audio - a fast and powerful lossless audio compressor; http:

//www.monkeysaudio.com/index.html).

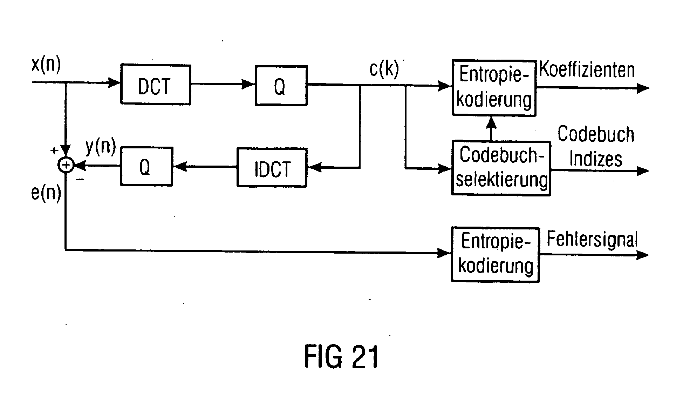

Die zweite Möglichkeit ein verlustloses Audiokodierverfahren zu realisieren besteht darin auf ein verlustbehaftetes Audiokodierverfahren aufzusetzen. Ein Vertreter des Lossy Coding Model ist LTAC, wobei statt LTAC (Lossless Transform Audio Compression) auch die Abkürzung LTC (Lossless Transform Coding) verwendet wird, siehe Liebchen, Tilman; Purat, Marcus; Noll, Peter: Lossless Transform Coding of Audio Signals. Munich, Germany : 102nd AES Convention, 1997. Die prinzipielle Arbeitsweise des Encoders ist in Fig. 21 dargestellt.

Fig. 21 zeigt ein Blockdiagramm einer Struktur eines LTAC (LTAC = Lossless Transform Coding) Encoders. Der Encoder umfasst einen "DCT"-Block um ein Eingangssignal x(n) in den Frequenzbereich zu transformieren, woran eine Quantisierung Q anschließt. Das quantisierte Signal c(n) kann dann über einen "IDCT"-Block zurück in den Zeitbereich transformiert werden, wo es dann über einen weiteren Quantisierer Q quantisiert von dem ursprünglichen Eingangssignal subtrahiert werden kann. Das Restsignal e(n) kann dann entropiekodiert übertragen werden. Das quantisierte Signal c(n) kann ebenfalls über eine Entropiekodierung, die entsprechend der Fig. 21 aus verschiedenen Codebüchern auswählen kann, kodiert werden.

Bei LTAC werden die Zeitwerte x(n) durch eine orthogonale Transformation (DCT - Diskrete Kosinus Transformation) in den Frequenzbereich transformiert. Im verlustbehafteten Teil werden dann die Spektralwerte quantisiert c(k) und entropiekodiert.

Um nun ein verlustloses Kodierverfahren zu realisieren, werden zusätzlich die quantisierten Spektralwerte c(k) mit der inversen Transformation (IDCT = Inverse Discrete Cosinus Transformation) zurücktransformiert und abermals quantisiert y(n). Das Restsignal wird durch e(n)=x(n)-y(n) berechnet. Anschließend wird e(n) entropiekodiert und übertragen. Im Decoder kann man aus c(k) durch die IDCT mit anschließender Quantisierung wieder y(n) erhalten. Letztlich wird eine perfekte Rekonstruktion von x(n) im Decoder durch y(n)+e(n)=y(n)+[x(n)-y(n)]=x(n) realisiert.

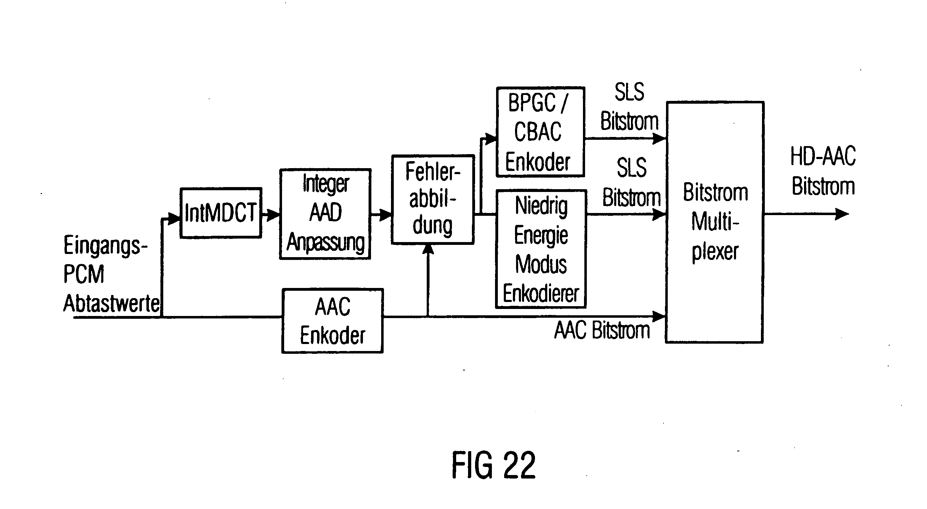

Ein weiteres Verfahren welches in die Kategorie des Lossy Coding Model fällt, ist MPEG-4 Scalable Lossless Audio Coding (MPEG-4 SLS) (siehe Geiger, Ralf; Yu, Rongshan; Herre, Jürgen; Rahardja, Susanto; Kim, Sang-Wook; Lin, Xiao; Schmidt, Markus: ISO/IEC MPEG-4 High-Definition Scalable Advanced Audio Coding. Paris : 120th AES Convention, May 2006). Es verbindet Funktionalitäten der verlustfreien Audiokodierung, der verlustbehafteten Audiokodierung und der skalierbaren Audiokodierung. MPEG-4 SLS ist auf Bitstromebene rückwärtskompatibel zu MPEG-4 Advanced Audio Coding (MPEG-4 AAC) (siehe ISO/IEC JTC1/SC29/WG11: Coding of Audiovisual Objects, Part 3. Audio, Subpart 4 Time/Frequency Coding. International Standard 14496-3, 1999). Fig. 22 zeigt ein Blockdiagramm eines MPEG-4 SLS (SLS = Scalable Lossless Audio Coding) Encoders.

Die Audiodaten werden zunächst mit einer IntMDCT (Integer Modified Discrete Cosine Transform) (siehe Geiger, Ralf; Sporer, Thomas; Koller, Jürgen; Brandenburg, Karlheinz: Audio Coding Based on Integer Transforms; New York : 111nd AES Conv., 2001) in den Frequenzbereich transformiert und anschließend durch ein Temporal Noise Shaping (TNS) und eine Mitten-/Seitenkanal-Kodierung weiterverarbeitet (Integer AAC Tools/Anpassung). Alles was der AAC Encoder kodiert, wird dann von den IntMDCT Spektralwerten durch ein Error Mapping/Fehlerabbildung entfernt. Übrig bleibt ein Restsignal welches einer Entropiekodierung unterzogen wird. Für die Entropiekodierung wird ein BPGC (Bit-Plane Golomb Co-de), CBAC (Context-Based Arithmetic Code) und Low Energy Mode/Niedrig Energie Modus verwendet.

Die Schallübertragung über zwei oder mehr Kanäle wird als Stereophonie bezeichnet. In der Praxis wird der Begriff Stereo meist ausschließlich für zweikanalige Stücke verwendet. Liegen mehr als zwei Kanäle vor, spricht man von Mehrkanalton. Diese Masterarbeit beschränkt sich auf Signale mit zwei Kanälen, wofür synonym die Bezeichnung Stereosignale verwendet wird. Eine Möglichkeit Stereosignale zu verarbeiten besteht darin beide Kanäle unabhängig voneinander zu kodieren. In diesem Fall spricht man von unabhängiger Stereokodierung (Independent Stereo Coding). Abgesehen von "pseudostereo"-Versionen alter Monoaufnahmen (beide Kanäle identisch) oder Zweikanalton beim Fernsehen (unabhängige Kanäle) weisen Stereosignale in aller Regel sowohl Unterschiede wie auch Gemeinsamkeiten (Redundanz) zwischen den beiden Kanälen auf. Wenn es gelingt die Gemeinsamkeiten zu ermitteln und sie für beide Kanäle lediglich einmal zu übertragen, kann man die Bitrate reduzieren. In diesem Fall spricht man von abhängiger Stereokodierung (Joint Stereo Coding). Eine Möglichkeit die Redundanz zwischen Stereosignalen zu reduzieren ist die Mitten-/Seitenkanal-Kodierung (MS-Kodierung). Diese Technik wurde erstmals für verlustbehaftete Audiokodierverfahren in Johnston, J. D.; Ferreira, A. J.: Sum-Difference Stereo Transform Coding, IEEE International Conference, ICASSP,1992; beschrieben. Wie man aus einem linken Kanal L und einem rechten Kanal R einen Mittenkanal M und einen Seitenkanal S erzeugt zeigt die folgende Gleichung

$$\begin{pmatrix} \dfrac{1}{2} & \dfrac{1}{2} \\ \dfrac{1}{2} & -\dfrac{1}{2} \end{pmatrix} \begin{pmatrix} L \\ R \end{pmatrix} = \begin{pmatrix} M \\ S \end{pmatrix}$$

Da

$$\det \begin{pmatrix} \dfrac{1}{2} & \dfrac{1}{2} \\ \dfrac{1}{2} & -\dfrac{1}{2} \end{pmatrix} \neq 0$$

ist die MS-Kodierung invertierbar

$$\begin{pmatrix} 1 & 1 \\ 1 & -1 \end{pmatrix} \begin{pmatrix} M \\ S \end{pmatrix} = \begin{pmatrix} L \\ R \end{pmatrix}.$$

Auch verlustlose Audiokodierverfahren nutzen die MS-Kodierung. Da die obige Gleichung aber die Eigenschaft hat, dass sich in manchen Fällen Gleitkommazahlen statt Ganzzahlen (Integer) ergeben, wird von einigen verlustlosen Audiokodierverfahren (siehe Ashland, Matthew T.: Monkey's Audio - a fast and powerful lossless audio compressor; http://www.monkeysaudio.com/index.html) die folgende Gleichung für eine MS-Kodierung verwendet

$$M = NINT\left(\frac{L+R}{2}\right)$$

$$S = L - R$$

NINT bedeutet hier Rundung zur nächstgelegenen Ganzzahl bezüglich Null.
Neben einer MS-Kodierung verwenden verlustlose Audiokodierverfahren auch eine LS-Kodierung bzw. RS-Kodierung (siehe Coalson, Josh: FLAC - Free Lossless Audio Codec; http://flac.sourceforge.net). Um aus einer LS-Kodierung den rechten Kanal bzw. aus einer RS-Kodierung den linken Kanal zu erhalten geht man wie in folgender Gleichung vor

$$L = R + S$$

$$R = L - S$$

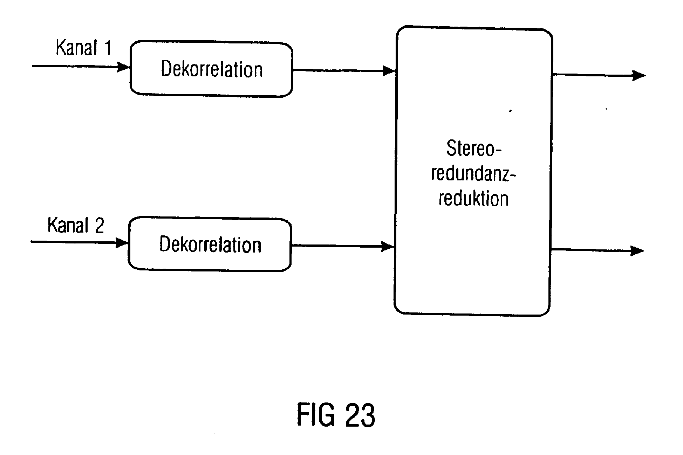

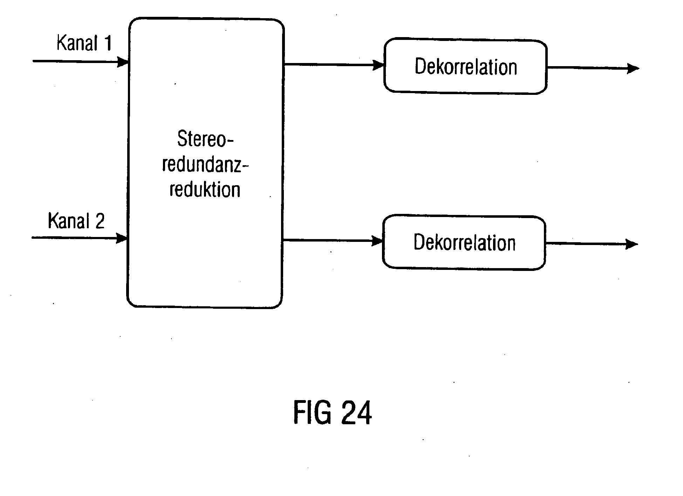

Es gibt zwei prinzipielle Möglichkeiten eine Stereoredundanzreduktion (Stereo Redundancy Reduction - SRR) durchzuführen. Entweder nach der Dekorrelation der einzelnen Kanäle (siehe Fig. 23) oder vor der Dekorrelation der einzelnen Kanäle (siehe Fig. 24). Fig. 23 zeigt eine Stereoredundanzreduktion (SRR) nach Dekorrelation einzelner Kanäle, Fig. 24 eine Stereoredundanzreduktion vor Dekorrelation einzelner Kanäle. Beide Methoden haben spezifische Vor- als auch Nachteile. Im folgenden soll aber ausschließlich Methode 2 verwendet werden.
In diesem Abschnitt soll für die vorgestellte lineare Prädiktion (LPC = Linear Prediction Coding) eine geeignete Quantisierung entwickelt werden. Die ermittelten Koeffizienten $a_z$ sind in aller Regel Gleitkommawerte (reelle Zahlen), was in digitalen Systemen immer nur mit endlicher Genauigkeit dargestellt werden kann. Also muss eine Quantisierung der Koeffizienten $a_z$ stattfinden. Dies kann aber zu größeren Prädiktionsfehlern führen und ist bei der Erzeugung des Restsignals zu berücksichtigen. Deshalb ist es sinnvoll die Quantisierung über einen Genauigkeitsparameter g zu steuern. Ist g groß findet eine feinere Quantisierung der Koeffizienten statt und es werden mehr Bits für die Koeffizienten benötigt. Ist g klein findet eine gröbere Quantisierung der Koeffizienten statt und es sind weniger Bits für die Koeffizienten nötig. Um eine Quantisierung realisieren zu können, wird zunächst der betragsmäßig größte Koeffizient $a_{max}$ ermittelt

$$a_{max} = \max\left(|a_i|\right)$$

*für i=1,2,..., p.*
Der so ermittelte maximale Prädiktorkoeffizient $a_{max}$ wird jetzt in eine Mantisse M und in einen Exponenten E zur Basis 2 zerlegt, also

$$a_{max} = 2^E \cdot M .$$

Die Mantisse M wird im weiteren Verlauf nicht mehr benötigt, aber der Exponent E dient dazu den Skalierungsfaktor s durch folgende Gleichung zu ermitteln

$$s = g - E - 1 .$$

Die Subtraktion von 1 dient dazu vorzeichenbehafteten Koeffizienten Rechnung zu tragen. Die quantisierten Prädiktorkoeffizienten ergeben sich für i=1,2,..., p durch die Gleichung

$$\hat{a}_i = \left\lfloor a_i \cdot 2^s \right\rfloor .$$

Mit dem Skalierungsfaktor s und den quantisierten Prädiktorkoeffizienten $\hat{a}_i$ wird das zu übertragende Restsignal *e(n)* ermittelt

$$e(n) = x(n) - \left\lfloor \left( \sum_{k=1}^{p} \hat{a}_i x(n-k) \right) \cdot 2^{-s} \right\rfloor .$$

Die Gleichung stellt sicher, dass $e(n) \in Z$ gilt. Durch eine Übertragung des Warmup, der Parameter *g, s, p,* $\hat{a}_i$ und des Restsignals *e(n)* zum Decoder ist dadurch eine perfekte Rekonstruktion der ursprünglichen Werte *x(n)* dieses Signalabschnitts möglich

$$x(n) = e(n) + \left\lfloor \left( \sum_{k=1}^{p} \hat{a}_i x(n-k) \right) \cdot 2^{-s} \right\rfloor .$$

Vergrößert man die Ordnung des Prädiktors, verkleinert dies in der Regel die Varianz und Amplitude des Restsignals. Dies hat eine kleinere Datenrate für das Restsignal zur Folge. Auf der anderen Seite ist es aber so, dass für eine größere Prädiktorordnung auch mehr Koeffizienten und ein größeres Warmup, also mehr Seiteninformation, übertragen werden muss. Dadurch steigt die Gesamtdatenrate wieder an. Die Aufgabe besteht also darin eine Ordnung zu finden, bei der die Gesamtdatenrate minimiert wird.

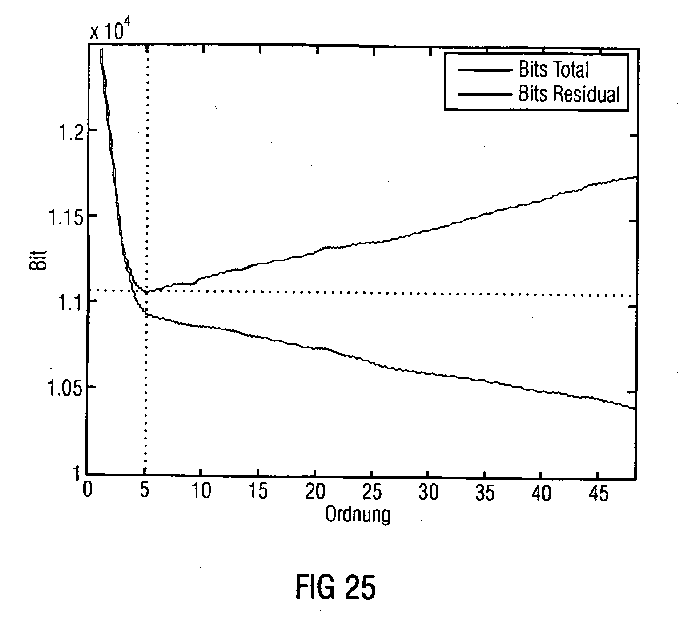

In Fig. 25 ist der Zusammenhang von Prädiktorordnung und Gesamtbitverbrauch dargestellt. Es ist klar zu erkennen, dass mit steigender Ordnung das Restsignal immer weniger Bits für eine Kodierung benötigt. Allerdings nimmt die Datenrate für die Seiteninformation (quantisierte Prädiktorkoeffizienten und Warmup) kontinuierlich zu, wodurch die Gesamtdatenrate ab einem gewissen Punkt wieder ansteigt. In aller Regel wird ein Minimum bei 1<p<16 erreicht. In Fig. 25 ergibt sich eine optimale Ordnung bei p=5. Für Fig. 25 wurde ein fester Wert für die Quantisierungssteuerung von g=12 und eine Auflösung von 16Bit pro Abtastwert für das Eingangssignal verwendet.

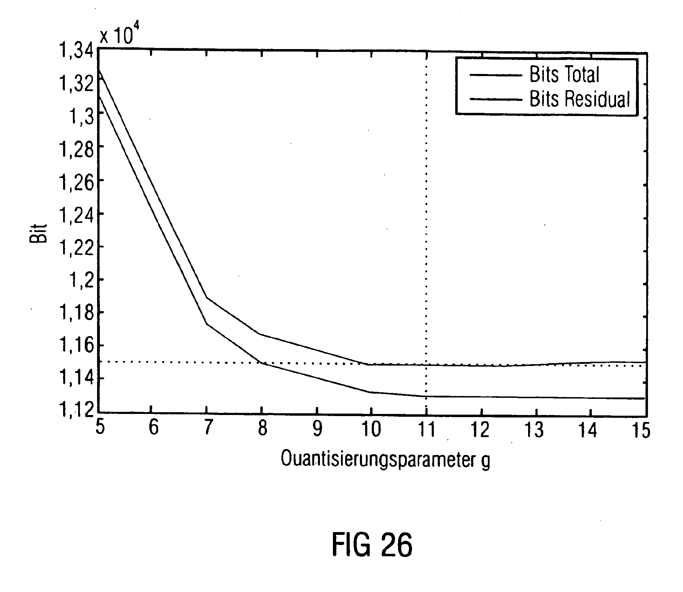

Fig. 26 zeigt eine Illustration des Zusammenhangs von Quantisierungparameters g und Gesamtbitverbrauch. Betrachtet man die Gesamtdatenrate in Abhängigkeit vom Quantisierungsparameter g (siehe Fig. 26), so sinkt der Bitverbrauch für das Restsignal kontinuierlich bis zu einem gewissen Wert. Ab hier nützt eine weitere Erhöhung der Quantisierungsgenauigkeit nichts mehr. D.h. die nötige Anzahl an Bits für das Restsignal bleibt annähernd konstant. Die Gesamtdatenrate sinkt anfangs auch kontinuierlich, steigt dann aber aufgrund größer werdender Seiteninformation für die quantisierten Prädiktorkoeffizienten wieder an. In den meisten Fällen ergibt sich ein Optimum bei 5<g<15. In Fig. 26 liegt das Minimum bei g=11. Für Fig. 26 wurde eine konstante Prädiktorordnung von p=7 und eine Auflösung von 16 Bit pro Abtastwert für das Eingangssignal verwendet.

Die eben gewonnenen Erkenntnisse sollen nun genutzt werden einen Algorithmus für eine verlustlose lineare Prädiktion in einer vereinfachten MATLAB Codedarstellung anzugeben (siehe lpc()). Bei MATLAB handelt es sich um eine kommerzielle mathematische Software die für Berechnungen mit Matrizen ausgelegt ist. Daher rührt auch der Name MATrix LABoratory. Programmiert wird unter MATLAB in einer proprietären, plattformunabhängigen Programmiersprache, die auf dem jeweiligen Rechner interpretiert wird. Zuerst werden einige Variablen nach den in Fig. 25 und Fig. 26 ermittelten Grenzwerten initialisiert. Dann werden die Prädiktorkoeffizienten über die Autokorrelation und dem Levinson-Durbin Algorithmus ermittelt. Den Kern des Algorithmus bilden zwei verschachtelte for-Schleifen. Die äußere Schleife läuft über die Prädiktorordung p. Die innere Schleife läuft über den Quantisierungsparameter g. Innerhalb der inneren Schleife findet die Quantisierung der Koeffizienten, die Berechnung des Restsignals und eine Entropiekodierung des Restsignals statt. Statt einer kompletten Entropiekodierung des Restsignals wäre auch eine möglicherweise schneller auszuführende Schätzung des Bitverbrauchs denkbar. Letztlich sichert man sich die Variante mit dem niedrigsten Bitverbrauch. Es folgt ein Ausführungsbeispiel eines MATLAB-Codes:

```
Ipc(data, bitsPerSample)
% initialisiere bestBits mit maximalen Wert
   bestBits = INT_MAX;
% Grenzen der Prädiktorordnung
   max_lpc_order = 16;
   min_lpc_order = 1;
% Grenzen der Quantisierungsgenauigkeit
   min_quant_precision = 5;
   max_quant_precision = 15;
% berechne Autokorrelation
   autoc = CalcAutocorr(data, max_Ipc_order);
% ermittle Koeffizienten für sämtliche relevanten
% Ordnungen mit dem Levinson-Durbin Algorithmus
   coeffs = CalcCoeff(autoc. max_lpc_order);
% finde die beste Ordnung p
   for p = min_lpc_order:1:max_lpc_order
% finde den besten Quantisierungsparameter g
      for g = min_quant_precision:1:max_quant_precision
% quantisiere die Koeffizienten
         [qcoeffs, s] = QuantCoeffs(coeffs, p, g);
% berechne Restsignal (eigentliche Prädiktion)
         [residual, warmup] = CalcResidual(data, p, s, qcoeffs);
% Entropiekodierung des Restsignals
         bitsResidual = EntropyCoding(residual);
% nötige Bits fur die Koeffizienten
         bitsQCoeffs = g * p;
% nötige Bits fur das Warmup
         bitsWarmup = bitsPerSample * p;
% ermittle Gesamtbitverbrauch
         bitsTotal = bitsResidual + bitsQCoeffs + bitsWarmup;
% speichere beste Variante
         if (bitsTotal < bestBits)
            bestOrder = p;
            bestWarmup = warmup;
            bestQuantScal = s;
```

```
                bestPrecision = g;
                bestQCoeffs = qcoeffs;
                bestResidual = residual;
                bestBits = bitsTotal;
            end
        end
    end
  end
```

Hier soll untersucht werden, ob der oben beschriebene FIR Prädiktor mit festen und ganzahligen Koeffizienten (Fixed Predictor) gewinnbringend erweitert werden kann. Aus obigem Abschnitt wissen wir, daß eine optimale Ordnung p im Bereich von 1<p<16 liegt. Der Fixed Predictor verwendet in Robinson, Tony: SHORTEN: Simple lossless and nearlossless waveform compression; Technical report CUED/FINFENG/TR.156, Cambridge University Engineering Department, December 1994, eine maximale Ordnung von p = 3. In Hans, Mat; Schafer, Ronald W.: Lossless Compression of Digital Audio, IEEE Signal Processing Magazine, July 2001, S. 30 ist die Übertragungsfunktion des Fixed Predictor

$$H(z) = \left(1 - z^{-1}\right)^{p}.$$

und der Betragsfrequenzgang

$$\left|H\left(e^{j\omega T}\right)\right| = \left|2 \cdot \sin(\omega T / 2)\right|^{p}$$

angegeben. T bezeichnet hier die Abtastrate und $\omega = 2\pi f$. Die übertragungsfunktion ist eine mathematische Beschreibung des Verhaltens eines linearen, zeitinvarianten System, welches einen Eingang und einen Ausgang besitzt. Durch den Frequenzgang wird das Verhalten eines linearen zeitinvarianten Systems beschrieben, wobei die Ausgangsgröße mit der Eingangsgröße verglichen und in Abhängigkeit von der Frequenz aufgezeichnet wird. Unter Zuhilfenahme von obiger Gleichung werden zwei weitere Ordnungen p=4 und p=5 entworfen:

$$\hat{x}_0(n) \;=\; 0$$

$$\hat{x}_1(n) \;=\; x(n-1)$$

$$\hat{x}_2(n) \;=\; 2x(n-1) - x(n-2)$$

$$\hat{x}_3(n) \;=\; 3x(n-1) - 3x(n-2) + x(n-3)$$

$$\hat{x}_4(n) \;=\; 4x(n-1) - 6x(n-2) + 4x(n-3) - x(n-4)$$

$$\hat{x}_5(n) \;=\; 5x(n-1) - 10x(n-2) + 10x(n-3) - 5x(n-4) + x(n-5)$$

Die entsprechenden Restsignale ergeben sich durch folgende Gleichung und die Bildung des Warmup geschieht äquivalent zu obigem Abschnitt:

$$e_0(n) \;=\; x(n)$$

$$e_1(n) \;=\; e_0(n) - e_0(n-1)$$

$$e_2(n) \;=\; e_1(n) - e_1(n-1)$$

$$e_3(n) \;=\; e_2(n) - e_2(n-1)$$

$$e_4(n) \;=\; e_3(n) - e_3(n-1)$$

$$e_5(n) \;=\; e_4(n) - e_4(n-1)$$

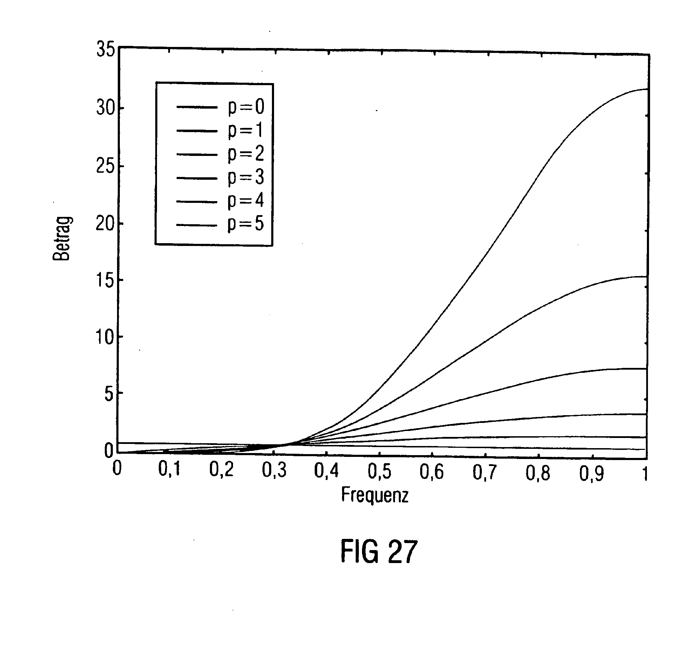

Fig. 27 zeigt eine Illustration eines Betragsfrequenzgangs eines Fixed Predictors in Abhängigkeit von dessen Ordnung p. Deutlich wird die Wirkung der verschiedenen Prädiktorordnungen anhand einer Betrachtung ihres Frequenzgangs (siehe Fig. 27). Bei einer Ordnung von p=0 entspricht das Restsignal dem Eingangssignal. Dadurch ergibt sich ein Betragsfrequenzgang von konstant 1. Eine Erhöhung der Ordnung führt einerseits zu einer stärkeren Dämpfung der tieffrequenten Signalanteile, andererseits aber zu einer Anhebung der hochfrequenten Signalanteile. Die Frequenzachse wurde für die Darstellung zur halben Abtastfrequenz normalisiert, wodurch sich bei der halben Abtastfrequenz (hier 22.05 kHz) die 1 ergibt.

Eine Untersuchung soll nun zeigen ob durch die Hinzunahme von p=4 und p=5 ein Kodiergewinn erzielt werden kann. Dazu werden verschiedene Musikstücke untersucht und pro Block die Ordnung ausgewählt, welche die wenigsten Bits benötigt.

In folgender Tabelle ist dargestellt wie oft welche Ordnung als die Beste, aufsummiert über die gesamte Audiodatei, selektiert wurde. Für die Erstellung dieser Tabelle wurde eine konstante Blocklänge von 1024 Zeitwerten genommen.

| Stück Nr. | p = 0 | p = 1 | p = 2 | p = 3 | p = 4 | p = 5 | Gesamtblockanzahl |
|-----------|-------|-------|-------|-------|-------|-------|-------------------|
| 1 | 0 | 14 | 316 | 67 | 57 | 0 | 454 |
| 4 | 15 | 69 | 161 | 79 | 0 | 0 | 324 |
| 6 | 5 | 173 | 115 | 27 | 0 | 0 | 320 |
| 7 | 3 | 74 | 189 | 43 | 0 | 0 | 309 |
| 8 | 0 | 221 | 959 | 0 | 0 | 0 | 1180 |
| 14 | 2 | 30 | 279 | 158 | 4 | 0 | 473 |
| 15 | 0 | 0 | 0 | 0 | 0 | 216 | 216 |

Aus obiger Tabelle ist ersichtlich, daß es keine Prädiktorordnung gibt, die in allen Fällen optimal ist. Deshalb ist es sinnvoll, die beste Ordnung für jeden Block erneut zu bestimmen. Am häufigsten werden die Ordnungen p=2, p=3 und p=1 selektiert. Weniger häufig werden die Ordnungen p=0 und p=4 verwendet. Bei Stück Nummer 1 wird durch die Erweiterung des Fixed Predictor um p=4 ein Kodiergewinn erzielt. Die Ordnung p=5 bringt nur bei Stück 15 einen Kodiergewinn. Da es sich bei Stück Nummer 15 um kein "gewöhnliches" Musiksignal handelt, sondern um einen 1kHz Sinus, ist der Nutzen von p=5 fraglich. Zudem deutet dies auch darauf hin, dass p>5 in aller Regel keinen großen Kodiergewinn mehr bringt und lediglich die Komplexität erhöht. Wie in obigem Abschnitt, sollen die eben gewonnen Erkenntnisse genutzt werden, um einen Algorithmus (siehe fixed()) anzugeben. Zuerst werden die maximale und minimale Ordnung festgelegt. Dann folgt eine for-Schleife, welche über alle Ordnungen läuft. Innerhalb dieser Schleife wird das Restsignal mit dem entsprechenden Bitverbrauch und die Kosten für das Warmup in Abhängigkeit von der Ordnung ermittelt. Letztlich wird die beste Variante gewählt.

```
fixed(data, bitsPerSample)
% initialisiere bestBits mit maximalen Wert
    bestBits = INT_MAX;
```

```
% Grenzen der Prädiktorordnung
   max_fixed_order = 5;
   min_fixed_order = 0:
   for p = min_fixed_order:1:max_fixed_order
% berechne Restsignal (eigentliche Prädiktion)
         [residual, warmup] = CalcResidual(data, p);
% Entropiekodierung des Restsignals
         bitsResidual = EntropyCoding(residual);
% nötige Bits für das Warmup,
         bitsWarmup = bitsPerSample * p;
% ermittle Gesamtbitverbrauch
         bitsTotal = bitsResidual + bitsWarmup;
% speichere beste Variante
         if (bitsTotal < bestBits)
            bestOrder = p;
            bestWarmup = warmup;
            bestResidual = residual;
            bestBits = bitsTotal;
         end
   end
end
```

Bei der Differenzkodierung wird, wie der Name sagt, nicht der eigentliche Wert, sondern die Differenz aufeinanderfolgender Werte kodiert. Sind die Differenzen kleiner als die ursprünglichen Werte kann eine höhere Kompression erreicht werden. Der in obigem Abschnitt beschriebene Fixed Predictor verwendet für p=1 eine Differenzkodierung.

Definition (Differenzkodierung): Sei $i \in N$ mit $1<i<n<oo$ und $x_i \in Z$, dann ist die Differenzkodierung definiert als:

$$\delta(x) = \begin{cases} x_i & falls\ i = 1 \\ x_{i-1} - x_i & sonst \end{cases} .$$

Die Differenzkodierung ist invertierbar.

Definition (Inverse Differenzkodierung): Sei $i \in N$ mit $1<i<n<oo$ und $x_1 \in Z$, dann ist die Inverse Differenzkodierung definiert als:

$$\delta^{-1}(x) = \begin{cases} x_1 & falls\ i = 1 \\ x_{i-1} - \delta(x_i) & sonst \end{cases} .$$

Wie bei den Prädiktoren wird das Warmup (ein Zeitwert bei i=1) von der Entropiekodierung ausgeschlossen. $\delta$ hat die Eigenschaft, dass bei absteigend sortierten Zeitwerten das Restsignal komplett in $N_0$ liegt. Dadurch lässt sich eine nachfolgende Entropiekodierung einfacher gestalten. Eine Differenzkodierung arbeitet dann optimal, wenn die zu kodierenden Werte sehr nahe beieinander liegen, also stark korreliert sind. Durch die Sortierung der Zeitwerte werden die Zeitwerte in eine starke Korrelation gebracht. Fig. 12 zeigte bereits die Auswirkung einer Differenzkodierung angewandt auf sortierte Zeitwerte. Deutlich ist der übereinstimmende Wert von sortiertem und dekorreliertem Zeitsignal bei Index 1 (Warmup) zu erkennen. Weiterhin ist der wesentlich kleinere Dynamikumfang des Restsignals der Differenzkodierung gegenüber den sortierten Zeitwerten auffallend. Detaillierte Angaben zu Fig. 12 sind der folgenden Tabelle angegeben. Die Differenzkodierung stellt also ein einfaches und effizientes Verfahren dar, um sortierte Zeitwerte zu kodieren.

| Stück Nr. 2 | max. Wert (ohne Warmup) | min. Wert | Warmup |
|---|---|---|---|
| Sortierte Zeitwerte | 32425 | -32768 | 32767 |
| Restsignal $\delta$ | 2630 | 0 | 32767 |

In den folgenden beiden Abschnitten werden Methoden entwickelt, wie man Permutationen effektiv kodieren kann. Legt man eine gedächtnisfreie Betrachtung einer Permutation zugrunde, dann ist die Entropie einer beliebigen Permutation σ mit |σ|<oo durch folgende Gleichung gegeben. Auf die gedächtnisbehaftete Betrachtung einer Permutation soll hier bewusst verzichtet werden, da eine gedächtnisfreie Betrachtung die einfachste Art der Kodierung einer Permutation darstellt

$$H(\sigma) = \log_2\big(|\sigma|\big) \ .$$

H(σ) beschreibt dann die nötige Anzahl von Bit/Zeichen für Binärkodierung eines σ(i). Um z.B. eine Permutation der Länge 256 darzustellen, benötigt man pro Element 8 Bit. Dies ist darin begründet, dass das Auftreten der Elemente der Permutation gleichwahrscheinlich ist. Die bei der Kodierung eines Audiosignals (z.B. 16 Bit Auflösung) durch Sortierung der Zeitwerte entstehende Permutation würde in diesem Beispiel allein die Hälfte der Eingangsdatenrate benötigen. Da dieses Datenvolumen bereits relativ hoch ist, stellt sich folgende Frage: Können Permutationen mit weniger als $\log_2(|\sigma|)$ Bit pro Element binär kodiert werden?

In obigem Abschnitt wurde gezeigt, dass man von der Permutationsdarstellung in eine äquivalente Inversionstafeldarstellung und zurück wechseln kann. Es soll deshalb untersucht werden, ob eine Binärdarstellung der Inversionstafel eine kleinere Datenrate benötigt als die der Permutation. Ein Beispiel soll Aufschluss darüber geben.

Beispiel: Gegeben sind folgende Permutationen

$$\sigma = \begin{pmatrix} 1 & 2 & 3 & 4 \\ 4 & 2 & 1 & 3 \end{pmatrix}, \pi = \begin{pmatrix} 1 & 2 & 3 & 4 \\ 4 & 3 & 2 & 1 \end{pmatrix}$$

Wird von σ und n die Inversionstafel gebildet, so ergibt sich I(σ) = (2110), I(n) = (3210). Es gilt

$$H\big(I(\sigma)\big) = 1.5 \ Bit < 2 \ Bit = H\big(\sigma\big) \ .$$

D.h. die Entropie der Inversionstafel ist tatsächlich kleiner als die der Permutation. Aber für π ergibt sich

$$H\big(I(\pi)\big) = 2 \ Bit = H\big(\pi\big) \ .$$

Im Falle von n ist also die Entropie der Inversionstafel genauso groß wie die der Permutation. Aber betrachtet man π in umgekehrter Folge, d.h. π(4), π(3), π(2), π(1) erhält man die identische Permutation und deren Inversionstafel hat eine sehr kleine Entropie. In jedem Falle gilt für eine beliebige Permutation σ mit |σ|<oo:

$$H\big(I(\sigma)\big) \le H\big(\sigma\big) \ .$$

Es sollen nun weitere Inversionstafelbildungsvorschriften definiert werden, um dem im obigen Beispiel beschriebenen Problem mit n entgegenzuwirken. Zunächst soll der Vollständigkeit halber nochmal die in obigem Abschnitt beschriebene Inversionstafelbildungsvorschrift (im folgenden Inversionstafel LB) erwähnt werden.

Definition (LB = Left Bigger): Sei σ ∈ $S_n$ eine Permutation und $b_j$ mit $j$=1,2,...,n die Anzahl der Elemente links von $j$ die größer als $j$ sind. Dann stellt $I_{lb}(\sigma)=(b_1b_2...b_n)$ die Inversionstafel LB von σ dar.

Definition (LS = Left Smaller): Sei σ ∈ $S_n$ eine Permutation und $b_j$ mit $j$=1, 2,..., n die Anzahl der Elemente links von j die kleiner als j sind. Dann stellt $I_{ls}(\sigma)=(b_1b_2...b_n)$ die Inversionstafel LB von σ dar.

Definition (RB = Right Bigger): Sei σ ∈ $S_n$ eine Permutation und $b_j$ mit $j$=1, 2, ..., n die Anzahl der Elemente rechts von $j$ die größer als $j$ sind. Dann stellt $I_{rb}(\sigma)=(b_1b_2...b_n)$ die Inversionstafel LB von σ dar.

Definition (RS = Right Smaller): Sei σ ∈ $S_n$ eine Permutation und $b_j$ mit $j$=1, 2, ..., n die Anzahl der Elemente rechts von j die kleiner als j sind. Dann stellt $I_{rs}(\sigma)=(b_1 b_2 ... b_n)$ die Inversionstafel LB von σ dar.

Beispiel: Stellvertretend sei hier ein Beispiel für die Bildung einer Inversionstafel RS und die entsprechende Generierung der Permutation gezeigt,

$$\sigma = \begin{pmatrix} 1 & 2 & 3 & 4 \\ 4 & 2 & 1 & 3 \end{pmatrix}.$$

Zuerst nimmt man das Element der Permutation mit σ*(i)=1* und zählt die Elemente rechts von σ*(i)=1* in σ die kleiner als die 1 sind. Hier ist dies kein Element. Dann nimmt man das Element der Permutation mit σ*(i)=2* und zählt die kleineren Elemente rechts von σ*(i)=1* in σ. Hier ist kein Element rechts neben σ*(i)=2* kleiner als die 2. Verfährt man genauso bis |σ| weiter, ergibt sich letztlich $I_{rs}(\sigma)=(b_1,...,b_4)=(0023)$. Aus einer Inversionstafel RS läßt sich bei schrittweisem Vorgehen j=1,2,...|σ| die entsprechende Permutation wieder generieren. Dafür geht man umgekehrt vor und fügt *j* so ein, dass $b_j$ Elemente rechts davon kleiner *j* sind.

$$b1 = 0 \qquad 1$$

$$b2 = 0 \qquad 1\,2$$

$$b3 = 2 \qquad 3\,1\,2$$

$$b4 = 3 \qquad 4\,3\,1\,2$$

Bildet man von σ die Inversionstafeln LB, LS und RB erhält man

$$I_{lb}(\sigma) = (2210)$$

$$I_{ls}(\sigma) = (0100)$$

$$I_{lb}(\sigma) = (1000)$$

Ein Vergleich der Entropien der Inversionstafeln von oben zeigt, dass deren Entropien teilweise erhebliche Unterschiede aufweisen und hier in allen Fällen kleiner der Entropie der Permutation (2 Bit) sind.

$$H(I_{lb}(\sigma)) = 1.5 Bit < 2 Bit = H(\sigma)$$

$$H(I_{ls}(\sigma)) \approx 0.81 Bit < 2 Bit = H(\sigma)$$

$$H(I_{rb}(\sigma)) \approx 0.81 Bit < 2 Bit = H(\sigma)$$

$$H(I_{rs}(\sigma)) \quad = \quad 1.5Bit \quad < 2Bit = H(\sigma)$$

ARNAVUT, Ziya: Permutation Techniques in Lossless Compression. Nebraska, University, Computer Science, Dissertation, 1995, S. 58-78 hat in seiner Dissertation mehrere verschiedene Methoden für die Bildung von Inversionstafeln benutzt. Er verwendete allerdings andere Bildungsvorschriften für die Inversionstafeln. Dabei handelt es sich um die Lehmer Inversionstafeln. Ist im weiteren Verlauf die Rede von Inversionstafeln, so sind die nicht-Lehmer Inversionstafeln gemeint. Im Falle von Lehmer Inversionstafeln, wird explizit der Zusatz "Lehmer" mit angegeben. Diese sollen nun beschrieben und im weiteren Verlauf auch verwendet werden.

Definition (Lehmer Inversionstafel RS (Right Smaller)): Sei $\sigma \in S_n$ eine Permutation. Die Lehmer Inversionstafel RS $I_{rsl}(\sigma)=(b_1,b_2,...,b_n)$ ist dann definiert als

$$b_k = \left| \{ j : k < j \leq n \wedge \sigma(k) > \sigma(j) \} \right|$$

*für* $1 \leq k \leq n$

Der Zusatz rsl steht für "Right Smaller Lehmer". Entsprechendes gilt für folgenden Definitionen. Natürlich kann man aus der Lehmer Inversionstafel RS auch wieder die Permutation generieren. In ARNAVUT, Ziya: Permutation Techniques in Lossless Compression. Nebraska, University, Computer Science, Dissertation, 1995 auf S. 62-63 wurde dafür folgender Algorithmus angegeben. 1 stellt in dem Algorithmus eine verkettete Liste dar

*Algorithmus :* $I_{rsl}^{-1}(\sigma)$

    1. Setze i ← 1,1 ← (1,2,...,n)
    2. σ(i) ← 1(b$_i$ +1)
    3. 1 ← 1-1(b$_i$ +1) (entferne1(b$_i$ +1)von 1)
    4. i ← i+1, falls i > n stop, andernfalls gehe zu 2.

ARNAVUT, Ziya: Permutation Techniques in Lossless Compression. Nebraska, University, Computer Science, Dissertation, 1995 hat zwar in seiner Dissertation darauf hingewiesen, dass er mehrere Lehmer Inversionstafelbildungsvorschriften verwendet hat, allerdings wurden keine detaillierten Definitionen der übrigen drei Inversionstafelbildungsvorschriften (RBL, LSL und LBL) und entsprechende Algorithmen zur Rückgewinnung der Permutation angegeben. Deshalb sollen an dieser Stelle die entsprechenden Definitionen und Algorithmen angegeben werden.

Definition (Lehmer Inversionstafel RB). Sei $\sigma \in S_n$ eine Permutation. Die Lehmer Inversionstafel RB $I_{rbl}(\sigma)=(b_1,b_2,...,b_n)$ ist dann definiert als

$$b_k = \left| \{ j : k < j \leq n \wedge \sigma(k) < \sigma(j) \} \right|$$

*für* $1 \leq k \leq n$.

A*lg*orithmus: $I_{rbl}^{-1}(\sigma)$

    1. Setzte i←1,1←(n,n-1,...,1)
    2. σ(i)←1(b$_i$+1)
    3. 1←1-1(b$_i$+1) (entferne 1(b$_i$+1) von1)
    4. i ←i +1, falls i > n stop, andernfalls gehe zu 2.

Definition (Lehmer Inversionstafel LS). Sei $\sigma \in S_n$ eine Permutation. Die Lehmer Inversionstafel LS $I_{lsl}(\sigma)=(b_1, b_2,...,b_n)$ ist dann definiert als

$$b_k = \left| \left\{ j : j < k \leq n \wedge \sigma(k) > \sigma(j) \right\} \right|$$

für 1≤k≤n

Algorithmus : $I_{lsl}^{-1}(\sigma)$

1. Setzte i←n,1←(1,2,...,n)
2. σ-(i)←1(b$_i$+1)
3. 1←1-1(b$_i$+1) (entferne1(b$_i$+1) von 1)
4. i ←i-1, falls i > n stop, andernfalls gehe zu 2.

Definition (Lehmer Inversionstafel LB). Sei $\sigma \in S_n$ eine Permutation. Die Lehmer Inversionstafel LB $I_{lbl}(\sigma)=(b_1, b_2,...,b_n)$ ist dann definiert als

$$b_k = \left| \left\{ j : j < k \leq n \wedge \sigma(k) < \sigma(j) \right\} \right|$$

für 1≤k≤n .

Algorithmus: $I_{lbl}^{-1}(\sigma)$

1. Setzte i←n, 1←(n,n-1,...,1)
2. σ(i)←1(b$_i$+1)
3. 1←1-1(b$_i$+1) (entferne 1(b$_i$+1) von1)
4. i ←i-1, falls i > n stop, andernfalls gehe zu 2.

Beispiel: Auch hier soll beispielhaft für alle vier Lehmer Inversionstafeln die Konstruktion einer Lehmer Inversionstafel LB und die entsprechende Rückgewinnung der Permutation gezeigt werden. Gegeben sei

$$\sigma = \begin{pmatrix} 1 & 2 & 3 & 4 \\ 4 & 3 & 1 & 2 \end{pmatrix} \; .$$

Zuerst nimmt man das erste Element der Permutation σ(1) = 4 und zählt die Elemente links von σ(1) in σ die größer als die 4 sind. Hier sind dies 0 Elemente. Dann nimmt man das zweite Element der Permutation σ(2) = 3 und zählt die größeren Elemente links von σ(2) in σ. Hier ist 1 Element neben der σ(2) größer als die 3. Verfährt man genauso bis |σ| weiter, ergibt sich letztlich $I_{lbl}(\sigma)=(b_1,b_2,...,b_4)=(0122)$. Aus einer Lehmer Inversionstafel LB lässt sich die entsprechende Permutation durch Algorithmus $I_{lbl}^{-1}(\sigma)$ wieder generieren

| | | | | | |
|---|---|---|---|---|---|
| | | | | | $l = (4,3,2,1)$ |
| $b_4 = 2$ | | | | 2 | $l = (4,3,1)$ |
| $b_3 = 2$ | | | 1 | 2 | $l = (4,3)$ . |
| $b_2 = 1$ | | 3 | 1 | 2 | $l = (4)$ |
| $b_1 = 0$ | 4 | 3 | 2 | 1 | $l = \{ \}$ |

Bildet man von σ die Lehmer Inverionstafeln RSL, RBL und LSL erhält man

$$l_{rsl}(\sigma) = (3200)$$
$$l_{rbl}(\sigma) = (0010) \quad .$$
$$l_{lsl}(\sigma) = (0001)$$

Die gezeigte Eigenschaft der Elemente der Inversionstafel LB gilt auch für die Inversionsionstafeln RB, RBL und RSL. Für die Inversionstafeln LS, RS, LBL und LSL haben die Elemente hingegen folgende Eigenschaften

$$0 \leq b_j \leq j-1$$

($\forall j=1,2,...,n$).

Zwischen den Inversionstafeln und den Lehmer Inversionstafeln besteht folgender Zusammenhang bezüglich der Entropie

$$H(l_{lb}(\sigma)) = H(l_{lbl}(\sigma))$$
$$H(l_{ls}(\sigma)) = H(l_{lsl}(\sigma))$$
$$H(l_{rb}(\sigma)) = H(l_{rbl}(\sigma)) \quad .$$
$$H(l_{rs}(\sigma)) = H(l_{rsl}(\sigma))$$

Dies liegt daran, dass bei Bildung der jeweiligen Inversionstafel bzw. Lehmer Inversionstafel lediglich die Elemente in einer anderen Reihenfolge betrachtet werden.

Um eine Aussage darüber zu erhalten wie hoch die Datenrate ist, um eine Permutation zu kodieren, wird nun ein Maß für diesen Kodieraufwand definiert. Für dieses Maß werden die Entropien der verschiedenen Inversiontafeln bzw. Lehmer Inversionstafeln betrachtet.

Definition (Kodierbarkeitsmaß): Sei $\sigma$ eine Permutation mit $|\sigma|<\infty$ und $l_{lb}(\sigma)$, $l_{ts}(u)$, $l_{ls}(\sigma)$, $l_{rb}(\sigma)$ die entsprechenden Inversionstafeln bzw. $l_{lbl}(\sigma)$, $l_{lsl}(\sigma)$, $l_{rbl}(\sigma)$, $l_{rsl}(\sigma)$ die entsprechenden Lehmer Inversionstafeln, dann ist das Kodierbarkeitsmaß für Permutationen durch

$$C(\sigma) = min\left(H(l_{lsl}(\sigma)), H(l_{lbl}(\sigma)), H(l_{rsl}(\sigma)), H(l_{rbl}(\sigma))\right)$$
$$= min\left(H(l_{ls}(\sigma)), H(l_{lb}(\sigma)), H(l_{rs}(\sigma)), H(l_{rb}(\sigma))\right)$$

definiert.

Eine Signalisierung welche der 8 Inversionstafelbildungsvorschriften benutzt wurde kann mit 3 Bit erfolgen. Somit ist die Verwendung der besten Variante kostengünstiger gegenüber gewöhnlicher Binärkodierung der Permutation wenn folgende Ungleichung für $|\sigma|<\infty$ zutrifft:

$$3 < \left(H(\sigma) - C(\sigma)\right)\cdot|\sigma| \quad .$$

Durch experimentelle Untersuchungen wurde festgestellt, dass für $|\sigma|>1$ immer $H(\sigma)>C(\sigma)$ und infolgedessen diese Ungleichung ab $|\sigma|>4$ gilt. Damit ist auch die anfangs gestellte Frage, ob eine Permutation mit weniger als $\log_2(|\sigma|)$ kodiert werden kann, beantwortet. Aus Gründen der Messbarkeit ist man daran interessiert Permutationen Stück für Stück ausgehend von der identischen Permutation zu verwürfeln. Dazu kann man einen Algorithmus aus KNUTH, Donald E.: The Art of Computer Programming; Massachusetts: Addison Wesley, 1998 (Vol. 2, S. 145) verwenden. Algorithmus P (Shuffing):Sei $X_1$, $X_2$,...,$X_t$ eine Anzahl von t Zahlen die verwürfelt werden sollen.

P1 Initialisierung:Setze j ← t
P2. Generiere U: Generiere eine Zufallszahl U zwischen 0 und 1 (gleichverteilt)
P3. Vertauschung : Setze k ←⌊jU⌋+1. Vertausche $X_k$ ↔ $X_j$.
P4. Verkleinere j : Verkleinere j um 1. Falls j < 1 gehe zu P2.

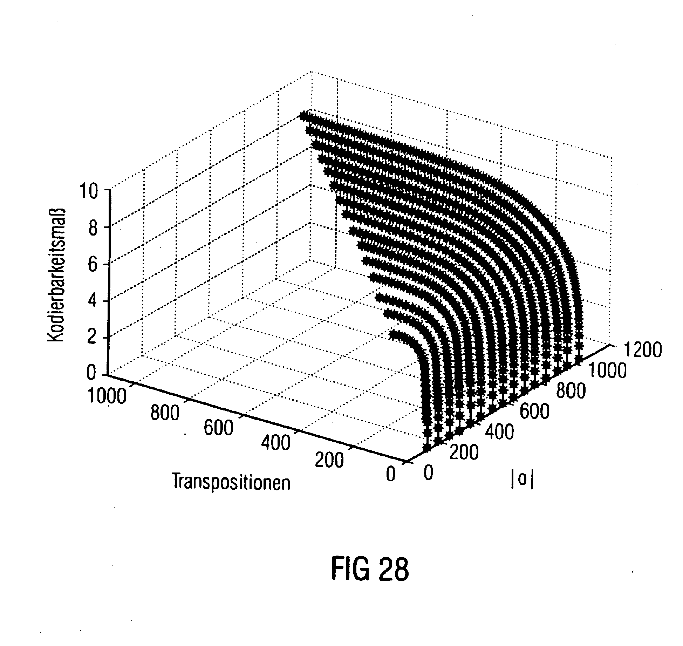

Nachteilig an dem Algorithmus ist die Wahl von U. Denn abhängig davon, welches U randomisiert gewählt wird, werden die t Zahlen in einem Transpositionsschritt manchmal etwas mehr bzw. manchmal etwas weniger verwürfelt. Wesentlich ist dabei aber die Eigenschaft, dass der Algorithmus schrittweise vorgeht und Stück für Stück die Verwürfelung einer ursprüngliche unverwürfelten Permutation (identische Permutation) erhöht. Aus Fig. 28 ist deutlich eine Eigenschaft zwischen Länge der Permutation, Anzahl der Transpositionen und des Kodierbarkeitsmaßes herauszulesen. Fig. 28 zeigt eine Illustration des Zusammenhangs von Permutationslänge |s|, Anzahl der Transpositionen und Kodierbarkeitsmaß. Ist die identische Permutation gegeben, dann ist das Kodierbarkeitsmaß gleich 0. Werden nur wenige Elemente der Permutation miteinander vertauscht, steigt das Kodierbarkeitsmaß sofort sehr stark an. Werden anschließend noch mehr Permutationselemente durch Transpositionen vertauscht, flacht die Kurve nach oben ab und läuft gegen die empirisch ermittelten Bitwerte aus folgender Tabelle

| $|\sigma|$ | 128 | 192 | 256 | 320 | 384 | 448 | 512 | 576 | 640 | 704 | 768 | 832 | 896 | 970 | 1024 |
|---|---|---|---|---|---|---|---|---|---|---|---|---|---|---|---|
| $H(\sigma)$ | 7.00 | 7.59 | 8.00 | 8.32 | 8.59 | 8.81 | 9.00 | 9.17 | 9.32 | 9.46 | 9.59 | 9.70 | 9.81 | 9.91 | 10.00 |
| $c(\sigma)$ | 5.72 | 6.35 | 6.73 | 7.08 | 7.33 | 7.53 | 7.74 | 7.90 | 8.07 | 8.19 | 8.32 | 8.43 | 8.53 | 8.65 | 8.74 |

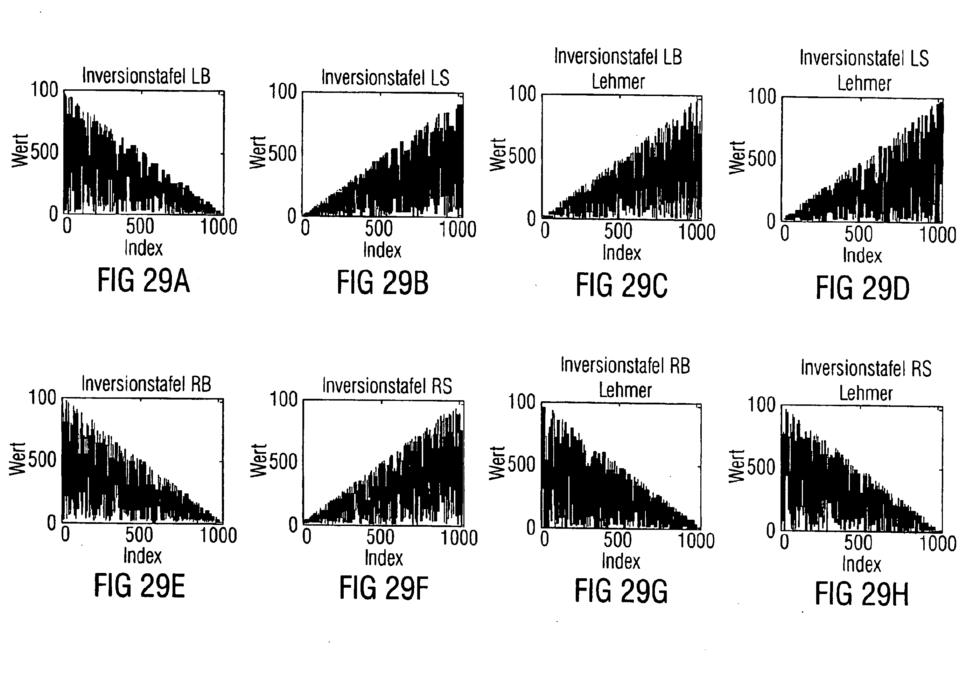

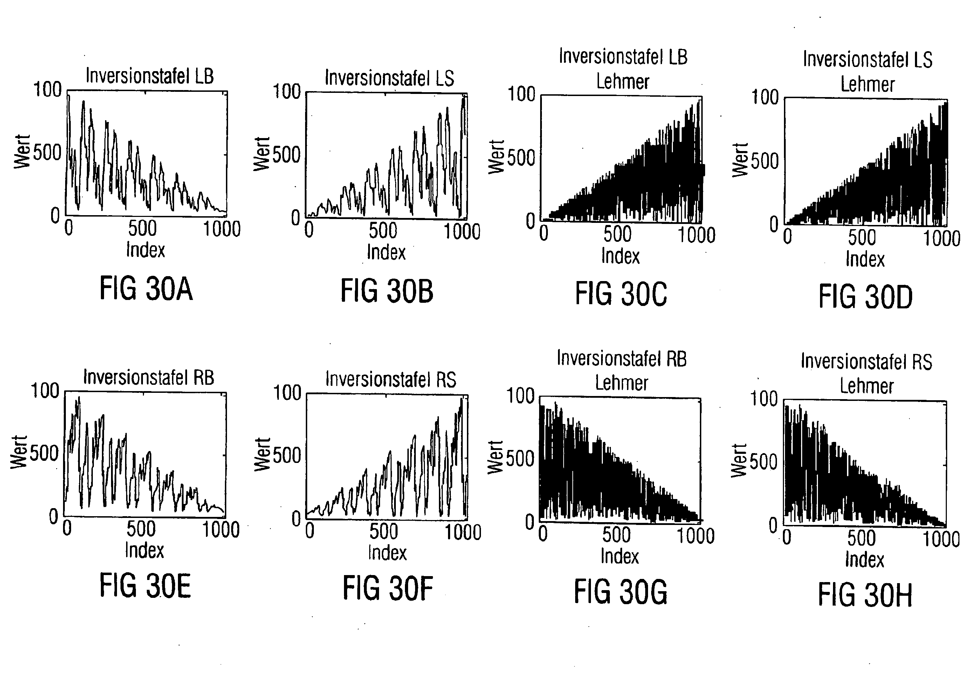

Nun soll gezeigt werden welche Form die Inversionstafeln und Lehmer Inversionstafeln einer Permutation, die durch die Sortierung der Zeitwerte entstanden ist, bei verschiedengearteter Musik haben. Dazu wird ein sehr tonales Stück und ein rauschartiges Stück verwendet. Fig. 29a-h zeigen eine Darstellung von Inversionstafeln im 10. Block (Frame) eines rauschartigen Stückes. Fig. 30a-h zeigen eine Darstellung von Inversionstafeln im 20. Block (Frame) eines tonalen Stückes. Es liegt eine Blockgröße von 1024 Zeitwerten zugrunde.

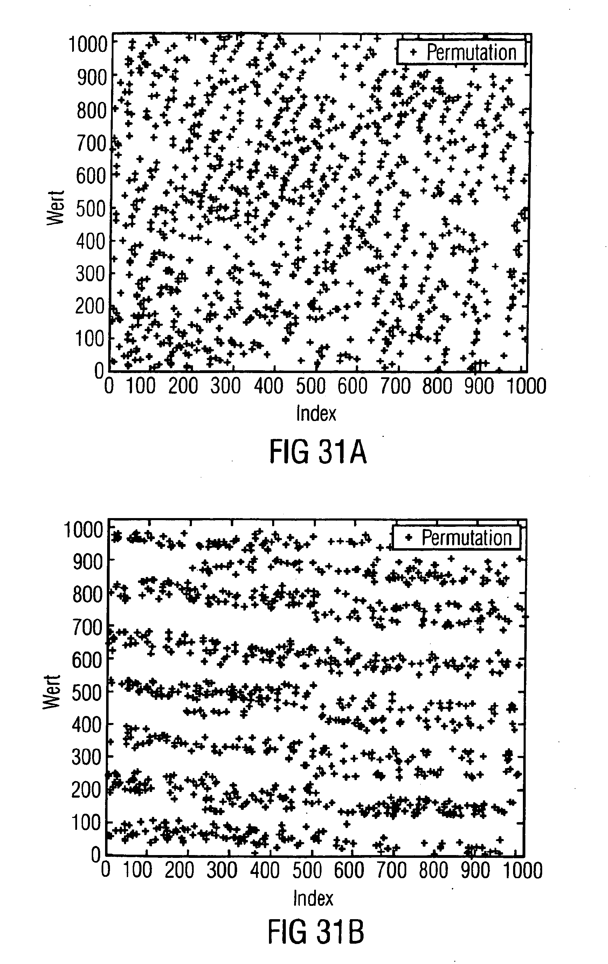

In den Fig. 29a-h und 30a-h ist zunächst die größer bzw. kleiner werdende dreieckige Kurvenform auffallend. Diese Kurvenform ist durch die zugrundeliegende Inversionstafelbildungsvorschrift und diese Gleichungen bedingt. Weiter fällt auf, dass die Lehmer Inversionstafeln sowohl beim rauschartigen Musikstück (siehe Fig. 29a-h) als auch beim tonalen Musikstück (siehe Fig. 30a-h) sehr unkorreliert sind. Wohingegen bei den Inversionstafeln zwischen dem tonalen Musikstück und dem rauschartigen Musikstück ein deutlicher Unterschied zu erkennen ist. Betrachtet man die zu den obigen Inversionstafeln und Lehmer Inversionstafeln gehörenden Permutationen, so ist auch dort die durch Sortierung des tonalen Musikstücks entstandene Permutation wesentlich korrelierter als die des rauschartigen Musikstückes (siehe Fig. 31a,b). Fig. 31a,b zeigen eine Darstellung von aus einer Sortierung von Zeitwerten enstandenen Permutation eines rauschartigen Stückes im 10. Block und eines tonalen Stückes.

Die rechte Permutation aus Fig. 31 erinnert an ein an der Hauptachse gespiegeltes Audiosignal. Es scheint so, dass ein direkter Zusammenhang zwischen Audiosignal, Rücksortiervorschrift und sogar auch noch der Inversionstafeln besteht.

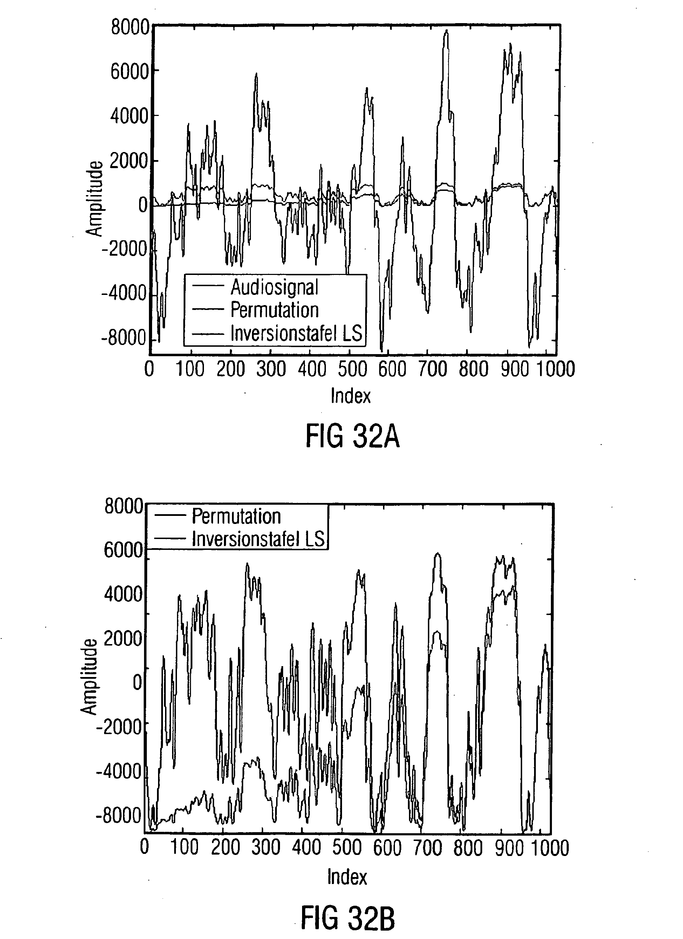

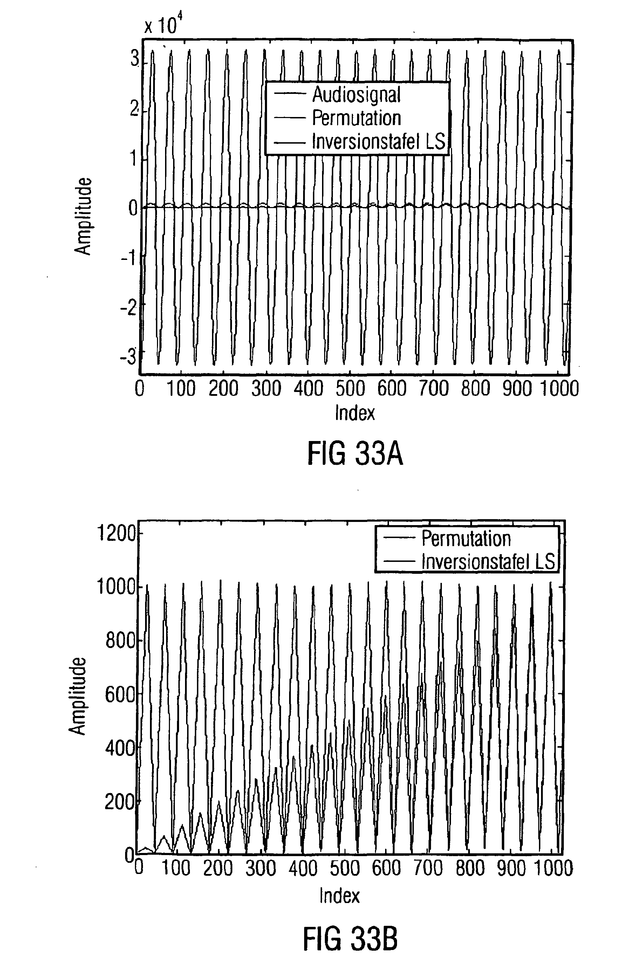

Die Fig. 32a,b und 33a,b zeigen das Audiosignal eines Blocks, die entsprechende Permutation bei welcher die x und y Koordinate vertauscht wurde und die entsprechende Inversionstafel LS. Fig. 32a zeigt einen Teil eines Audiosignals, die entsprechende Permutation und Inversionstafel LS, und Fig. 32b zeigt die Permutation und die Inversionstafel LS aus Fig. 32a vergrößert. Fig. 33a zeigt einen Teil eines Audiosignals, die entsprechende Permutation und Inversionstafel LS, und Fig. 33b zeigt die Permutation und die Innersionstafel LS aus Fig. 33a vergrößert.

Die Fig. 32a,b und 33a,b zeigen deutlich die Verbundenheit von ursprünglichem Audiosignal, Permutation und Inversionstafel. D.h. wird die Amplitude des ursprünglichen Signals größer, steigt auch die Amplitude von Permutation und Inversionstafel an bzw. umgekehrt. Sehr erwähnenswert sind auch die Amplitudenverhältnisse. Die maximale und minimale Amplitude der Permutation bleibt immer in einem beschränkten Rahmen von $\min(\sigma(i))=1$ bis $\max(\sigma(i))=|\sigma|$. Die Inversionstafel hat aufgrund der obigen Gleichungen sogar noch kleinere Amplitudenwerte von $\min(\sigma(i))-1$ bis $\max$ $(\sigma(i))-1$. Im Gegensatz dazu hat ein Audiosignal von 16 Bit einen maximalen Amplitudenumfang von $-\dfrac{2^{16}}{2}$ bis $\dfrac{2^{16}}{2}-1$. Das eben beobachtete Prinzip soll nun explizit hervorgehoben werden. Prinzip der Korrelationsübertragung:

Die Korrelation des Audiosignals spiegelt sich in aller Regel in der durch Sortierung entstandenen xy-vertauschten Permutation und der zur Permutation entsprechend gehörenden Inversionstafel wieder. Wegen des oben gezeigten Prinzips der Korrelationsübertragung bietet sich eine Prädiktion der Inversionstafeln zur Weiterverarbeitung an. Für die Prädiktion soll der beschriebene Fixed Predictor verwendet werden. Im Allgemeinen liefert eine Prädiktion der Lehmer Inversionstafeln kein gutes Ergebnis. In sehr seltenen Ausnahmefällen kommt es aber vor, dass das Restsignal der Prädiktion einer Lehmer Inversionstafel manchmal weniger Bits benötigt als das Restsignal der Inversionstafeln. Deshalb werden alle 8 Inversionstafelbildungvorschriften verwendet. Als vereinfachten MATLAB Code kann man dies wie in permCoding() darstellen.

```
permCoding(perm)
% erzeuge Inversionstafeln
    invLB = calcInvVecLB(perm);
    invLS = calcInvVecLS(perm);
    invRB = calcInvVecRB(perm);
  invRS = calcInvVecRS(perm);
% erzeuge Lehmer Inversionstafetn
    invLBL = calcInvVecLBLehmer(perm):
    invLSL = calcInvVecLSLehmer(perm);
    invRBL = calcInvVecRBLehmer(perm):
    invRSL = calcInvVecRSLehmer(perm);
% Präiktion der Inverstonstafeln
    restsignalLB = fixed(invLB);
    restsignalLS = fixed(invLS);
  restsignalRB = fixed(invRB);
  restsignalRS = fixed(invRS);
```

```
% Präiktion der Lehmer inversionstafeln
  restsignalLBL = fixed(invLBL);
  restsignalLSL = fixed(invLSL);
  restsignalRBL = fixed(invRBL);
  restsignalRSL = fixed(invRSL);
% ermittle Bitbedarf
  [bitsLB, bitsLS, bitsRB, bitsRS
  bitsLBL, bitsLSL, bitsRBL, bitsRSL] = getBitConsumption(restsignalLB,
                      restsignalLS,
                      restsignalRB,
                      restsignalRS,
                      restsignalLBL,
                      restsignalLSL,
                      restsignalRBL,
                      restsignalRSL);
% ermittle die bitsparenste Variante
  [bestInvVecBits,bestInvVecVersion] = min([bitsLB, bitsLS, bitsRB, bitsRS.
                      bitsLBL, bitsLSL, bitsRBL, bitsRSL]);
  end
```

Aus obigem Abschnitt ist bekannt, dass die Inversionstafeln immer eine Form haben die einem Dreieck gleicht. In seltenen Fällen kann es vorkommen, dass die Prädiktion der Inversionstafeln und Lehmer Inversionstafel ineffizient ist. Um diesem Problem zu begegnen, kann man nun die dreieckige Form der Inversionstafeln und Lehmer Inversionstafeln ausnutzen, um eine relative kostengünstige Binärkodierung im worst case Fall zu realisieren. Der worst case Fall tritt z.B. dann ein, wenn rauschartige oder transiente Audiosignale zu kodieren sind. Denn in diesen Fällen liefert eine Prädiktion der Inversionstafeln bzw. Lehmer Inversionstafeln manchmal keine guten Ergebnisse. Dazu werden abhängig von der jeweiligen Inversionstafelbildungsvorschrift immer soviel wie nötig aber sowenig wie möglich Bits für eine gewöhnliche Binärdarstellung der Elemente zugeteilt. Die entsprechenden dynamischen Bitzuteilungsfunktionen sind folgendermaßen definiert.

Definition (Dynamische Bitzuteilungsfunktion LS, RS, LBL, LSL). Sei $\sigma \in S_n$ eine Permutation und $b_j$ mit j=1,2,..., n die Elemente einer Inversionstafelbildungsvorschrift, dann ist die Dynamische Bitzuteilungsfunktion LS, RS, LBL, LSL definiert als

$$d(b_j) = \begin{cases} 1 & \text{Bit} \quad \text{für } j = 1 \\ \lfloor log_2(j-1) \rfloor + 1 & \text{Bit} \quad \text{sonst} \end{cases} .$$

Definition (Dynamische Bitzuteilungsfunktion LB, RB, RBL, RSL). Sei $\sigma \in S_n$ eine Permutation und $b_j$ mit j=1,2,...,n die Elemente einer Inversionstafelbildungsvorschrift, dann ist die Dynamische Bitzuteilungsfunktion LB, RB, RBL, RSL definiert als

$$d(b_j) = \begin{cases} 1 & \text{Bit} \quad \text{für } j = n \\ \lfloor log_2(n-j) \rfloor + 1 & \text{Bit} \quad \text{sonst} \end{cases} .$$

Die folgende Tabelle zeigt was dieser Kodieransatz leisten kann.

| $|\sigma|$ | dynamische Bitzuteilung | statische Bitzuteilung |
|---|---|---|
| 32 | 4.063 Bit | 5 Bit |
| 64 | 5.031 Bit | 6 Bit |
| 128 | 6.016 Bit | 7 Bit |
| 256 | 7.008 Bit | 8 Bit |

(fortgesetzt)

| $|\sigma|$ | dynamische Bitzuteilung | statische Bitzuteilung |
|---|---|---|
| 512 | 8.004 Bit | 9 Bit |
| 1024 | 9.002 Bit | 10 Bit |
| 2048 | 10.001 Bit | 11 Bit |

Durch eine über die Inversionstafeln bzw. Lehmer Inversionstafeln realisierte dynamische Bitzuteilung kann ungefähr 1Bit gegenüber einer gewöhnlichen Binärkodierung der Permutation pro Element eingespart werden. Dieser Kodieransatz stellt somit ein einfaches und gewinnbringendes Vorgehen für den worst case Fall dar.

In diesem Abschnitt soll untersucht werden, wie für die Restsignale der eben beschriebenen Dekorrelationsverfahren eine Entropiekodierung zu gestalten ist, um eine möglichst hohe Kompression zu erreichen. In ROBINSON, Tony: SHORTEN: Simple lossless and nearlossless waveform compression. Technical report CUED/FINFENG/TR.156, Cambridge University Engineering Department, December 1994, REZNIK, Y.: Coding of Prediction Residual in MPEG-4 Standard for Lossless Audio Coding (MPEG-4 ALS). IEEE Proc., ICASSP, 2004 und LIEBCHEN, Tilman; REZNIK, Yuriy; MORIYA, Takehiro; YANG, Dai Tracy: MPEG-4 Audio Lossless Coding. Berlin, Germany : 116th AES Convention, May 2004 wurde gezeigt, dass das Restsignal einer Prädiktion von Zeitwerten eine annähernde Laplaceverteilung aufweist. Dies gilt auch für das Restsignal einer Prädiktion der nicht Lehmer Inversionstafeln. Kausal dafür ist das in obigem Abschnitt beschriebene Prinzip der Korrelationsübertragung.

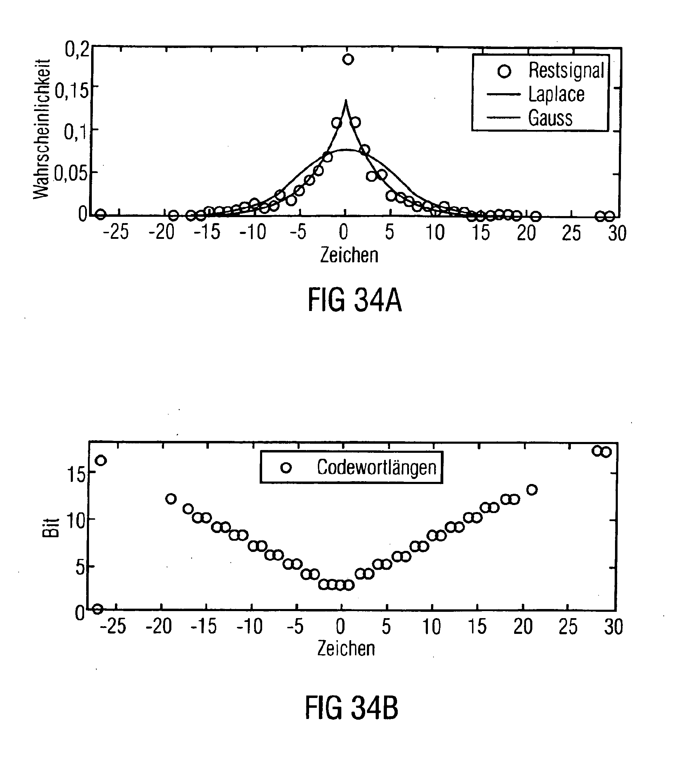

Fig. 34a zeigt eine Wahrscheinlichkeitsverteilung und Fig. 34b eine Länge der Codewörter eines durch Prädiktion (Fixed Predictor) entstandenen Restsignals einer Inversionstafel LB. Fig. 34a zeigt die Wahrscheinlichkeitsverteilung des Restsignals einer nicht Lehmer Inversionstafel LB, entstanden durch die Anwendung eines Fixed Predictors. Für die Bestimmung der Codewortlängen des Restsignals liegt eine vorwärts-adaptive Rice Kodierung mit einem Parameter von k=2 zugrunde. Deutlich ist zu erkennen, daß die Wahrscheinlichkeitsverteilung des Restsignals annähernd einer Laplaceverteilung entspricht. Im Falle einer Laplaceverteilung ist eine Golomb bzw. Rice Kodierung optimal als Entropiekodierverfahren geeignet (siehe GOLOMB, S. W.: Run-length encodings. IEEE Transactions on Information Theory, IT-12(3), pp. 399-401, July 1966, GALLAGER, Robert G.; VAN VOORHIS, David C.: Optimal Source Codes for Geometrically Distributed Integer Alphabets. IEEE Transactions on Information Theory, March 1975 und SALOMON, David: Data Compression. London : Springer-Verlag, Fourth Edition, 2007, SALOMON, David: Data Compression. London : Springer-Verlag, Fourth Edition, 2007.

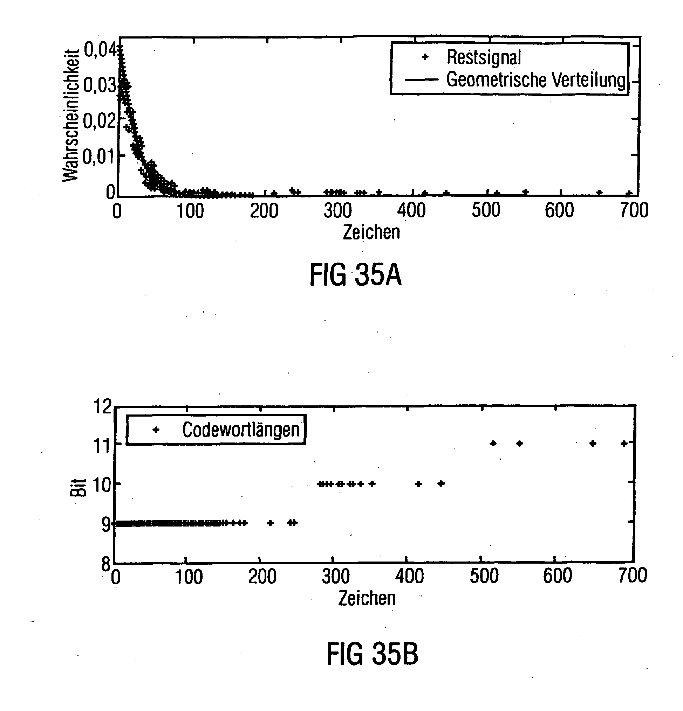

Letztlich ist noch die Wahrscheinlichkeitsverteilung des Restsignals der Differenzkodierung der sortierten Zeitwerte zu betrachten. Fig. 35a zeigt eine Wahrscheinlichkeitsverteilung und Fig. 35b eine Länge von Codewörtern eines durch Differenzkodierung entstandenen Restsignals sortierter Zeitwerte. In Fig. 35a ist deutlich zu erkennen, das das Restsignal eine annähernd geometrische Wahrscheinlichkeitsverteilung aufweist. Auch in diesem Fall ist eine Golomb bzw. Rice Kodierung sehr gut als Entropiekodierverfahren geeignet. Zur Darstellung der Codewortlängen wurde in Fig. 35b eine vorwärts-adaptive Rice Kodierung mit einem Parameter von k=8 verwendet.

Zusätzlich zu den speziellen Wahrscheinlichkeitsverteilungen haben die Restsignale die Eigenschaft, dass die Wertebereiche von Block zu Block teilweise erheblich schwanken und viele Werte des Wertebereichs gar nicht vorkommen. In Fig. 34 ist dies z.B. zwischen -25,...,-20 der Fall. Auch in Fig. 35 ist dies für Werte > 350 zu erkennen. Eine tabellarische Abspeicherung der Codes oder deren Übertragung als Seiteninformation, wie dies z.B. bei einer Huffman Kodierung der Fall wäre, ist deswegen ungeeignet. Da jeder Rice bzw. Golomb Code durch den Parameter k bzw. m eindeutig beschrieben wird, ist lediglich k bzw. m als Seiteninformation zu übertragen, wenn zwischen verschiedenen Rice bzw. Golomb Codes unterschieden werden soll. Mit dem Wissen, dass eine Rice bzw. Golomb Kodierung hervorragend für die in SOLO präsenten Restsignale geeignet ist, sollen nun verschiedene Varianten einer Rice, bzw. Golomb Kodierung entwickelt werden.

Essentiell ist dabei die Bestimmung des Rice Parameters k bzw. des Golomb Parameters m. Wählt man den Parameter zu groß, erhöht dies die Anzahl der nötigen Bits für die kleinen Zahlen. Wählt man den Parameter zu klein, steigt die nötige Anzahl der Bits für den unär kodierten Teil vor allem bei großen zu kodierenden Werten sehr stark an. Ein falsch gewählter Parameter kann somit die Datenrate des Entropiecodes deutlich vergrößern und damit die Kompression verschlechtern. Es gibt zwei Möglichkeiten eine Rice bzw. Golomb Kodierung zu gestalten:

1. vorwärts-adaptive Rice/Golomb Kodierung
2. rückwärts-adaptive Rice/Golomb Kodierung

Einige Methoden, um den Rice Parameter k vorwärts-adaptiv zu berechnen, wurden bereits aufgezeigt. Weitere Gegebenheiten der vorwärts-adaptiven Rice Parameterbestimmung sollen nun erläutert werden. Liegt ein Restsignal

e(i)$\in$ Z für i=1,2,...,n vor, dann wird zunächst eine Abbildung M(e(i)) von Z nach $N_0$ vorgenommen. Liegt das Restsignal bereits komplett in $N_0$, wie dies bei dem Restsignal der Differenzkodierung der sortierten Zeitwerte der Fall ist, dann entfällt diese Abbildung. Die Abbildung von Z nach No wird für e(i) E Z im folgenden vorausgesetzt. Somit ergibt sich folgende Gleichung

$$\mu = \begin{cases} \dfrac{1}{n}\sum_{i=1}^{n} M(e(i)) & \text{für} \quad e(i) \in Z \\ \dfrac{1}{n}\sum_{i=1}^{n} e(i) & \text{für} \quad e(i) \in N_0 \end{cases}.$$

mit zwei unterschiedlichen Bildungsvorschriften für den arithmetischen Mittelwert.

Die einfachste Möglichkeit den Rice Parameter zu bestimmen ist, alle in Frage kommenden Rice Parameter zu testen und den Parameter mit dem niedrigsten Bitverbrauch zu wählen. Dies ist nicht sehr komplex, weil der Wertebereich der zu testenden Rice Parameter durch die Bitauflösung des Zeitsignals beschränkt wird. Bei einer Auflösung von 16Bit sind maximal 16 Rice Parameter zu verifizieren. Der entsprechende Bitbedarf pro Parameter kann letztlich anhand weniger Bitoperationen bzw. arithmetischer Operationen bestimmt werden. Dieses Vorgehen den optimalen Rice Parameter zu finden ist etwas aufwendiger als die direkte Berechnung des Parameters, garantiert aber immer den optimalen Rice Parameter zu erhalten. In dem hier vorgestellen Verfahren zur verlustlosen Audiokodierung wird in den meisten Fällen diese Methode zur Bestimmung des Rice Parameters verwendet. Bei einer direkten Bestimmung des Rice Parameters kann man sich die in KIELY, A.: Selecting the Golomb Parameter in Rice Coding. IPN Progress Report, Vol. 42-159, November 2004 hergeleiteten Parametergrenzwerte

$$k_{min}(\mu) = max\left\{0, \left\lceil log_2\left(\frac{2}{3}(\mu+1)\right)\right\rceil\right\}$$

$$k_{max}(\mu) = max\left\{0, \left\lfloor log_2(\mu)\right\rfloor\right\}$$

zu Nutze machen. Dadurch wird der Bereich des optimalen Rice Parameters k auf

$$k_{max}(\mu) - k_{min}(\mu) \le 2 \qquad \forall \mu$$

beschränkt und man muss maximal 3 verschiedene Rice Parameter testen, um den optimalen Parameter bestimmen zu können. Liegt eine geometrische Wahrscheinlichkeitsverteilung vor, dann ergibt sich der optimale Rice Parameter durch folgende Gleichung

$$k_{geo} = max\left\{0, 1 + \left\lceil log_2\left(\frac{\ln(\phi-1)}{\ln\left(\frac{\mu}{\mu+1}\right)}\right)\right\rceil\right\}$$

wobei $\phi = (\sqrt{5}+1)/2$ ist, siehe KIELY, A.: Selecting the Golomb Parameter in Rice Coding. IPN Progress Report, Vol. 42-159, November 2004, S. 6.

Bei einer vorwärts-adaptiven Golomb Kodierung ist eine Parameterbestimmung anhand einer Suchmethode, wie dies bei der Rice Kodierung durchaus akzeptabel war, wesentlich komplexer. Dies liegt daran, dass die Golomb Kodierung deutlich mehr Zwischenabstufungen des Parameters m besitzt. Deshalb wird der Golomb Parameter errechnet

$$m = max\left\{1, \text{NINT}\left(-\frac{ln(1+\theta)}{ln(\theta)}\right)\right\},$$

vgl. Reznik, Y.: Coding of Prediction Residual in MPEG-4 Standard for Lossless Audio Coding (MPEG-4 ALS). IEEE Proc., ICASSP, 2004. Dabei wird θ durch

$$\theta = \frac{\sum_{i=1}^{n} e(i)}{n + \sum_{i=1}^{n} e(i)}$$

berechnet.

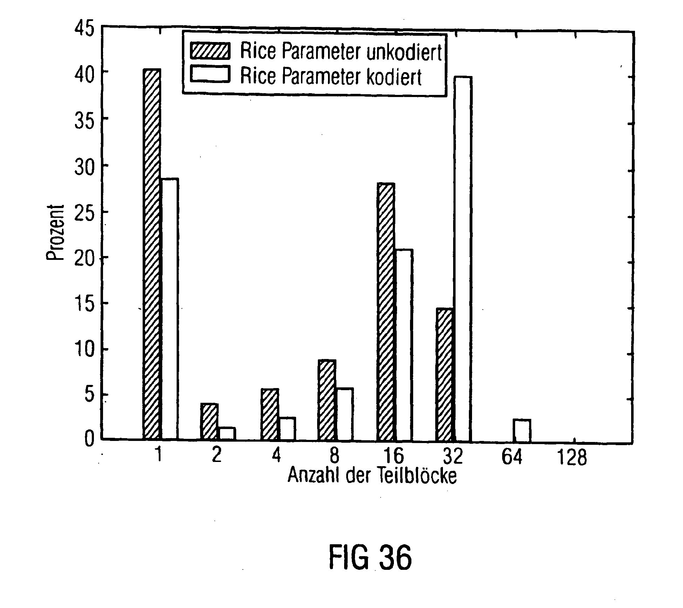

Bei einer vorwärts-adaptiven Rice/Golomb Kodierung besteht die Möglichkeit einen zu kodierenden Datenblock in mehrere Teilblöcke zu zerlegen und für jeden Teil-block einen eigenen Parameter zu bestimmen und zu übertragen. Mit zunehmender Anzahl von Teilblöcken steigt die nötige Seiteninformation für die Parameter. Die Effektivität der Teilblockzerlegung hängt stark davon ab, wie die zu übertragenden Parameter selbst kodiert werden. Da die Parameter aufeinanderfolgender Blöcke meist nicht besonders stark variieren, bietet sich eine Differenzkodierung der Parameter mit anschließender vorwärts-adaptiver Rice Kodierung an. Summiert man nun die nötige Datenrate der entropiekodierten Teilblöcke einschließlich der dazugehörenden Parameterseiteninformation über den Gesamtblock auf, und zählt wie oft welche Teilblockzerlegung das kleinste Datenaufkommen benötigte, ergibt sich für den gesamten Kodierprozess von einem Stück Nr. 1 die Fig. 36. Fig. 36 zeigt einen prozentualen Anteil einer Teilblockzerlegung mit einem geringsten Datenaufkommen einer vorwärts-adaptiven Rice Kodierung über ein Restsignal eines Fixed Predictors eines Stückes einschließlich einer Seiteninformation für Parameter, die Gesamtblocklänge ist 1024 Zeitwerte groß.

| Anzahl Teilblöcke | 128 | 64 | 32 | 16 | 8 | 4 | 2 | 1 |
|---|---|---|---|---|---|---|---|---|
| Parameter unkodiert | 488 | 243 | 121 | 60 | 30 | 15 | 8 | 4 |
| Parameter kodiert | 304 | 153 | 80 | 44 | 25 | 16 | 10 | 6 |
| Summe der Teilblockdatenraten | 9748 | 9796 | 9833 | 9872 | 9911 | 9926 | 9938 | 9952 |

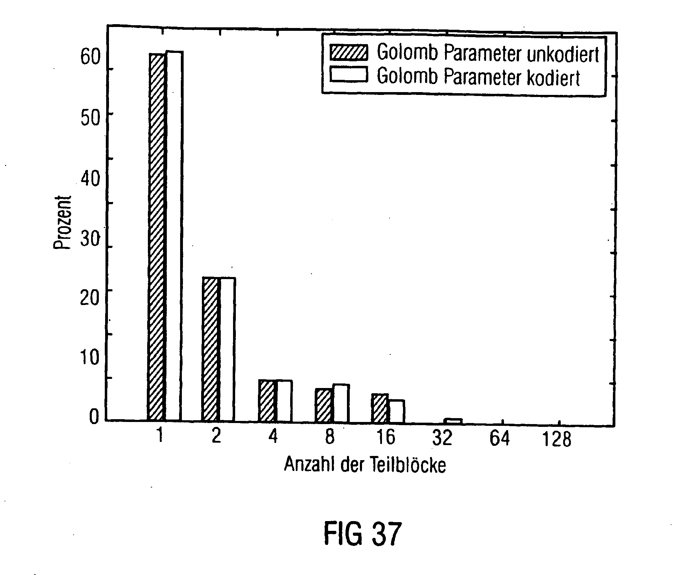

Bei unkodierten Rice Parametern ist eine Teilblockzerlegung meist nicht besonders gewinnbringend. Werden die Rice Parameter kodiert, dann ist häufig eine Zerlegung in 32 Teilblöcken besser als keine Teilblockzerlegung (vgl. auch folgende Tabelle). Bei einer vorwärts-adaptiven Golomb Kodierung ist eine Teilblockzerlegung sowohl für unkodierte Golomb Parameter, als auch für kodierte Golomb Parameter meist nicht vorteilhaft (siehe Fig. 37 und die folgende Tabelle). Fig. 37 zeigt einen prozentualen Anteil einer Teilblockzerlegung mit dem geringsten Datenaufkommen einer vorwärts-adaptiven Golomb Kodierung über das Restsignal eines Fixed Predictors eines Stückes einschließlich Seiteninformation für Parameter, die Gesamtblocklänge ist 1024 Zeitwerte groß. Allerdings bestände die Möglichkeit die Golomb Parameter vor ihrer Kodierung noch zu quantisieren, um dadurch deren nötige Datenrate zu verkleinern. Da aber bereits die Rice Parameter im Prinzip quantisierte Golomb Parameter darstellen, soll dies hier nicht weiter betrachtet werden.

| Anzahl Teilblöcke | 128 | 64 | 32 | 16 | 8 | 4 | 2 | 1 |
|---|---|---|---|---|---|---|---|---|
| Parameter unkodiert | 1242 | 603 | 293 | 142 | 69 | 34 | 17 | 9 |
| Parameter kodiert | 1123 | 552 | 278 | 139 | 68 | 36 | 19 | 11 |
| Summe der Teilblockdatenraten | 9752 | 9794 | 9827 | 9863 | 9899 | 9913 | 9924 | 9938 |

Aus den Fig. 36 und 37 ist ersichtlich, dass es keine in allen Fällen optimale Teilblockzerlegung gibt. Somit ergeben sich zwei Möglichkeiten:

1. Alle in Frage kommenden Teilblockzerlegungen zu testen und die mit der kleinsten Datenrate zu wählen.

2. Eine im Mittel gut geeignete Teilblockzerlegung für alle Fälle verwenden.

Da die 1. Möglichkeit die Komplexität des Systems bei geringfügig besserer Kompression stark erhöht, wird im weiteren Verlauf keine Teilblockzerlegung verwendet. Wie eine vorwärts-adaptive Rice bzw. Golomb Kodierung praktisch realisiert wird, ist in FwAdaptCoding() gezeigt. Zu Beginn findet für ein vorzeichenbehaftetes Restsignal eine Abbildung nach N0 statt. Damit wird dann der Rice/Golomb Parameter bestimmt und letztlich alle Zeichen mit diesem Parameter kodiert. Es folgt ein Beispielcode

```
FwAdaptCoding(data, signedData)
    if (signedData)
% Abbildung in die natürlichen Zahlen einschließlich der Null
        udata = Fold(data);
    else
        udata = data;
    end
% bestimme Parameter
    parameter = DetermineParameter(udata);
% laufe über alle zu kodierenden Daten
    for i=1:length(udata)
% kodiere einen Wert
        code(i) = EncodeValue(udata(i), parameter);
    end
end
```

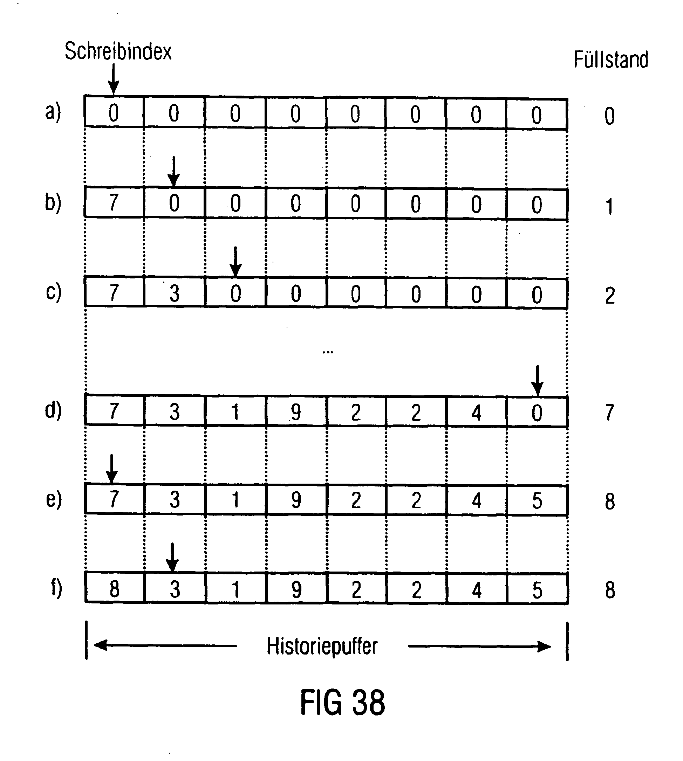

Eine rückwärts-adaptive Rice/Golomb Kodierung errechnet den Parameter aus vor-hergehenden bereits kodierten Zeichen. Dazu werden die eben kodierten Zeichen in einen History Buffer zyklisch eingetragen. Zu dem History Buffer gibt es zwei Variablen. Eine hält den aktuellen Füllstand des History Buffers fest und die andere Variable speichert die nächste Schreibposition. In Fig. 38 ist die prinzipielle Arbeitsweise des History Buffers der Größe 8 dargestellt. Zu Beginn wird der History Buffer mit Null initialisiert, der Füllstand ist Null und der Schreibindex ist eins (siehe a)). Dann wird ein Zeichen nach dem anderen in den History Buffer eingetragen und jeweils der Schreibindex (Pfeile) und der Füllstand aktualisiert (siehe b)-e)). Ist der History Buffer einmal komplett gefüllt, bleibt der Füllstand konstant (hier 8) und nur der Schreibindex wird angepasst (siehe e)-f)). Die Berechnung des rückwärts-adaptiven Rice Parameters geschieht folgendermaßen. Sei $e(i) \in N_0$ mit i=1,2,...,W die im History Buffer enthaltenen Restsignalwerte, W die Größe des History Buffers und F der aktuelle Füllstand, dann errechnet sich der rückwärts-adaptive Rice Parameter durch Gleichung

$$k = max\left\{1, NINT\left(\frac{\sum_{i=1}^{W} l(e(i)) + \left\lfloor \frac{F}{2} \right\rfloor}{F}\right)\right\},$$

wobei die Funktion $l(e(i))$ die nötige Anzahl der Bits für $e(i)$ ermittelt, also

$$l(e(i)) = \begin{cases} 1 & \text{falls } e(i) = 0 \\ \lfloor log_2(e(i)) \rfloor + 1 & \text{sonst} \end{cases}.$$

Die Berechnung des rückwärts-adaptiven Golomb Parameters geschieht durch Gleichung

$$m = max\left\{1, \text{NINT}\left(ln(2) \cdot \frac{\sum_{i=1}^{w} e(i)}{F} \cdot C\right)\right\}.$$

Durch empirische Versuche erwies sich C=1,15 als sinnvoll. Für die Größe des History Buffers wird im folgenden sowohl für die rückwärts-adaptive Rice Kodierung als auch für die rückwärts-adaptive Golomb Kodierung eine Größe von W=16 verwendet. Dies stellt einen guten Kompromiss zwischen einer zu trägen Adaption und einer zu abrupt reagierenden Adaption dar. Wie bei der rückwärts-adaptiven Arithmetischen Kodierung muss die bei der Dekodierung verwendete Adaption zur Enkodierung synchronisiert werden, ansonsten ist eine perfekte Rekonstruktion der Daten nicht möglich. In machen Fällen verursacht bei der Rückwärtsadaption der anfangs noch nicht komplett gefüllte History Buffer noch keine gute Vorhersage des Parameters. Deshalb wird eine Variante verwendet, welche für die ersten W Werte einen vorwärts-adaptiven Parameter berechnet, und erst wenn der History Buffer komplett gefüllt ist, werden aus diesem adaptive Parameter berechnet.

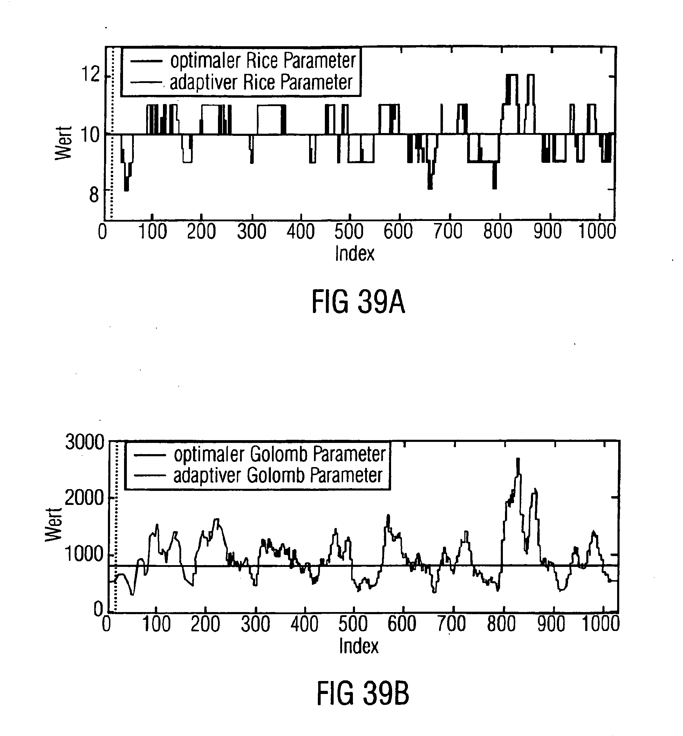

Wie die adaptive Parameterbestimmung arbeitet ist detailiert in Fig. 39a,b gezeigt. Fig. 39a,b zeigen eine Illustration zur Arbeitsweise einer Adaption verglichen mit einem optimalen Parameter für den Gesamtblock. Dabei stellen die helleren Linien den Grenzbereich dar, ab welchem die adaptiven Parameter verwendet werden. Vereinfacht läßt stich dieses eben beschriebene Vorgehen wie in BwAdaptivCoding() darstellen. Zuerst folgt im Falle von $e(i) \in Z$ wieder eine Abbildung nach $N_0$. Dann wird über die ersten W Werte (Größe des History Buffers) ein vorwärts-adaptiver Parameter bestimmt mit dem die ersten W Werte kodiert werden. Ist der History Buffer komplett gefüllt, werden die adaptiven Parameter für die weitere Kodierung verwendet. Es folgt ein Beispielcode

```
FwAdaptCoding(data, signedData)
    if(signedData)
% Abbildung in die nafürlichen Zahlen elnschlleßlich der Null
        udata = Fold(data);
    else
        udata = data;
    end
% bestimme Parameter
    parameter = DetermineParameter(udata);
% laufe uber alle zu kodierenden Daten
    for I=1:length(udata)
% kodiere einen Wert
        code(I) = EncodeVatue(udata(I), parameter):
    end
end
```

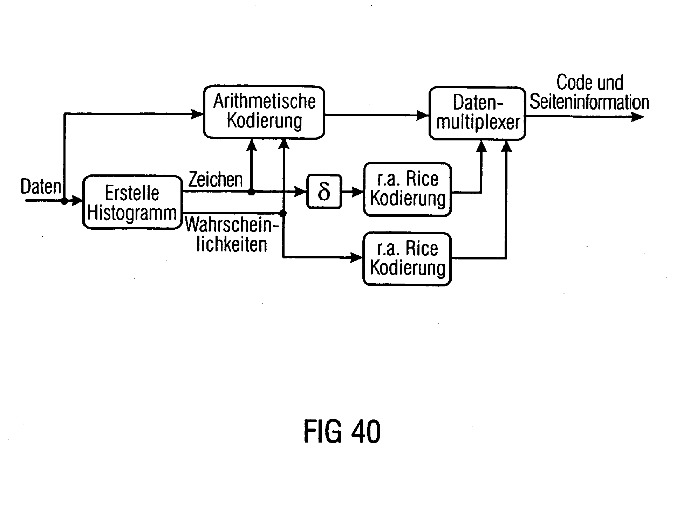

Um die Leistungsfähigkeit der eben entwickelten Rice/Golomb Entropiekodierverfahren umfangreicher beurteilen zu können, soll zusätzlich eine vorwärts-adaptive Arithmetische Kodierung unter Zuhilfenahme einer rückwärts-adaptiven Rice Kodierung entwickelt werden. Dazu wird zunächst ein Histogramm der zu kodieren-den Daten erstellt. Mit diesem Histogramm ist es möglich durch die Arithmetische Kodierung einen Code dicht an der Entropiegrenze zu erzeugen. Allerdings müssen zusätzlich die enthaltenen Zeichen und deren Auftrittswahrscheinlichkeiten übertragen werden. Da die Zeichen im Histogramm streng monoton steigend angeordnet sind, bietet sich hier vor einer rückwärts-adaptiven Rice Kodierung noch eine Differenzkodierung δ an. Die Wahrscheinlichkeiten werden lediglich rückwärts-adaptiv Rice kodiert. Letztlich ergeben sich die Gesamtkosten für dieses Vorgehen durch die Summe des Codes der Arithmetischen Kodierung, der Rice kodierten Zeichen und der Rice kodierten Wahrscheinlichkeiten (siehe Fig. 40). Fig. 40 zeigt ein Ausführungsbeispiel einer vorwärts-adaptiven arithmetische Kodierung unter Zuhilfenahme einer rückwärts-adaptiven Rice Kodierung.

Jetzt sollen die fünf verschiedenen Entropiekodierverfahren miteinander verglichen werden. Dazu werden Tabellen aller im Gesamtsystem vorhandenen Verfahren zur Restsignalsignalerzeugung erstellt und das Datenaufkommen gemittelt pro Block über das gesamte jeweilige Stück in Byte angegeben werden. Die folgende Tabelle zeigt einen Vergleich verschiedener Entropiekodierverfahren angewandt auf das Restsignal des LPC Prädiktors.

| Stück Nr. | Entropie summiert | v.a. Rice Kodierung | r.a. Rice Kodierung | v.a. Golomb Kodierung | r.a. Golomb Kodierung | v.a. Arith. Kodierung |
|---|---|---|---|---|---|---|
| 1 | 1117 | 1242 | 1252 | 1241 | 1239 | 1599 |
| 2 | 1249 | 1980 | 1998 | 1981 | 1984 | 2548 |
| 4 | 910 | 988 | 974 | 985 | 960 | 1201 |
| 13 | 1026 | 1096 | 1111 | 1095 | 1098 | 1350 |
| 14 | 1111 | 1278 | 1291 | 1276 | 1279 | 1668 |

Die folgende Tabelle zeigt einen Vergleich verschiedener Entropiekodierverfahren angewandt auf das Restsignal Vergleich verschiedener Entropiekodierverfahren angewandt auf das Restsignal des Fixed Predictors.

| Stock Nr. | Entropie summiert | v.a. Rice Kodierung | r.a. Rice Kodierung | v.a. Golomb Kodierung | r.a. Golomb Kodierung | v.a. Arith. Kodierung |
|---|---|---|---|---|---|---|
| 1 | 1100 | 1243 | 1246 | 1241 | 1233 | 1599 |
| 2 | 1249 | 1982 | 1999 | 1983 | 1986 | 2543 |
| 4 | 908 | 1001 | 978 | 995 | 964 | 1218 |
| 13 | 989 | 1050 | 1064 | 1049 | 1052 | 1276 |
| 14 | 1140 | 1370 | 1381 | 1367 | 1370 | 1797 |

Die folgende Tabelle zeigt einen Vergleich verschiedener Entropiekodierverfahren angewandt auf das Restsignal einer mit dem Fixed Predictor dekorrelierten nicht Lehmer Inversionstafel LB

| Stück Nr. | Entropie summiert | v.a. Rice Kodierung | r.a. Rice Kodierung | v.a. Golomb Kodierung | r.a. Golomb Kodierung | V.a. Arith. Kodierung |
|---|---|---|---|---|---|---|
| 1 | 674 | 705 | 677 | 698 | 665 | 780 |
| 2 | 1111 | 1241 | 1203 | 1237 | 1189 | 1603 |
| 4 | 683 | 767 | 764 | 755 | 721 | 833 |
| 13 | 659 | 687 | 670 | 680 | 656 | 754 |
| 14 | 856 | 922 | 907 | 914 | 883 | 1058 |

Die folgende Tabelle zeigt einen Vergleich verschiedener Entropiekodierverfahren angewandt auf das Restsignal der Differenzkodierung der sortierten Zeitwerte

| StÜck Nr. | Entropie summiert | v.a. Rice Kodierung | r.a. Rice Kodierung | v.a. Golomb Kodierung | r.a. Golomb Kodierung | v.a. Arith. Kodierung |
|---|---|---|---|---|---|---|
| 1 | 711 | 756 | 730 | 750 | 721 | 819 |
| 2 | 868 | 949 | 914 | 937 | 905 | 1051 |
| 4 | 471 | 547 | 487 | 528 | 476 | 540 |
| 13 | 610 | 660 | 624 | 653 | 615 | 694 |
| 14 | 605 | 678 | 622 | 665 | 613 | 697 |

Bildet man aus den obigen Tabellen die aufgerundeten arithmetischen Mittelwerte, so ergibt sich folgende Tabelle

| Entropie summiert | 903 |
|---|---|
| r.a. Golomb Kodierung | 1031 |
| r.a. Rice Kodierung | 1045 |
| v.a. Golomb Kodierung | 1052 |
| v.a. Rice Kodierung | 1058 |
| v.a. Arithmetische Kodierung | 1282 |

Für die abschließende Analyse der obigen Tabelle ist noch zu berücksichtigen, dass der Golomb Parameter eine etwas höhere Seiteninformationsdatenrate benötigt als der Rice Parameter. Trotzdem stellt die rückwärts-adaptive Golomb Kodierung im Mittel das beste Entropiekodierverfahren für die in SOLO vorhandenen Restsignale dar. In sehr seltenen Fällen kann es vorkommen, dass die Adaptionsstrategie fehlschlägt und keine guten Ergebnisse liefert. Deshalb kommt letztlich in SOLO eine Kombination aus einer rückwärts-adaptiven Golomb Kodierung und einer vorwärts-adaptiven Rice Kodierung zum Einsatz.

Um eine geeignete Blockgröße für ein Audiokodierverfahren festzulegen, sind immer folgende Gegebenheiten zu bedenken:

- Wählt man die Blocklänge zu klein, so werden im Verhältnis zu den reinen Kodierungsdaten relativ viel Daten für die Seiteninformationen benötigt

- Wählt man die Blocklänge zu groß, benötigt sowohl der Encoder als auch der Decoder große Datenstrukturen, um die zu bearbeitenden Daten im Speicher zu halten. Zudem stehen die ersten dekodierten Daten bei einer größeren Blocklänge auch erst später zur Verfügung als bei einer kleineren Blocklänge

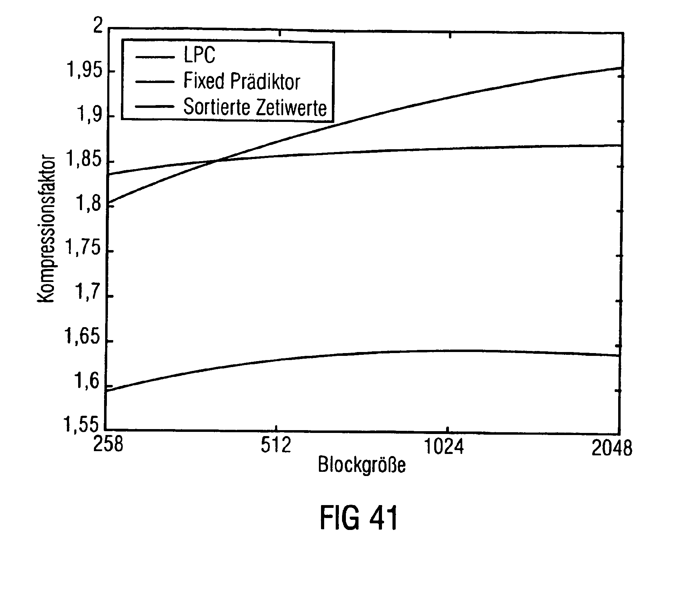

Im wesentlichen wird also die Blocklänge dadurch bestimmt welche Anforderungen an das Kodierverfahren gestellt werden. Steht der Kompressionsfaktor im Vordergrund, ist unter Umständen eine sehr große Blocklänge akzeptabel. Wird aber ein Kodierverfahren mit einer niedrigen Verzögerungszeit oder einem kleinen Speicherverbrauch gefordert, so ist eine sehr große Blocklänge sicher nicht brauchbar. Bereits bestehende Audiokodierverfahren verwenden üblicherweise Blocklängen von 128 bis 4608 Abtastwerten. Bei einer Abtastrate von 44.1 khz entspricht dies ca. 3 bis 104 Millisekunden. Eine Untersuchung soll Aufschluss darüber geben, wie sich die verschiedenen von SOLO verwendeten Dekorrelationsverfahren bei unterschiedlichen Blocklängen verhalten. Dazu werden verschiedene Stücke bei Blocklängen von 256, 512, 1024 und 2048 Abtastwerten enkodiert und der Kompressionsfaktor F unter Einbezug der jeweiligen Seiteninformationen ermittelt. Von den sieben Kompressionsfaktoren einer Blocklänge wird dann der arithmetische Mittelwert gebildet. In Fig. 41 ist das Ergebnis dieser Untersuchung dargestellt.

Fig. 41 zeigt eine Darstellung des Einflusses der Blockgröße auf den Kompressionsfaktor F. Deutlich ist zu erkennen, dass die Prädiktoren mit steigender Blocklänge einen besseren Kompressionsfaktor erzielen, wobei dies bei dem Fixed Predictor nicht so stark wie bei dem LPC Kodierverfahren ausgeprägt ist. Das nach dem Sorting Model arbeitende Dekorrelationsverfahren, hat ein Optimum bei einer Blocklänge von 1024 Abtastwerten. Da ein hoher Kompressionsfaktor bei einer möglichst kleinen Blocklänge erstrebenswert ist, wird im folgenden vorrangig eine Blocklänge von 1024 Abtastwerten verwendet. SOLO kann allerdings optional mit einer Blockänge von 256, 512 oder 2048 Abtastwerten betrieben werden.

In obigem Abschnitt wurde gezeigt, dass eine verlustlose Stereoredundanzreduktion realisiert werden kann. Eine Schwierigkeit dabei ist, dass der Mittenkanal M durch eine Division mit 2 mit anschließender Rundung zum nächstgelegenen ganzzahligen Wert bezüglich Null entstanden ist. Dadurch ist in manchen Fällen Information verloren gegangen. Dies ist z.B. bei L=5, R=4 der Fall. Wir gehen in diesem Beispiel davon aus, dass in jedem Kanal nur ein Wert vorhanden ist. In Wirklichkeit handelt es sich beim linken Kanal L oder beim rechten Kanal R natürlich um Vektoren.

Hier erhalten wir $M = NINT(\frac{L+R}{2}) = NINT(\frac{5+4}{2}) = NINT(4,5) = 4$. Diese Information ist aber noch im Seitenkanal S=L-R=5-4=1 enthalten. Eine verlustbehaftete Rundung von M hat immer dann stattgefunden, wenn S ungerade ist. Dies ist entsprechend bei der Dekodierung zu berücksichtigen. Diese eben beschriebene Möglichkeit der Korrektur des Mittenkanals läßt sich aber vermeiden wenn M aus R und S generiert wird

$$S = L - R$$

$$M = NINT\left(\frac{S}{2}\right) + R$$

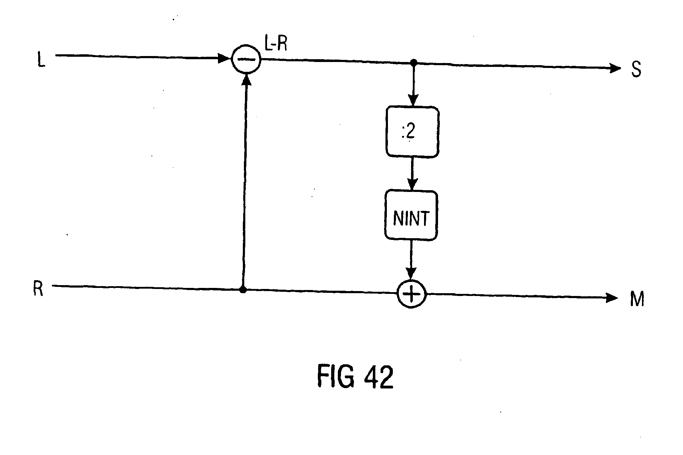

Grafisch lässt sich die Gleichung wie in Fig. 42 darstellen. Fig. 42 zeigt eine Darstellung zur verlustlosen MS-Enkodierung. Die MS-Dekodierung invertiert die Berechnungsvorschrift der MS-Enkodierung und generiert aus M und S wieder den rechten Kanal R und den linken Kanal L

$$R = M - NINT\left(\frac{S}{2}\right)$$

$$L = S + R$$

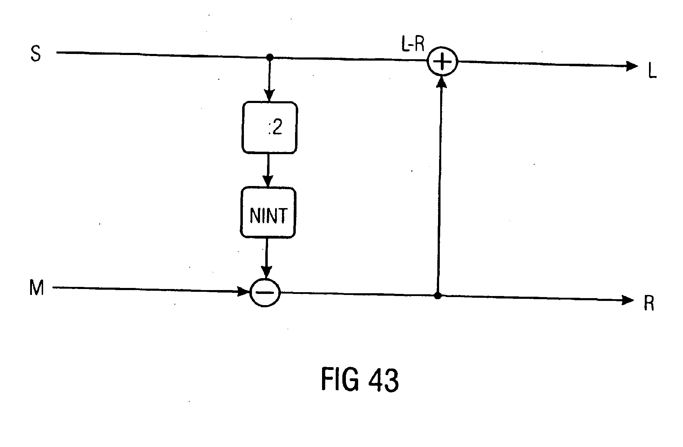

Eine grafische Darstellung der Gleichung ist in Fig. 43 gezeigt. Fig. 43 zeigt eine weitere Darstellung zur verlustlosen MS-Enkodierung.

Neben einer MS-Kodierung soll innerhalb von SOLO auch eine LS- und RS-Kodierung zur Stereoredundanzreduktion verwendet werden. Somit gibt es insgesamt vier Varianten für die Kodierung von Stereosignalen:

1. LR-Kodierung: keine Stereoredundanzreduktion
2. LS-Kodierung: linker Kanal und Seitenkanal
3. RS-Kodierung: rechter Kanal und Seitenkanal
4. MS-Kodierung: Mittenkanal und Seitenkanal

Wie soll man aber entscheiden welche Kodierung am besten ist? Eine Möglichkeit wäre es ein Kriterium zu entwickeln, welches die Variante mit dem kleinsten Datenaufkommen auswählt bevor man die Dekorrelation und Entropiekodierung des jeweiligen Kanals durchführt. Diese Möglichkeit benötigt deutlich weniger Speicher und ist auch nur halb so rechenkomplex als die im folgenden beschriebene Vorgehensweise. Allerdings hängt die Güte dabei maßgeblich von dem Entscheidungskriterium ab. Man könnte dafür die Entropie (Gleichung 2.3) verwenden. Versuche haben allerdings gezeigt, dass die Entropie hierfür kein zuverlässiges Entscheidungskriterium darstellt.

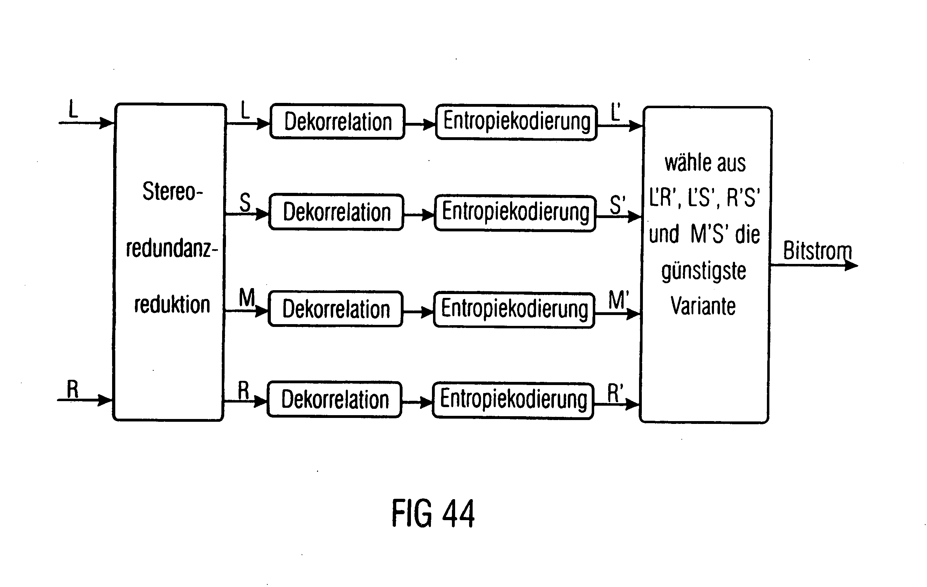

Eine andere Möglichkeit wäre es L, R, M und S komplett zu verarbeiten, und nach dem Bitverbrauch zu entscheiden welche Variante verwendet werden soll. Hier benötigt man mehr Speicher und Rechenzeit, kann aber mit Sicherheit immer die günstigste Variante selektieren. Im folgenden wird lediglich von der zweiten Möglichkeit Gebrauch gemacht (s. Fig. 44). Fig. 44 zeigt eine Illustration zur Auswahl einer besten Variante zur Stereoredundanzreduktion.

Eine Untersuchung soll nun zeigen was diese Vorgehensweise bei Stereosignalen leistet. In folgender Tabelle wird die gemittelte Entropie über das gesamte Stück der verschiedenen Varianten gegenübergestellt. Es wurde durchgehend eine Blocklänge von 1024 Zeitwerten pro Kanal benutzt. In der letzten Spalte (Beste Variante) ist die gemittelte Entropie des Vorgehens nach Fig. 44 dargestellt.

| StÜck Nr. | L | R | S | M | LR | LS | RS | MS | Beste Variante |
|---|---|---|---|---|---|---|---|---|---|
| 16(L=R) | 9.64 | 9.64 | 0 | 9.64 | 19.28 | 9.64 | 9.64 | 9.64 | 9.64 |
| 17 | 9.64 | 9.62 | 9.55 | 9.63 | 19.26 | 19.19 | 19.17 | 19.18 | 19.16 |
| 18 | 8.74 | 8.77 | 7.62 | 8.74 | 17.51 | 16.36 | 16.39 | 16.36 | 16.34 |
| 19 | 7.79 | 7.84 | 4.32 | 7.83 | 15.63 | 12.11 | 12.16 | 12.15 | 12.10 |
| 20 | 8.29 | 8.30 | 5.07 | 8.30 | 16.59 | 13.36 | 13.37 | 13.37 | 13.35 |
| 27 | 9.18 | 9.18 | 9.23 | 9.11 | 18.36 | 18.41 | 18.41 | 18.34 | 18.32 |
| 28 | 9.36 | 9.38 | 9.41 | 9.33 | 18.74 | 18.77 | 18.79 | 18.74 | 18.72 |

(fortgesetzt)

| StÜck Nr. | L | R | S | M | LR | LS | RS | MS | Beste Variante |
|---|---|---|---|---|---|---|---|---|---|
| 29 | 9.12 | 9.10 | 9.15 | 9.07 | 18.22 | 18.27 | 18.25 | 18.22 | 18.20 |

Am gewinnbringensten ist das Vorgehen nach Fig. 44 bei Stereosignalen mit identischen Kanälen. Bei stark monohaftigen Sprachstücken wie nützt die vorgestellte Stereoredundanzreduktion viel, wohingegen bei normalen Musikstücken wie 17, 27, 28 und 29 zwischen der LR-Kodierung und der Auswahl der besten Variante nur ein sehr geringer Kodiergewinn erzielt wird.

Insbesondere wird darauf hingewiesen, dass abhängig von den Gegebenheiten das erfindungsgemäße Konzept auch in Software implementiert sein kann. Die Implementierung kann auf einem digitalen Speichermedium insbesondere einer Diskette oder einer CD mit elektronisch auslesbaren Steuersignalen erfolgen, die so mit einem programmierbaren Computersystem und/oder Mikrocontroller zusammenwirken können, dass das entsprechende Verfahren ausgeführt wird. Allgemein besteht die Erfindung somit auch in einem Computerprogrammprodukt mit einem auf einem maschinenlesbaren Träger gespeichertem Programmcode zur Durchführung des erfindungsgemäßen Verfahrens, wenn das Computerprogrammprodukt auf einem Rechner und/oder Mikrocontroller abläuft. In anderen Worten ausgedrückt kann die Erfindung somit als ein Computerprogramm mit einem Programmcode zur Durchführung des Verfahrens realisiert werden, wenn das Computerprogramm auf einem Computer und/oder Mikrocontroller abläuft.

Bezugszeichenliste

100   Vorrichtung zum Kodieren
110   Einrichtung zum Sortieren
120   Einrichtung zum Kodieren

150   Vorrichtung zum Dekodieren
160   Einrichtung zum Empfangen
170   Einrichtung zum Dekodieren
180   Einrichtung zum Umsortieren

200   Vorrichtung zum Kodieren
210   Einrichtung zum Sortieren
220   Einrichtung zum Einstellen
230   Einrichtung zum Kodieren

250   Vorrichtung zum Dekodieren
260   Einrichtung zum Empfangen
270   Einrichtung zum Dekodieren
280   Einrichtung zum Approximieren
290   Einrichtung zum Umsortieren

400   Vorrichtung zum Kodieren
410   Einrichtung zum Sortieren
420   Einrichtung zum Kodieren

450   Vorrichtung zum Dekodieren
460   Einrichtung zum Empfangen
470   Einrichtung zum Dekodieren
480   Einrichtung zum Umsortieren

300   Vorrichtung zum Kodieren
310   Einrichtung zum Sortieren
320   Einrichtung zum Erzeugen
330   Einrichtung zum Kodieren

350 Vorrichtung zum Dekodieren
360 Einrichtung zum Empfangen
370 Einrichtung zum Prädizieren
380 Einrichtung zum Umsortieren

505 Audiosignal
510 Permutation
515 Inversionstafel

600 Kodierer
605 Vorverarbeitung
610 Sortierung
615 Verarbeitung/Kodierung der sortierten Daten
620 Entropiekodierung
625 Bitstrommultiplexer
630 Verarbeitung/Kodierung der sortierten Daten
635 Entropiekodierung

700 Dekodierer
705 Bitstromdemultiplexer
710 Entropiedekodierung
715 Dekodierung der sortierten Daten
720 Rücksortierung
725 Entropiedekodierung
730 Dekodierung der Permutation

800 Kodierer
805 Zeit-/Frequenztransformation
810 Sortierung
815 Curve Fitting
820 Permutationskodierung
825 Bitratenkontrolle
830 Entropiekodierer
835 Bitstromformatierer
840 Psychoakustisches Modell

900 Dekodierer
905 Bitstromdemultiplexer
910 Entropiedekodierer
915 Inverse Curve Fitting
920 Resorting
925 Permutationsdekodierer
930 Frequenz-/Zeittransformation

**Patentansprüche**

1. Vorrichtung (200) zum Kodieren einer Sequenz von Abtastwerten eines Informationssignals, das ein Audiosignal umfasst, wobei jeder Abtastwert innerhalb der Sequenz eine Ursprungsposition aufweist, mit folgenden Merkmalen:

   einer Einrichtung (210) zum Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist;
   einer Einrichtung (220) zum Einstellen von Funktionskoeffizienten einer Funktionsvorschrift zur Anpassung der Funktionsvorschrift an einen Teilbereich der sortierten Sequenz; und
   einer Einrichtung (230) zum Kodieren der Funktionskoeffizienten, der Abtastwerte außerhalb des Teilbereichs und einer Information über eine Beziehung zwischen den Ursprungs- und Sortierungspositionen der Abtastwerte.

**2.** Vorrichtung (200) gemäß Anspruch 1, die ferner eine Vorverarbeitungseinrichtung aufweist, die ausgebildet ist, um eine Filterung, eine Zeit-/FrequenzTransformation, eine Prädiktion oder eine Multikanalredundanzreduktion zur Erzeugung der Sequenz von Abtastwerten durchzuführen.

**3.** Vorrichtung (200) gemäß Anspruch 1 oder 2, bei der die Einrichtung (230) zum Kodieren ausgebildet ist, um die Information über die Beziehung zwischen den Ursprungs- und Sortierungspositionen als Indexpermutation zu kodieren.

**4.** Vorrichtung (200) gemäß einem der Ansprüche 1 bis 3, bei der die Einrichtung (230) zum Kodieren ausgebildet ist, um die Information über die Beziehung zwischen den Ursprungs- und Sortierungspositionen als Inversionstafel zu kodieren.

**5.** Vorrichtung (200) gemäß einem der Ansprüche 1 bis 4, bei der die Einrichtung (220) zum Kodieren ausgebildet ist, um die sortierten Abtastwerte, die Information über die Beziehung zwischen den Ursprungs- und Sortierungspositionen mit einer Differenz- und anschließender Entropiekodierung oder nur einer Entropiekodierung zu kodieren.

**6.** Vorrichtung (200) gemäß einem der Ansprüche 1 bis 5, bei der die Einrichtung (230) zum Kodieren ausgebildet ist, um basierend auf den Abtastwerten, einer Permutation oder einer Inversionstafel Koeffizienten eines Prädiktionsfilters zu bestimmen und zu kodieren.

**7.** Vorrichtung (200) gemäß Anspruch 6, bei der die Einrichtung (230) zum Kodieren ferner ausgebildet ist, um ein Restsignal, das einer Differenz zwischen den Abtastwerten und einem Ausgangssignal eines Prädiktionsfilters entspricht, zu kodieren.

**8.** Vorrichtung (200) gemäß Anspruch 7, bei der die Einrichtung (230) zum Kodieren ausgebildet ist, um das Restsignal mit einer Entropiekodierung zu kodieren.

**9.** Verfahren zum Kodieren einer Sequenz von Abtastwerten eines Informationssignals, das ein Audiosignal umfasst, wobei jeder Abtastwert innerhalb der Sequenz eine Ursprungsposition aufweist, mit folgenden Schritten:

Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist;
Einstellen von Funktionskoeffizienten einer Funktionsvorschrift zur Anpassung der Funktionsvorschrift an einen Teilbereich der sortierten Sequenz; und
Kodieren der Funktionskoeffizienten, der Abtastwerte außerhalb des Teilbereichs und einer Information über eine Beziehung zwischen den Ursprungs- und Sortierungspositionen der Abtastwerte.

**10.** Computerprogramm mit einem Programmcode zur Durchführung des Verfahrens gemäß Anspruch 9, wenn der Programmcode auf einem Computer ausgeführt wird.

**11.** Vorrichtung (250) zum Dekodieren einer Sequenz von Abtastwerten eines Informationssignals, das ein Audiosignal umfasst, wobei jeder Abtastwert innerhalb der Sequenz eine Ursprungsposition aufweist, mit folgenden Merkmalen:

einer Einrichtung (260) zum Empfangen von kodierten Funktionskoeffizienten, sortierten Abtastwerten und einer Information über eine Beziehung zwischen einer Sortierungsposition und der Ursprungsposition von Abtastwerten;
einer Einrichtung (270) zum Dekodieren von Abtastwerten;
einer Einrichtung (280) zum Approximieren von Abtastwerten basierend auf den Funktionskoeffizienten in einem Teilbereich der Sequenz; und
einer Einrichtung (290) zum Umsortieren der Abtastwerte und des Teilbereiches basierend auf der Information über die Beziehung zwischen den Ursprungs- und Sortierungspositionen, so dass jeder Abtastwert seine Ursprungsposition aufweist.

**12.** Vorrichtung (250) gemäß Anspruch 11, bei der die Einrichtung (260) zum Empfangen ausgebildet ist, um die Information über die Beziehung zwischen den Ursprungs- und Sortierungspositionen als Indexpermutation zu empfangen.

**13.** Vorrichtung (250) gemäß Anspruch 11 oder 12, bei der die Einrichtung (260) zum Empfangen ausgebildet ist, um die Information über die Beziehung zwischen den Ursprungs- und Sortierungspositionen als Inversionstafel zu empfangen.

**14.** Vorrichtung (250) gemäß einem der Ansprüche 11 bis 13, bei der die Einrichtung (270) ferner ausgebildet ist, um die Funktionskoeffizienten, die sortierten Abtastwerte oder die Information über die Beziehung zwischen den Ursprungs- und Sortierungspositionen mit einer Entropie- und anschließender Differenzdekodierung oder nur einer Entropiedekodierung zu dekodieren.

**15.** Vorrichtung (250) gemäß einem der Ansprüche 11 bis 14, bei die Einrichtung (260) zum Empfangen ausgebildet ist, um kodierte Koeffizienten eines Prädiktionsfilters zu empfangen und die Einrichtung (270) zum Dekodieren ausgebildet ist, um die kodierten Koeffizienten zu dekodieren, wobei die Vorrichtung (250) ferner eine Einrichtung zum Prädizieren von Abtastwerten basierend auf den Koeffizienten aufweist.

**16.** Vorrichtung (250) gemäß einem der Ansprüche 11 bis 15, bei der die Einrichtung (260) zum Empfangen ausgebildet ist, um ein Restsignal, das einer Differenz zwischen den Abtastwerten und einem Ausgangssignal des Prädiktionsfilters oder der Einrichtung (280) zum Approximieren entspricht, zu empfangen und die Einrichtung (270) zum Dekodieren ausgebildet ist, um basierend auf dem Restsignal die Abtastwerte anzupassen.

**17.** Vorrichtung (250) gemäß Anspruch 16, bei der die Einrichtung (270) zum Dekodieren ausgebildet ist, um das Restsignal mit einer Entropiedekodierung zu dekodieren.

**18.** Verfahren zum Dekodieren einer Sequenz von Abtastwerten eines Informationssignals, das ein Audiosignal umfasst, wobei jeder Abtastwert innerhalb der Sequenz eine Ursprungsposition aufweist, mit folgenden Schritten:

Empfangen von kodierten Funktionskoeffizienten, sortierten Abtastwerten und einer Information über eine Beziehung zwischen einer Sortierungsposition und der Ursprungsposition von Abtastwerten;
Dekodieren von Abtastwerten;
Approximieren von Abtastwerten basierend auf den Funktionskoeffizienten in einem Teilbereich der Sequenz; und
Umsortieren der Abtastwerte und des Teilbereiches basierend auf der Information über die Beziehung zwischen den Ursprungs- und Sortierungspositionen, so dass jeder Abtastwert seine Ursprungsposition aufweist.

**19.** Computerprogramm mit einem Programmcode zur Durchführung des Verfahrens gemäß Anspruch 18, wenn der Programmcode auf einem Computer ausgeführt wird.

**20.** Vorrichtung (300) zum Kodieren einer Sequenz von Abtastwerten eines Informationssignals, das ein Audiosignal umfasst, wobei jeder Abtastwert innerhalb der Sequenz eine Ursprungsposition aufweist, mit folgenden Merkmalen:

einer Einrichtung (310) zum Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist;
einer Einrichtung (320) zum Erzeugen einer Zahlenfolge abhängig von einer Beziehung zwischen den Ursprungs- und Sortierungspositionen der Abtastwerte und zum Bestimmen von Koeffizienten eines Prädiktionsfilters basierend auf der Zahlenfolge; und
einer Einrichtung (330) zum Kodieren der sortierten Abtastwerte und der Koeffizienten.

**21.** Vorrichtung (300) gemäß Anspruch 20, die ferner eine Vorverarbeitungseinrichtung aufweist, die ausgebildet ist, um eine Filterung, eine Zeit-/FrequenzTransformation, eine Prädiktion oder eine Multikanalredundanzreduktion zur Erzeugung der Sequenz von Abtastwerten durchzuführen.

**22.** Vorrichtung (300) gemäß Anspruch 20 oder 21, bei der die Einrichtung (320) zum Erzeugen der Zahlenfolge ausgebildet ist, um eine Indexpermutation zu erzeugen.

**23.** Vorrichtung (300) gemäß einem der Ansprüche 20 bis 22, bei der die Einrichtung (320) zum Erzeugen der Zahlenfolge ausgebildet ist, um eine Inversionstafel zu erzeugen.

**24.** Vorrichtung (300) gemäß einem der Ansprüche 20 bis 23, bei der die Einrichtung (320) zum Erzeugen der Zahlenfolge ausgebildet ist, um ferner ein Restsignal zu erzeugen, das einer Differenz zwischen der Zahlenfolge und einer auf der Basis der Koeffizienten prädizierten Prädiktionsfolge entspricht.

25. Vorrichtung (300) gemäß einem der Ansprüche 20 bis 24, bei der die Einrichtung (330) zum Kodieren angepasst ist, um die sortierten Abtastwerte oder die Koeffizienten gemäß einer Differenz- oder Entropiekodierung zu kodieren.

26. Vorrichtung (300) gemäß einem der Ansprüche 24 oder 25, bei der die Einrichtung (330) zum Kodieren ferner ausgebildet ist, um das Restsignal zu kodieren.

27. Verfahren zum Kodieren einer Sequenz von Abtastwerten eines Informationssignals, das ein Audiosignal umfasst, wobei jeder Abtastwert innerhalb der Sequenz eine Ursprungsposition aufweist, mit folgenden Schritten:

Sortieren der Abtastwerte nach ihrer Größe, um eine sortierte Sequenz von Abtastwerten zu erhalten, wobei jeder Abtastwert eine Sortierungsposition innerhalb der sortierten Sequenz aufweist;
Erzeugen einer Zahlenfolge abhängig von einer Beziehung zwischen den Ursprungs- und Sortierungspositionen der Abtastwerte und Bestimmen von Koeffizienten eines Prädiktionsfilters basierend auf der Zahlenfolge; und
Kodieren der sortierten Abtastwerte und der Koeffizienten.

28. Computerprogramm mit einem Programmcode zur Durchführung des Verfahrens gemäß Anspruch 27, wenn der Programmcode auf einem Computer ausgeführt wird.

29. Vorrichtung (350) zum Dekodieren einer Sequenz von Abtastwerten eines Informationssignals, das ein Audiosignal umfasst, wobei jeder Abtastwert innerhalb der Sequenz eine Ursprungsposition aufweist, mit folgenden Merkmalen:

einer Einrichtung (360) zum Empfangen von Koeffizienten eines Prädiktionsfilters und von einer Sequenz von Abtastwerten, wobei jeder Abtastwert eine Sortierungsposition aufweist;
einer Einrichtung (370) zum Prädizieren einer Zahlenfolge basierend auf den Koeffizienten; und
einer Einrichtung (380) zum Umsortieren der Sequenz von Abtastwerten basierend auf der Zahlenfolge, so dass jeder Abtastwert seine Ursprungsposition aufweist.

30. Vorrichtung (350) gemäß Anspruch 29, bei der die Einrichtung (370) zum Prädizieren der Zahlenfolge eine Indexpermutation als Zahlenfolge prädiziert.

31. Vorrichtung (350) gemäß Anspruch 29 oder 30, bei der die Einrichtung (370) zum Prädizieren der Zahlenfolge eine Inversionstafel als Zahlenfolge prädiziert.

32. Vorrichtung (350) gemäß einem der Ansprüche 29 bis 31, bei der die Einrichtung (360) zum Empfangen ferner ausgebildet ist, um ein kodiertes Restsignal zu empfangen und die Einrichtung (370) zum Prädizieren ausgebildet ist, um das Restsignal bei der Prädiktion der Zahlenfolge zu berücksichtigen.

33. Vorrichtung (350) gemäß einem der Ansprüche 29 bis 32, die ferner eine Einrichtung zum Dekodieren aufweist, die ausgebildet ist, um Abtastwerte, Restsignale oder Koeffizienten nach einer Differenz- oder Entropiekodierung zu dekodieren.

34. Verfahren zum Dekodieren einer Sequenz von Abtastwerten eines Informationssignals, das ein Audiosignal umfasst, wobei jeder Abtastwert innerhalb der Sequenz eine Ursprungsposition aufweist, mit folgenden Schritten:

Empfangen von Koeffizienten eines Prädiktionsfilters und von einer Sequenz von Abtastwerten, wobei jeder Abtastwert eine Sortierungsposition aufweist;
Prädizieren einer Zahlenfolge basierend auf den Koeffizienten; und
Umsortieren der Sequenz von Abtastwerten basierend auf der Zahlenfolge, so dass jeder Abtastwert seine Ursprungsposition aufweist.

35. Computerprogramm mit einem Programmcode zur Durchführung des Verfahrens gemäß Anspruch 34, wenn der Programmcode auf einem Computer ausgeführt wird.

**Claims**

1. Apparatus (200) for encoding a sequence of samples of an information signal including an audio signal, with each sample within the sequence comprising an original position, comprising:

a means (210) for sorting the samples depending on their sizes, in order to acquire a sorted sequence of samples, with each sample comprising a sorting position within the sorted sequence;
a means (220) for adjusting functional coefficients of a functional rule for adaptation of the functional rule to a partial range of the sorted sequence; and
a means (230) for encoding the functional coefficients, the samples outside the partial range and information on a relation between the original and sorting positions of the samples.

2.  Apparatus (200) according to claim 1, further comprising a preprocessing means formed to perform filtering, time/frequency transform, prediction or multi-channel redundancy reduction for generating the sequence of samples.

3.  Apparatus (200) according to claim 1 or 2, wherein the means (230) for encoding is formed to encode the information on the relation between the original and sorting positions as an index permutation.

4.  Apparatus (200) according to one of claims 1 to 3, wherein the means (230) for encoding is formed to encode the information on the relation between the original and sorting positions as an inversion chart.

5.  Apparatus (200) according to one of claims 1 to 4, wherein the means (220) for encoding is formed to encode the sorted samples, the information on the relation between the original and sorting positions with differential and ensuing entropy coding or only entropy coding.

6.  Apparatus (200) according to one of claims 1 to 5, wherein the means (230) for encoding is formed to determine and encode coefficients of a prediction filter on the basis of the samples, a permutation or an inversion chart.

7.  Apparatus (200) according to claim 6, wherein the means (230) for encoding is further formed to encode a residual signal corresponding to a difference between the samples and an output signal of a prediction filter.

8.  Apparatus (200) according to claim 7, wherein the means (230) for encoding is formed to encode the residual signal with entropy coding.

9.  Method of encoding a sequence of samples of an information signal including an audio signal, with each sample within the sequence comprising an original position, comprising:

    sorting the samples depending on their sizes, in order to acquire a sorted sequence of samples, with each sample comprising a sorting position within the sorted sequence;
    adjusting functional coefficients of a functional rule for adaptation of the functional rule to a partial range of the sorted sequence; and
    encoding the functional coefficients, the samples outside the partial range and information on a relation between the original and sorting positions of the samples.

10. Computer program with a program code for performing the method according to claim 9, when the program code is executed on a computer.

11. Apparatus (250) for decoding a sequence of samples of an information signal including an audio signal, with each sample within the sequence comprising an original position, comprising:

    a means (260) for receiving encoded functional coefficients, sorted samples and information on a relation between a sorting position and the original position of samples;
    a means (270) for decoding samples;
    a means (280) for approximating samples on the basis of functional coefficients in a partial range of the sequence; and
    a means (290) for re-sorting the samples and the partial range on the basis of the information on the relation between the original and sorting positions, so that each sample comprises its original position.

12. Apparatus (250) according to claim 11, wherein the means (260) for receiving is formed to receive the information on the relation between the original and sorting positions as an index permutation.

13. Apparatus (250) according to claim 11 or 12, wherein the means (260) for receiving is formed to receive the information on the relation between the original and sorting positions as an inversion chart.

14. Apparatus (250) according to one of claims 11 to 13, wherein the means (270) is further formed to decode the functional coefficients, the sorted samples or the information on the relation between the original and sorting positions with entropy and ensuing differential decoding or only entropy decoding.

15. Apparatus (250) according to one of claims 11 to 14, wherein the means (260) for receiving is formed to receive encoded coefficients of a prediction filter, and the means (270) for decoding is formed to decode the encoded coefficients, wherein the apparatus (250) further comprises a means for predicting samples on the basis of the coefficients.

16. Apparatus (250) according to one of claims 11 to 15, wherein the means (260) for receiving is formed to receive a residual signal which corresponds to a difference between the samples and an output signal of the prediction filter or the means (280) for approximating, and the means (270) for decoding is formed to adapt the samples on the basis of the residual signal.

17. Apparatus (250) according to claim 16, wherein the means (270) for decoding is formed to decode the residual signal with entropy decoding.

18. Method of decoding a sequence of samples of an information signal including an audio signal, with each sample within the sequence comprising an original position, comprising:

receiving encoded functional coefficients, sorted samples and information on a relation between a sorting position and the original position of samples;
decoding samples;
approximating samples on the basis of the functional coefficients in a partial range of the sequence; and
re-sorting the samples and the partial range on the basis of the information on the relation between the original and sorting positions, so that each sample comprises its original position.

19. Computer program with a program code for performing the method according to claim 18, when the program code is executed on a computer.

20. Apparatus (300) for encoding a sequence of samples of an information signal including an audio signal, with each sample within the sequence comprising an original position, comprising:

a means (310) for sorting the samples depending on their sizes, in order to acquire a sorted sequence of samples, with each sample comprising a sorting position within the sorted sequence;
a means (320) for generating a series of numbers depending on a relation between the original and sorting positions of the samples, and for determining coefficients of a prediction filter on the basis of the series of numbers; and
a means (330) for encoding the sorted samples and the coefficients.

21. Apparatus (300) according to claim 20, further comprising a preprocessing means formed to perform filtering, time/frequency transform, prediction or multi-channel redundancy reduction for generating the sequence of samples.

22. Apparatus (300) according to claim 20 or 21, wherein the means (320) for generating the series of numbers is formed to generate an index permutation.

23. Apparatus (300) according to one of claims 20 to 22, wherein the means (320) for generating the series of numbers is formed to generate an inversion chart.

24. Apparatus (300) according to one of claims 20 to 23, wherein the means (320) for generating the series of numbers is formed to further generate a residual signal corresponding to a difference between the series of numbers and a prediction series predicted on the basis of the coefficients.

25. Apparatus (300) according to one of claims 20 to 24, wherein the means (330) for encoding is formed to encode the sorted samples or the coefficients in accordance with differential or entropy coding.

26. Apparatus (300) according to claim 24 or 25, wherein the means (330) for encoding is further formed to encode the residual signal.

**27.** Method of encoding a sequence of samples of an information signal including an audio signal, with each sample within the sequence comprising an original position, comprising:

sorting the samples depending on their sizes, in order to acquire a sorted sequence of samples, with each sample comprising a sorting position within the sorted sequence;
generating a series of numbers depending on a relation between the original and sorting positions of the samples, and determining coefficients of a prediction filter on the basis of the series of numbers; and
encoding the sorted samples and the coefficients.

**28.** Computer program with a program code for performing the method according to claim 27, when the program code is executed on a computer.

**29.** Apparatus (350) for decoding a sequence of samples of an information signal including an audio signal, with each sample within the sequence comprising an original position, comprising:

a means (360) for receiving coefficients of a prediction filter and a sequence of samples, with each sample comprising a sorting position;
a means (370) for predicting a series of numbers on the basis of the coefficients; and
a means (380) for re-sorting the sequence of samples on the basis of the series of numbers, so that each sample comprises its original position.

**30.** Apparatus (350) according to claim 29, wherein the means (370) for predicting the series of numbers predicts an index permutation as the series of numbers.

**31.** Apparatus (350) according to claim 29 or 30, wherein the means (370) for predicting the series of numbers predicts an inversion chart as the series of numbers.

**32.** Apparatus (350) according to one of claims 29 to 31, wherein the means (360) for receiving is further formed to receive an encoded residual signal, and the means (370) for predicting is formed to take the residual signal into account in the prediction of the series of numbers.

**33.** Apparatus (350) according to one of claims 29 to 32, further comprising a means for decoding formed to decode samples, residual signals or coefficients in accordance with differential or entropy coding.

**34.** Method of decoding a sequence of samples of an information signal including an audio signal, with each sample within the sequence comprising an original position, comprising:

receiving coefficients of a prediction filter and a sequence of samples, with each sample comprising a sorting position;
predicting a series of numbers on the basis of the coefficients; and
re-sorting the sequence of samples on the basis of the series of numbers, so that each sample comprises its original position.

**35.** Computer program with a program code for performing the method according to claim 34, when the program code is executed on a computer.

**Revendications**

**1.** Dispositif (200) de codage d'une séquence de valeurs de balayage d'un signal d'informations qui comporte un signal audio, chaque valeur de balayage dans la séquence présentant une position d'origine, aux caractéristiques suivantes:

un moyen (210) destiné à trier les valeurs de balayage selon leur grandeur, pour obtenir une séquence triée de valeurs de balayage, chaque valeur de balayage présentant une position de triage dans la séquence triée;
un moyen (220) destiné à régler les coefficients de fonction d'une règle de fonction pour adapter la règle de fonction à une zone partielle de la séquence triée; et
un moyen (230) destiné à coder les coefficients de fonction, les valeurs de balayage en-dehors de la zone partielle et une information sur un rapport entre les positions d'origine et de triage des valeurs de balayage.

2. Dispositif (200) selon la revendication 1, qui présente par ailleurs un moyen de traitement réalisé pour effectuer une filtration, une transformation temps/fréquence, une prédiction ou une réduction de redondance multicanal pour générer la séquence de valeurs de balayage.

3. Dispositif (200) selon la revendication 1 ou 2, dans lequel le moyen (230) destiné à coder est réalisé pour coder l'information sur le rapport entre les positions d'origine et de triage comme permutation d'indice.

4. Dispositif (200) selon l'une des revendications 1 à 3, dans lequel le moyen (230) destiné à coder est réalisé pour coder l'information sur le rapport entre les positions d'origine et de triage comme tableau d'inversions.

5. Dispositif (200) selon l'une des revendications 1 à 4, dans lequel le moyen (220) destiné à coder est réalisé pour coder les valeurs de balayage triées, l'information sur le rapport entre les positions d'origine et de triage par un codage de différence et un codage entropique successif ou uniquement par un codage entropique.

6. Dispositif (200) selon l'une des revendications 1 à 5, dans lequel le moyen (230) destiné à coder est réalisé pour déterminer et coder, sur base des valeurs de balayage, d'une permutation ou d'un tableau d'inversions, les coefficients d'un filtre de prédiction.

7. Dispositif (200) selon la revendication 6, dans lequel le moyen (230) destiné à coder est par ailleurs réalisé pour coder un signal résiduel correspondant à une différence entre les valeurs de balayage et un signal de sortie d'un filtre de prédiction.

8. Dispositif (200) selon la revendication 7, dans lequel le moyen (230) destiné à coder est réalisé pour coder le signal résiduel par un codage entropique.

9. Procédé de codage d'une séquence de valeurs de balayage d'un signal d'informations qui comporte un signal audio, chaque valeur de balayage dans la séquence présentant une position d'origine, aux étapes suivantes consistant à:

   trier les valeurs de balayage selon leur grandeur, pour obtenir une séquence triée de valeurs de balayage, chaque valeur de balayage présentant une position de triage dans la séquence triée;
   régler les coefficients de fonction d'une règle de fonction pour adapter la règle de fonction à une zone partielle de la séquence triée; et
   coder les coefficients de fonction, les valeurs de balayage en-dehors de la zone partielle et une information sur un rapport entre les positions d'origine et de triage des valeurs de balayage.

10. Programme d'ordinateur avec un code de programme pour réaliser le procédé selon la revendication 9 lorsque le code de programme est exécuté sur un ordinateur.

11. Dispositif (250) de décodage d'une séquence de valeurs de balayage d'un signal d'informations qui comporte un signal audio, chaque valeur de balayage dans la séquence présentant une position d'origine, aux caractéristiques suivantes:

   un moyen (260) destiné à recevoir des coefficients de fonction codés, des valeurs de balayage triées et une information sur un rapport entre une position de triage et la position d'origine des valeurs de balayage;
   un moyen (270) destiné à décoder les valeurs de balayage;
   un moyen (280) destiné à approximer les valeurs de balayage sur base des coefficients de fonction dans une zone partielle de la séquence; et
   un moyen (290) destiné à retrier les valeurs de balayage et la zone partielle sur base de l'information sur le rapport entre les positions d'origine et de triage, de sorte que chaque valeur de balayage présente sa position d'origine.

12. Dispositif (250) selon la revendication 11, dans lequel le moyen (260) destiné à recevoir est réalisé pour recevoir l'information sur le rapport entre les positions d'origine et de triage comme permutation d'indice.

13. Dispositif (250) selon la revendication 11 ou 12, dans lequel le moyen (260) destiné à recevoir est réalisé pour recevoir l'information sur le rapport entre les positions d'origine et de triage comme tableau d'inversions.

**14.** Dispositif (250) selon l'une des revendications 11 à 13, dans lequel le moyen (270) est par ailleurs réalisé pour décoder les coefficients de fonction, les valeurs de balayage triées ou l'information sur le rapport entre les positions d'origine et de triage par un codage entropique et un codage de différence successif ou uniquement par un codage entropique.

**15.** Dispositif (250) selon l'une des revendications 11 à 14, dans lequel le moyen (260) destiné à recevoir est réalisé pour recevoir les coefficients codés d'un filtre de prédiction et le moyen (270) destiné à décoder est réalisé pour décoder les coefficients codés, le dispositif (250) présente par ailleurs un moyen destiné à prédire des valeurs de balayage sur base des coefficients.

**16.** Dispositif (250) selon l'une des revendications 11 à 15, dans lequel le moyen (260) destiné à recevoir est réalisé pour recevoir un signal résiduel qui correspond à une différence entre les valeurs de balayage et un signal de sortie du filtre de prédiction ou du moyen (280) destiné à approximer et le moyen (270) destiné à décoder est réalisé pour adapter les valeurs de balayage sur base du signal résiduel.

**17.** Dispositif (250) selon la revendication 16, dans lequel le moyen (270) destiné à décoder est réalisé pour décoder le signal résiduel par un décodage entropique.

**18.** Procédé de décodage d'une séquence de valeurs de balayage d'un signal d'informations qui comporte un signal audio, chaque valeur de balayage dans la séquence présentant une position d'origine, aux étapes suivantes consistant à:

recevoir des coefficients de fonction codés, des valeurs de balayage triées et une information sur un rapport entre une position de triage et la position d'origine des valeurs de balayage;
décoder les valeurs de balayage;
approximer les valeurs de balayage sur base des coefficients de fonction dans une zone partielle de la séquence; et
retrier les valeurs de balayage et la zone partielle sur base de l'information sur le rapport entre les positions d'origine et de triage, de sorte que chaque valeur de balayage présente sa position d'origine.

**19.** Programme d'ordinateur avec un code de programme pour réaliser le procédé selon la revendication 18 lorsque le code de programme est exécuté sur un ordinateur.

**20.** Dispositif (300) de codage d'une séquence de valeurs de balayage d'un signal d'informations qui comporte un signal audio, chaque valeur de balayage dans la séquence présentant une position d'origine, aux caractéristiques suivantes:

un moyen (310) destiné à trier les valeurs de balayage selon leur grandeur, pour obtenir une séquence triée de valeurs de balayage, chaque valeur de balayage présentant une position de triage dans la séquence triée;
un moyen (320) destiné à générer une succession de nombres en fonction d'un rapport entre les positions d'origine et de triage des valeurs de balayage et à déterminer les coefficients d'un filtre de prédiction sur base de la succession de nombres; et
un moyen (330) destiné à coder les valeurs de balayage triées et les coefficients.

**21.** Dispositif (300) selon la revendication 20, qui présente par ailleurs un moyen de traitement réalisé pour effectuer une filtration, une transformation temps/fréquence, une prédiction ou une réduction de redondance multicanal pour générer la séquence de valeurs de balayage.

**22.** Dispositif (300) selon la revendication 20 ou 21, dans lequel le moyen (320) destiné à générer la succession de nombres est réalisé pour générer une permutation d'indice.

**23.** Dispositif (300) selon l'une des revendications 20 à 22, dans lequel le moyen (320) destiné à générer la succession de nombres est réalisé pour générer un tableau d'inversions.

**24.** Dispositif (300) selon l'une des revendications 20 à 23, dans lequel le moyen (320) destiné à générer la succession de nombres est réalisé pour générer par ailleurs un signal résiduel qui correspond à une différence entre la succession de nombres et une succession de prédiction prédite sur base des coefficients.

**25.** Dispositif (300) selon l'une des revendications 20 à 24, dans lequel le moyen (330) destiné à coder est adapté pour coder les valeurs de balayage triées ou les coefficients selon un codage de différence ou entropique.

26. Dispositif (300) selon l'une des revendications 24 ou 25, dans lequel le moyen (330) destiné à coder est par ailleurs réalisé pour coder le signal résiduel.

27. Procédé de codage d'une séquence de valeurs de balayage d'un signal d'informations qui comporte un signal audio, chaque valeur de balayage dans la séquence présentant une position d'origine, aux étapes suivantes consistant à:

trier les valeurs de balayage selon leur grandeur, pour obtenir une séquence triée de valeurs de balayage, chaque valeur de balayage présentant une position de triage dans la séquence triée;
générer une succession de nombres en fonction d'un rapport entre les positions d'origine et de triage des valeurs de balayage et déterminer les coefficients d'un filtre de prédiction sur base de la succession de nombres; et
coder les valeurs de balayage triées et les coefficients.

28. Programme d'ordinateur avec un code de programme pour réaliser le procédé selon la revendication 27 lorsque le code de programme est exécuté sur un ordinateur.

29. Dispositif (350) de décodage d'une séquence de valeurs de balayage d'un signal d'informations qui comporte un signal audio, chaque valeur de balayage dans la séquence présentant une position d'origine, aux caractéristiques suivantes:

un moyen (360) destiné à recevoir des coefficients d'un filtre de prédiction et une séquence de valeurs de balayage, chaque valeur de balayage présentant sa position de triage;
un moyen (370) destiné à prédire une succession de nombres sur base des coefficients; et
un moyen (380) destiné à retrier la séquence de valeurs de balayage sur base de la succession de nombres, de sorte que chaque valeur de balayage présente une position d'origine.

30. Dispositif (350) selon la revendication 29, dans lequel le moyen (370) destiné à prédire la succession de nombres prédit une permutation d'indice comme succession de nombres.

31. Dispositif (350) selon la revendication 29 ou 30, dans lequel le moyen (370) destiné à prédire la succession de nombres prédit un tableau d'inversions comme succession de nombres.

32. Dispositif (350) selon l'une des revendications 29 à 31, dans lequel le moyen (360) destiné à recevoir est par ailleurs réalisé pour recevoir un signal résiduel codé et le moyen (370) destiné à prédire est réalisé pour tenir compte du signal résiduel lors de la prédiction de la succession de nombres.

33. Dispositif (350) selon l'une des revendications 29 à 32, qui présente par ailleurs un moyen destiné à décoder qui est réalisé pour décoder les valeurs de balayage, les signaux résiduels ou les coefficients après un codage de différence ou entropique.

34. Procédé de décodage d'une séquence de valeurs de balayage d'un signal d'informations qui comporte un signal audio, chaque valeur de balayage dans la séquence présentant une position d'origine, aux étapes suivante consistant à:

recevoir des coefficients d'un filtre de prédiction et une séquence de valeurs de balayage, chaque valeur de balayage présentant une position de triage;
prédire une succession de nombres sur base des coefficients; et
retrier la séquence de valeurs de balayage sur base de la succession de nombres, de sorte que chaque valeur de balayage présente sa position d'origine.

35. Programme d'ordinateur avec un code de programme pour réaliser le procédé selon la revendication 34 lorsque le code de programme est exécuté sur un ordinateur.

Einrichtung
zum Sortieren

Einrichtung
zum Kodieren

110

120

100 ↗

FIG 1A

| Einrichtung zum Empfangen | Einrichtung zum Dekodieren | Einrichtung zum Umsortieren |
|---|---|---|

160    170    180

150

# FIG 1B

| Einrichtung zum Sortieren | Einrichtung zum Einstellen | Einrichtung zum Kodieren |
|---|---|---|

210　　　　　　　220　　　　　　　230

200 ↗

# FIG 2A

| Einrichtung zum Empfangen | | Einrichtung zum Dekodieren | | Einrichtung zum Approximieren | | Einrichtung zum Umsortieren |
|---|---|---|---|---|---|---|
| 260 | | 270 | | 280 | | 290 |

250

**FIG 2B**

Einrichtung
zum Sortieren

Einrichtung
zum Erzeugen

Einrichtung
zum Kodieren

310

320

330

300

FIG 3A

Einrichtung
zum
Empfangen

360

Einrichtung
zum
Prädizieren

370

Einrichtung
zum
Umsortieren

380

350

FIG 3B

Einrichtung
zum Sortieren

Einrichtung
zum Kodieren

410

420

400 ↗

FIG 4A

| Einrichtung zum Empfangen | Einrichtung zum Dekodieren | Einrichtung zum Umsortieren |

460     470     480

450

**FIG 4B**

FIG 5A

FIG 5B

FIG 6

EP 2 054 884 B1

Btstrom → **Bitstrom-demultiplexer** → **Entropie-dekodierung** → **Dekodierung der sortierten Daten** → sortierte Daten → **Rück-sortierung** → Ausgangs-daten

705

710

715

720

**Entropie-dekodierung** → **Dekodierung der Permutation** → Permutation

725

730

700

**FIG 7**

FIG 8

EP 2 054 884 B1

BS
Eingang

Bitstromdemultiplexer
905

Anpassungskoeffizienten

Entropiedekodierer
910

Inverse
Kurvenanpassung
915

Rücksortierer
920

Permutationsdekodierer
925

Original Index

f->t
930

PCM
Audio

900

FIG 9

FIG 10

FIG 11

**FIG 12**

FIG 13

Typischer Kurvenverlauf sortierter Zweitwerte

FIG 14

FIG 15

Audio
Signal → Blockbildung → x(n) → Intrakanal Dekorrelation → e(n) → Entropie-kodierung → komprimiertes Signal

FIG 16

FIG 17

**FIG 18**

FIG 19

FIG 20

FIG 21

FIG 22

EP 2 054 884 B1

FIG 23

Kanal 1 →

Kanal 2 →

Stereoredundanzreduktion

→ Dekorrelation →

→ Dekorrelation →

FIG 24

FIG 25

**FIG 26**

FIG 27

**FIG 28**

Inversionstafel LS
Lehmer

**FIG 29D**

Inversionstafel RS
Lehmer

**FIG 29H**

Inversionstafel LB
Lehmer

**FIG 29C**

Inversionstafel RB
Lehmer

**FIG 29G**

Inversionstafel LS

**FIG 29B**

Inversionstafel RS

**FIG 29F**

Inversionstafel LB

**FIG 29A**

Inversionstafel RB

**FIG 29E**

Inversionstafel LB

FIG 30A

Inversionstafel LS

FIG 30B

Inversionstafel LB
Lehmer

FIG 30C

Inversionstafel LS
Lehmer

FIG 30D

Inversionstafel RB

FIG 30E

Inversionstafel RS

FIG 30F

Inversionstafel RB
Lehmer

FIG 30G

Inversionstafel RS
Lehmer

FIG 30H

EP 2 054 884 B1

FIG 31A

FIG 31B

FIG 32A

FIG 32B

FIG 33A

FIG 33B

FIG 34A

FIG 34B

FIG 35A

FIG 35B

FIG 36

FIG 37

Schreibindex                                    Füllstand

a) | 0 | 0 | 0 | 0 | 0 | 0 | 0 | 0 |    0

b) | 7 | 0 | 0 | 0 | 0 | 0 | 0 | 0 |    1

c) | 7 | 3 | 0 | 0 | 0 | 0 | 0 | 0 |    2

...

d) | 7 | 3 | 1 | 9 | 2 | 2 | 4 | 0 |    7

e) | 7 | 3 | 1 | 9 | 2 | 2 | 4 | 5 |    8

f) | 8 | 3 | 1 | 9 | 2 | 2 | 4 | 5 |    8

Historiepuffer

# FIG 38

FIG 39A

FIG 39B

Code und
Seiteninformation

Arithmetische
Kodierung

Datenmultiplexer

Daten

Erstelle
Histogramm

Zeichen

$\delta$

r.a. Rice
Kodierung

Wahrscheinlichkeiten

r.a. Rice
Kodierung

FIG 40

FIG 41

FIG 42

S ——————————•———————————— L-R ⊕ —————————————→ L

:2

NINT

M ——————————————⊖———————————•————————————→ R

# FIG 43

Bitstrom

wähle aus L'R', L'S', R'S' und M'S' die günstigste Variante

Entropiekodierung — L'

Entropiekodierung — S'

Entropiekodierung — M'

Entropiekodierung — R'

Dekorrelation — L

Dekorrelation — S

Dekorrelation — M

Dekorrelation — R

Stereo-redundanz-reduktion

L

R

**FIG 44**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **Tony Robinson.** SHORTEN: Simple lossless and near lossless waveform compression. *Technical report CUED/F-INFENG/TR.156,* Dezember 1994
- **Mat Hans ; Ronald W. Schafer.** Lossless Compression of Digital Audio. *IEEE Signal Processing Magazine,* Juli 2001
- **Tilman Liebchen ; Marcus Purat ; Peter Noll.** Lossless Transform Coding of Audio Signals. *102nd AES Convention,* 1997
- **Ralf Geiger et al.** ISO/IEC MPEG-4 High-Definition Scalable Advanced Audio Coding. *120th AES Convention,* Mai 2006
- **E. Zwicker.** Psychoakustik. Springer-Verlag, 1982
- **Raad M. et al.** Scalable audio coding employing sorted sinusoidal parameters. *Sixth International Symposium on Signal Processing and its Applications,* 13. August 2001, vol. 1, 174-177
- The Art of Computer Programming. **Donald E. Knuth.** Sorting and Searching. Addison-Wesley, 1998, vol. 3
- **A. A. Babaev.** Procedures of encoding and decoding of permutations. *Kibernetika,* 1984, vol. 6, 77-82
- **Tilo Wik.** *Dieter Weninger: Verlustlose Audiokodierung mit sortierten Zeitwerten und Anbindung an filterbankbasierte Kodierverfahren,* Oktober 2006
- **J. Princen ; A. Bradley.** Analysis/ Synthesis Filter Bank Design Based on Time Domain Aliasing Cancellation. *IEEE Trans. ASSP,* 1986
- **Draper, N.R ; H. Smith.** Applied Regression Analysis. John Wiley & Sons, 1998
- Teaching Combinatorial Tricks to a Computer. **D. H. Lehmer.** Proc. Of Symposium Appl. Math., Combinatorial Analysis. Amercian Mathematical Society, 1960, vol. 10, 179-193
- The Machine Tools of Combinatorics. **D. H. Lehmer.** Applied Combinatorial Mathematics. John Wiley and Sons, Inc, 1964
- **Ziya Arnavut.** Permutations Techniques in Lossless Compression. *Dissertation,* 1995
- **J. Breebaart ; J. Herre ; C. Faller et al.** MPEG Spatial Audio Coding/MPEG Surround: Overview and Current Status. *119th AES Convention,* Oktober 2005

- **C. Faller ; F. Baumgarte.** Binaural Cue Coding Applied to Stereo and Multi-Channel Audio Compression. *112th AES Convention,* Mai 2002
- **V. Vatter.** Finitely Labeled Generating Trees and Restricted Permutations. *Journal of Symbolic Computation,* 2006, vol. 41, 559-572
- **NELDER, J. A. ; MEAD, R. A.** A Simplex Method for Function Minimization. *Computer Journal,* 1965, vol. 7, 308-313
- **Ziv, Jacob ; Lempel, Abraham.** A Universal Algorithm for Sequential Data Compression. *IEEE Transactions on Information Theory,* Mai 1977, vol. IT-23 (3
- **Huffman, David A.** A Method for the Construction of Minimum-Redundancy Codes. *Proceedings of the I.R.E,* September 1952
- **Burrows, M. ; Wheeler, D.** A block sorting lossless data compression algorithm. *Technical Report 124, Digital Equipment Corporation,* 1994
- **Robinson, Tony.** SHORTEN: Simple lossless and near lossless waveform compression. *Technical report CUED/FINFENG/TR.156,* Dezember 1994
- **Hans, Mat ; Schafer, Ronald W.** Lossless Compression of Digital Audio. *IEEE Signal Processing Magazine,* Juli 2001
- **Mitra, Sanjit K.** Digital Signal Processing. Mc-Graw-Hill, 2001, 155-176
- **Craven, P. ; Law, M ; Stuart J.** Lossless Compression using IIR prediction filters. *Munich : 102nd AES Conv.,* 1997
- **Sayood, Khalid.** Introduction to Data Compression. Morgan Kaufmann, 2006, 333
- **Jayant, N. S. ; Noll, P.** Digital Coding of Waveforms - Principles and Applications to Speech and Video. Prentice Hall, 1984, 267-269
- **Sayood, Khalid.** Introduction to Data Compression. Morgan Kaufmann, 2006, 332-334
- **Rabiner, L. R. ; Schafer, R. W.** Digital Processing of Speech Signals. Prentice-Hall, 1978, 396-404
- **Yu, R. ; Lin, X. ; Ko, C.C.** A Multi-Stage Levinson-Durbin Algorithm. *IEEE Proc.,* November 2002, vol. 1, 218-221
- **Hans, Mat ; Schafer, Ronald W.** Lossless Compression of Digital Audio. *IEEE Signal Processing Magazine,* Juli 2001, 28-31

- **Robinson ; Tony.** SHORTEN: Simple lossless and nearlossless waveform compression. *Technical report CUED/FINFENG/ TR.156,* Dezember 1994, 3-4
- **Robinson ; Tony.** SHORTEN: Simple lossless and nearlossless waveform compression. *Technical report CUED/FINFENG/TR.156,* Dezember 1994
- **Coalson, Josh.** *FLAC - Free Lossless Audio Codec, http://flac.sourceforge.net*
- **Liebchen, Tilman ; Reznik, Yuriy ; Moriya, Takehiro.** Yang, Dai Tracy: MPEG-4 Audio Lossless Coding. *116th AES Convention,* Mai 2004
- **Liebchen, Tilman ; Purat, Marcus ; Noll, Peter.** Lossless Transform Coding of Audio Signals. *102nd AES Convention,* 1997
- **Geiger, Ralf ; Yu, Rongshan ; Herre, Jürgen ; Rahardja, Susanto ; Kim, Sang-Wook ; Lin, Xiao ; Schmidt, Markus.** ISO/IEC MPEG-4 High-Definition Scalable Advanced Audio Coding. *Paris : 120th AES Convention,* Mai 2006
- ISO/IEC JTC1/SC29/WG11: Coding of Audiovisual Objects, Part 3. Audio, Subpart 4 Time/Frequency Coding. *International Standard 14496-3,* 1999
- **Geiger, Ralf ; Sporer, Thomas ; Koller, Jürgen ; Brandenburg, Karlheinz.** Audio Coding Based on Integer Transforms. *111nd AES Conv.,* 2001
- **Johnston, J. D. ; Ferreira, A. J.** Sum-Difference Stereo Transform Coding. *IEEE International Conference, ICASSP,* 1992
- **Hans, Mat ; Schafer, Ronald W.** Lossless Compression of Digital Audio. *IEEE Signal Processing Magazine,* Juli 2001, 30
- **ARNAVUT, Ziya.** Permutation Techniques in Lossless Compression. *Computer Science, Dissertation,* 1995, 58-78
- **ARNAVUT, Ziya.** Permutation Techniques in Lossless Compression. *Computer Science, Dissertation,* 1995, 62-63
- **ARNAVUT, Ziya.** Permutation Techniques in Lossless Compression. *Computer Science, Dissertation,* 1995
- **KNUTH, Donald E.** The Art of Computer Programming. Addison Wesley, 1998, vol. 2, 145
- **ROBINSON, Tony.** SHORTEN: Simple lossless and nearlossless waveform compression. *Technical report CUED/FINFENG/TR.156,* Dezember 1994
- **REZNIK, Y.** Coding of Prediction Residual in MPEG-4 Standard for Lossless Audio Coding (MPEG-4 ALS). *IEEE Proc., ICASSP,* 2004
- **LIEBCHEN, Tilman ; REZNIK, Yuriy ; MORIYA, Takehiro ; YANG, Dai Tracy.** MPEG-4 Audio Lossless Coding. *116th AES Convention,* Mai 2004
- **GOLOMB, S. W.** Run-length encodings. *IEEE Transactions on Information Theory, IT,* Juli 1966, vol. 12 (3), 399-401
- **GALLAGER, Robert G. ; VAN VOORHIS, David C.** Optimal Source Codes for Geometrically Distributed Integer Alphabets. *IEEE Transactions on Information Theory,* Marz 1975
- **SALOMON, David.** Data Compression. Springer, 2007
- **SALOMON, David.** Data Compression. Springer-Verlag, 2007
- **KIELY, A.** Selecting the Golomb Parameter in Rice Coding. *IPN Progress Report,* November 2004, vol. 42-159
- **KIELY, A.** Selecting the Golomb Parameter in Rice Coding. *IPN Progress Report,* November 2004, vol. 42-159, 6
- **Reznik, Y.** Coding of Prediction Residual in MPEG-4 Standard for Lossless Audio Coding (MPEG-4 ALS). *IEEE Proc., ICASSP,* 2004